(19) Europäisches Patentamt
European Patent Office
Office européen des brevets

(11) **EP 3 871 239 B1**

(12) **EUROPEAN PATENT SPECIFICATION**

(45) Date of publication and mention of the grant of the patent:
**22.05.2024 Bulletin 2024/21**

(21) Application number: **19790233.1**

(22) Date of filing: **25.10.2019**

(51) International Patent Classification (IPC):
***H01F 10/18*** $^{(2006.01)}$ ***H01F 41/20*** $^{(2006.01)}$
***C23C 14/08*** $^{(2006.01)}$ ***C23C 14/28*** $^{(2006.01)}$

(52) Cooperative Patent Classification (CPC):
**H01F 10/18; C23C 14/08; C23C 14/28; H01F 41/205**

(86) International application number:
**PCT/EP2019/079306**

(87) International publication number:
**WO 2020/084157 (30.04.2020 Gazette 2020/18)**

# (54) ELECTRICALLY INSULATING FERROMAGNETIC MATERIAL TRANSPARENT TO VISIBLE LIGHT: SYNTHETIZATION METHOD, MATERIAL AND USE IN DEVICES

ELEKTRISCH ISOLIERENDES FERROMAGNETISCHES MATERIAL, DAS FÜR SICHTBARES LICHT TRANSPARENT IST: SYNTHETISIERUNGSVERFAHREN, MATERIAL UND VERWENDUNG IN VORRICHTUNGEN

MATÉRIAU FERROMAGNÉTIQUE ÉLECTRIQUEMENT ISOLANT ET TRANSPARENT À LA LUMIÈRE VISIBLE : PROCÉDÉ DE SYNTHÉTISATION, MATÉRIAU ET UTILISATION DANS DES DISPOSITIFS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.10.2018 EP 18202591**

(43) Date of publication of application:
**01.09.2021 Bulletin 2021/35**

(60) Divisional application:
**24170854.4**

(73) Proprietor: **Reciprocal Engineering - RE Oy
00180 Helsinki (FI)**

(72) Inventors:
- **FRANTTI, Johannes
00180 Helsinki (FI)**
- **FUJIOKA, Yukari
00180 Helsinki (FI)**

(74) Representative: **Altmann Stößel Dick Patentanwälte PartG mbB
Isartorplatz 1
80331 München (DE)**

(56) References cited:
- **FUJIOKA ET AL: "Itinerant-Electron Ferromagnetism in a Titanium-Rich Magnesium Titanate Ilmenite Solid Solution", JOURNAL OF PHYSICAL CHEMISTRY C, vol. 115, no. 5, 5 January 2011 (2011-01-05), pages 1457-1463, XP055576341, ISSN: 1932-7447, DOI: 10.1021/jp107698j**
- **FUJIOKA ET AL: "Vacancy filled nickel-cobalt-titanate thin films : Vacancy filled nickel-cobalt-titanate thin films", PHYSICA STATUS SOLIDI. B, vol. 254, no. 7, 1 July 2017 (2017-07-01), page 1600799, XP055576346, DE ISSN: 0370-1972, DOI: 10.1002/pssb.201600799**
- **FUJIOKA ET AL: "Ferromagnetism in MgTiO<sub>3</sub>-Ti<sub>2</sub>O<sub>3 </sub>Solid Solutions", MATERIALS SCIENCE FORUM , vol. 700 1 September 2011 (2011-09-01), pages 23-27, XP009512356, ISSN: 1662-9752, DOI: 10.4028/WWW.SCIENTIFIC.NET/MSF.700.23 Retrieved from the Internet: URL:https://www.scientific.net/MSF.700.23 [retrieved on 2011-09-01]**

EP 3 871 239 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

- **Yukari Fujioka ET AL: "Nickel-cobalt-titanate thin films - new sustainable magnetic oxides", , 14 June 2016 (2016-06-14), XP055656260, Retrieved from the Internet: URL:https://arxiv.org/ftp/arxiv/papers/1606/1606.04256.pdf**

## Description

### Technical Field

Semiconductor devices
RF-devices
Spintronic devices
Logical devices
Magnetic-field sensors
Magneto-optics
Memory devices

### Background Art

Significant improvements to electronic materials can be introduced by ferromagnetic materials which are electrically insulating and transparent to visible light. By ferromagnetic materials, e. g. ferromagnetic insulators, we refer to materials which exhibit net magnetization reversible by an applied field and in practical terms do not conduct electric current. Ferromagnetic materials and spin-waves are predicted to have a crucial role in future semiconductor devices in the International Technology Roadmap for Semiconductors [1]. Among emerging technologies are listed All-Spin Logic (ASL) devices, which would largely be based on ferromagnetic media. ASL is among the current interests of semiconductor manufacturers. For example, Intel Corporation has recently reported material targets for scaling ASL [2]. Characteristic feature in these devices is that they use, at least partially, spin-waves instead of charges as an information carrier. The use of spin-waves is motivated by the need to have smaller and faster devices with lower energy consumption, non-volatile memory states for computational applications [2], and higher logical efficiency (i.e., fewer devices per combinatorial computation) [2]. According to the Roadmap for Semiconductors [1], minimal power consumption of transistor operation has become the main requirement for the semiconductor industry dictated by the new ecosystem of the electronic industry. Two types of spin-transistors, the spin-field-effect-transistor (spin-FET) and the spin-metal-oxide-semiconductor-field-effect-transistor (spin-MOSFET) are listed as Beyond-CMOS devices [1]. Other critical devices include logic gates, memories, phase shifters, isolators, gyrators, circulators and sensors. Since the horizontal space is running out, "3D power scaling" was given as a new scaling method in which the vertical dimension is fully utilized [1]. Integration of devices necessitates a combination of several manufacturing technologies, such as etching technologies developed by Bosch [3] for creating Micro-ElectroMechanical-Systems (MEMS), and standard thin film deposition techniques to fabricate devices on integrated circuit (IC).

Though having apparent technological advantages, room-temperature ferromagnetic electric insulators are sparse. For emerging applications ferromagnetic insulators provide numerous technological advantages, such as lower power consumption and simpler technical solution. Search of new permanent magnetic materials is also motivated by the need to reduce the dependency on rare-earth-elements. A recent example is a computational method in which density functional theory was applied to study a variety of intermetallic phases of rare-earth and transition metal phases with and without interstitial boron, carbon and nitrogen [4].

A widely studied material groups are ferrites which possess the spinel (for instance $NiFe_2O_4$ and $MgFe_4O_4$; an often quoted structural prototype example, the inverse spinel $Fe_3O_4$ is a conductor), YIG garnet ($Y_3Fe_5O_{12}$) or hexaferrite (examples are $BaM_2Fe_{16}O_{27}$, $Ba_2M_2Fe_{12}O_{22}$ and $Ba_3M_2Fe_{24}O_{41}$ hexagonal ferrites, where M represents Mn, Fe, Co, Ni, Cu, Zn, Mg and so on) structure. Ferrites are discussed in refs. 5 and 6. Another example is EuS, which is an insulating ferromagnet below 16 K. A more practical, room-temperature solution used in tunneling junctions is based on a CoFeB/MgO/CoFeB structure in which CoFeB form electrically conducting ferromagnetic layers and MgO is an insulating layer. In the devices based on the utilization of spin-waves, YIG single-crystal thin film is the most commonly encountered material. When electrical insulation is not a requirement a common choice is a metallic polycrystalline Py ($Ni_{81}Fe_{19}$) thin film.

Magnetism in the bulk $Mg_{0.88}Ti_{1.12}O_3$ and $Mg_{0.88}Ti_{1.12}O_3$ ilmenite was studied in refs. 7 and 8. Ref.ef 8 addresses also $Mg_{0.68}Ti_{1.32}O_3$ ilmenite. All samples reported in refs. 7 and 8 are thus summarized as $Mg_{1-x}Ti_{1+x}O_3$. Ti-rich compounds which were found to exhibit ferromagnetic behavior at 290 K and below. In all three cases, the structure is obtained from the ideal ilmenite structure by substituting Ti for Mg and still keeping the ideally vacant octahedra sites vacant, as is seen from Table 1 of ref. 7. This is one of the differences between the present thin film invention and the bulk material reported in refs. 7 and 8. In thin films, a significantly larger magnetization which is stable at higher temperatures is achieved. Mg and Ti had valence values 2+ and 4+, respectively and the magnetism was due to the itinerant electron magnetism. Both structure and valence features are distinct from the present invention, in which controlled cation arrangement, including the filling of the octahedra vacant in the ideal structure and the cation valence variation are preferred. In contrast thereto, bulk materials of ref. 7 and 8 do not show such a significantly larger magnetization since said materials are in particular not present as thin films. The present invention also deals with combining electric insulation and ferromagnetism. In the present invention, cation valence can vary as a function of average composition, and may vary spatially in the case of fixed average composition. This is illustrated in Fig. 23 and was confirmed by XPS measurements. Further comprised in the present invention are thin film materials having the generic formula $Mg_{1+nx}Ti_{1-x}O_3$.

Octahedra filling in Ni-Co-Ti-O thin films was considered in ref. 9 from structural but not from the magnetic or electric viewpoint. The effect of different substrate materials was not considered, which can be crucial for tunable devices and also for compatibility with semiconductor industry standards. Notably the thinnest films can exhibit large magnetization values, Fig. 13, not found from thicker samples reported in ref. 9. Another distinct aspect that is inter alia considered in the present invention but not in the prior art is the impact of cation arrangement on magnetic properties. The spatial distribution is a technical route to alter the magnetism - for instance, segregating (Ni,Co)-cations by $Ti^{4+}$-cations may weaken the magnetic coupling between magnetically ordered (Ni,Co)-layers. In contrast, mixing the cations may result in magnetically ordered films.

Thin film deposition of e.g. magnetic oxides includes standard physical vapor deposition (PVD) techniques: molecular beam epitaxy (MBE), chemical vapor deposition (CVD), electron beam physical vapor deposition (EBPVD), sputtering deposition, and pulsed laser deposition (PLD). Thin film microelectronic devices are typically grown by depositing structurally and chemically different layers (e.g. ferroelectrics with the perovskite structure and ferromagnetic with the spinel structure) in sequence.

**Technical Problem**

Electrical conductivity usually results in power lossess and limits the operation frequency of devices to GHz range. In microelectronics power consumption and large device size may be problems. To fullfil the criteria lead, mercury, and rare-earth-elements are commonly used. Iron is a major metallic impurity in semiconductor industry. Growth of multilayer structures can create interfaces which possess defects disrupting the functionality. Fabrication of multilayers may lead to structurally and chemically different types of layers, requiring different deposition techniques. Each deposition technique increases the number of processing steps required in device manufacturing. Attempts to develop new materials are often hampered by the easy formation of undesired structures with undesired properties. Large scale manufacturing requires that the devices can be grown on silicon, which restricts the list of usable materials. Integrated circuits are running out of vertical space.

The materials known in the art and discussed above do not fulfill all the requirements set to contemporary manufacturing technologies. E.g., the platform the film is to be part of, such as a monolithic device or an IC (integrated circuit), sets boundary conditions for the chosen manufacturing technique. For instance, IC chips usually tolerate only rather modest temperatures and oxygen pressure. In particular, the following technical problems usually may be observed:

**A. Eddy currents, Joule heating and no transparency to visible light result in considerable heating, power losses and limited operation frequencies in electronic devices.** Power consumption on ICs is identified as one of the major problems as it is challenging to dissipate the generated power. This in turn has resulted in the compromise in the operation frequency which has stayed in a few GHz range during the last decade [1]. Insulation is typically achieved in large band gap materials possessing no defects, which ideally make the material transparent to visible light. Achieving such a material usually requires that it corresponds to a large band gap insulator and that it can be deposited as defect free layers. Switchable net magnetization is widely applied in contemporary electronics. Requirement to make faster, smaller and less energy consuming materials may necessitate a combination of several physical properties, such as electrical insulation and ferromagnetism. Electrical insulation is generally advantageous for energy saving components and for devices based on tunneling phenomenon. Examples are spintronic devices, such as spin filters, tunable radio-frequency components, including frequency tuned bandpass filters and phase shifters, and magnetic sensors. Materials which are ferromagnetic, electrically insulating and transparent to visible light are rare yet technologically important for microelectronics.

**B. Signal conversion.** One of the technological challenges is that the signal propagating in the air must be converted into a much shorter wavelength excitation propagating in the functional part of the device. An example is the conversion of the incoming long wavelength (few centimeter when the frequency is in the GHz range) electromagnetic radiation to a shorter wavelength spin wave propagating in the ferromagnetic crystal. The spin-wave wavelength can be several orders of magnitude smaller than the wavelength of the electromagnetic radiation in air. However, conduction limits the operation frequency, as discussed in paragraph A. Another technical problem is that metallic ferromagnets have large damping factors for spin waves.

**C. Defects in devices.** Devices are typically comprised from several layers, such as electrode, dielectric paramagnetic spacer, ferromagnetic and ferroelectric layers. Layers typically have different atomic scale structure, which may result in defected interfaces hampering or even preventing the proper device function. Fig. 3 schematically illustrates two common cases when the atomic scale structure of the adjacent layers differs significantly. Shown examples are a misfit strain and dislocations formed at the interfaces [10].

Though many prototype devices are horizontal for practical reasons there is a demand to construct vertical devices in ICs. Many devices require a combination of compositionally different type of layers, such as ferroelectric layers applied for the voltage control of the magnetic properties (e.g., ferromagnetic resonance frequency or magnetization) of the adjacent ferromagnetic layer via magnetostriction. As another example of a stack-type structure, magnetic tunnel junctions (MTJ) utilize CoFeB/MgO/CoFeB as a central part in the devices in which the magnetization direction of one CoFeB layer is freely adjustable and of the second layer is pinned. Pinning is typically achieved via exchange bias field generated at the interface of an antiferromagnetic layer. The antiferromagnetic layer can either be an antiferromagnetic crystal layer, or an artificial antiferromagnetic formed from two ferromagnetic layers separated by a ruthenium (Ru) layer. Ru layer couples the ferromagnetic layers antiferromagnetically. MTJ can be used in a spin-transfer-torque magnetoresistive random access memory (STT-MRAM), an example study is given by the Qualcomm Incorporated researchers [11]. STT-MRAM is a non-volatile memory. The pinned layer functions as a reference layer. The tunneling current is small when the magnetization vectors are antiparallel and large when the magnetization vectors are parallel. For pinning rather complex layer structures are utilized and it is not easy to have high-quality interfaces due to the very different atomic scale structures of the layers.

**D. Only limited elements can be used.** Electronic devices must be constructed from semiconductor compliant elements, which should also be environmentally and economically sustainable in European Union as dictated by RoHS directive. This sets restrictions to the use of heavy metals, such as lead and mercury, and rare-earth elements. Also, iron which is commonly used in ferromagnetic materials is preferably avoided as it represents a major metallic impurity in semiconductor industry. Commonly studied iron-based half-metallic compounds are the Heusler compounds, such as $Fe_2XY$, where X = Ti, V, Cr, Mn, Fe, Co, Ni and Y = Al, Si [12] and $Co_2MnZ$, Z = Al, Ge, Si, Ga [13], YIG garnet and CoFeB.

**E. Need of diffusion barriers.** Barriers are usually required for instance, in CoFeB based materials to prevent boron diffusion, making the whole structure rather complex. For example, ref. 14 reports the structure constructed on silicon substrate by Fujitsu Laboratories: Lower electrode / Ta(3) / Ru(2) / IrMn(7) / CoFe(2) / Ru(0.7) / $Co_{60}Fe_{20}B_{20}$(2) / MgO(1) / $Co_{60}Fe_{20}B_{20}$(3) / capping layer(3) / Ta(5) / upper electrode where the numbers in parentheses give the layer thickness in nm and the capping layers were either Ta, $Ni_{80}Fe_{20}$ (permalloy) or Ti.

**F. Formation of undesired crystal phases via oxidation.** The choice of capping material can not only affect the B diffusion but also the atomic scale structure of CoFeB: with $Ni_{80}Fe_{20}$ the structure is face centered cubic and with Ti and Ta the structure is body centered cubic [14]. The structure can influence the tunneling current between ferromagnetic $Co_{60}Fe_{20}B_{20}$ electrodes. The crucial role of interfaces in CoFeB based devices is addressed in ref. 15: in CoFeB/MgO-type heterostructures the quality of the metal-oxide interface controls the performance of the device, as oxidation of the ferromagnetic electrode leads to impurity phases that can cause spin decoherence [16].

**G. Need of spacer layers.** Electrically insulating, nonmagnetic spacer layers are usually required to decouple conducting magnetic layers: spacer layers are needed as the conducting electrons intermediate exchange coupling. Often studied cases include various multilayer structures, an example is Fe-MgO-Fe multilayer in which MgO serves as a nonmagnetic spacer decoupling the magnetic ordering of Fe-layers so that the magnetization directions of the iron layers can be adjusted to be parallel or antiparallel.

**H. Tunable devices are large and complex.** Miniaturization requirements can partly be satisfied by decreasing the number of devices. As an example, contemporary mobile phones can have ten radio-frequency range filters. Ability to tune operating frequency can be a route to decrease the number of components and to reduce production costs. Commonly used magnetic tuning requires large units.

**I. Manufacturing of artificial magnetic crystals is costly.** In artificial magnetic crystals a structural element, characteristically from few nanometers to few hundred nanometers, is periodically repeated at least in one spatial direction, which requires complex etching and patterning thus increasing the manufacturing costs. Other issues are related to the complex physics following the complex size and shape of the magnetic materials. Examples are demagnetizing fields and nonuniform internal magnetic fields in the structures.

**J. Limited control of functional properties by composition adjustment.** A common route to adjust materials functional properties, such as magnetization, is to control composition. This is rather limited approach since structures often have a narrow variable space, for instance as a function of temperature and composition, where they are stable. Frequently straightforward mixing of the raw materials does not give the correct structure, or the desired functional properties. For instance, the ilmenite and corundum structured 3*d*-transition metal compounds have gained considerable attention over the past 60 years due to the interests towards magnetic and multiferroic materials. As an example, we specifically discuss the case of the ilmenite FeTiOs and the corundum $\alpha$-$Fe_2O_3$ (hematite), which order antiferromag-

netically at and below 55 K and the Morin point 250 K, respectively. Above 55 K FeTiOs is paramagnetic, and $\alpha$-$Fe_2O_3$ is a canted antiferromagnet (often called a weak ferromagnet) above the Morin point up to its Néel temperature at 950 K, and is paramagnetic above the Néel temperature [17]. In the canted antiferromagnetic phase the spin axis is on the c-plane, whereas below the Morin point $\alpha$-$Fe_2O_3$ has an antiferromagnetic ordering with the spin axis parallel to the hexagonal c-axis. By mixing FeTiOs and $\alpha$-$Fe_2O_3$ and applying the solid-solution method, or other bulk sample synthesis method, $(FeTiO_3)_{1-x}(Fe_2O_3)_x$ solid-solution is formed. The amount (in at.%) of (Fe+Ti) equals to 2/3 of the amount of O, and correspondingly only 2/3 of the octahedra are filled. Attempts to change this ratio by contemporary synthesis techniques result in the formation of undesired phases, such as oxides of iron and/or titanium with different structures, such as the spinel or rocksalt structures, as indicated by the ternary diagram given in ref. 18. The possibility to adjust the materials properties by composition adjustment is thus restricted: $(FeTiO_3)_{1-x}(Fe_2O_3)_x$ solid-solution possesses the ilmenite/corundum structure in which Ni/Co and Ti cations alternate in the layers perpendicular to the hexagonal c-axis and the fraction of vacant octahedra in the ilmenite structure is fixed to 1/3. The FeTiOs ilmenite and $\alpha$-$Fe_2O_3$ corundum structures have limited magnetic applications in electronics since they are paramagnetic or antiferromagnetic or only weakly ferromagnetic, i.e., canted antiferromagnets, and thus are not ferromagnetic insulators.

**K. Semiconductor industry incompatible processing conditions.** Ferrite manufacturing requires high-processing temperatures, frequently above 1173 K, under oxygen-rich environment [19].

L. **Slow thin film growth rate.** Thin films characteristically grow slowly, with decreasing crystalline quality and orientation after a limit thickness is exceeded. The limit thickness is often between 100 and 1000 nm.

Therefore, it is an object of the present invention to provide an improved thin film material, in particular as regards its physical properties, e. g. its magnetization, electrical conductivity and resistivity. Further, it is an object of the present invention to provide a thin film comprising a substrate and a thin film material and a method for preparation thereof. Further, it is an object of the present invention to provide a thin film material that shows improved physical properties when applied in electrical devices and which is applicable in contemporary manufacturing technologies.

## Solution to Problem

According to the present invention, multilayer thin film structures can be provided which allow manufacturing smaller, faster, more reliable and less energy consuming devices. In particular, a $A^{2+}{}_{1+nx}Ti^{z}{}_{1-x}O_3$ (ATO) thin film material and a method of making ATO materials and multilayer structures is provided according to claims 1-3 and claims 8-10, respectively, wherein *z* is the average T-cation oxidation state and *n* is *z*- and x- dependent parameter. With respect to the values for 1+nx and 1-x, it is preferred that said values fulfill specific conditions. Therefore, a specific ATO thin film material can be defined by a specific pair of a value 1+nx and a value 1-x, wherein x is preferably not 0. In particular, it is preferred that for a specific ATO thin film material a pair of values 1+nx and 1-x defines a point ((1+nx);(1-x)) on a specific area in a Cartesian coordinate system defined by an abscissa (1+nx) and an ordinate (1-x). For example, 1+nx may represent the abscissa and 1-x may represent the ordinate to determine such an area. As an example, reference is made in this regard to figure 24. In figure 24, such a specific area can be defined by the lines G1, G2, and L1. Thus, a specific area can be defined by three or more lines in such a diagram and its intersections, in particular defined by respective 1+nx and 1-x values. In this regard, it is preferred that a pair of the values for 1+nx and 1-x define a point ((1+nx);(1-x)) within an area defined by the lines 1-x = -(1+nx)+3, 1-x = -0.500(1+nx)+1.500, and 1-x = 1.561(1+nx)+0.44, and the intersections of said lines. Preferably, a pair of the values for 1 +nx and 1-x define a point ((1+nx);(1-x)) within an area defined by the lines 1-x = -(1+nx)+2.9, 1-x = -0.500(1+nx)+1.550, and 1-x = 1.451(1+nx)+0.70, and the intersections of said lines, wherein more preferably a pair of the values for 1 +nx and 1-x define a point ((1+nx);(1-x)) within an area defined by the lines 1-x = -0.500(1+nx)+1.9, 1-x = -0.500(1+nx)+1.550, 1-x = 1.451(1+nx)+0.70, and 1+nx=3, and the intersections of said lines. The structure can be stabilized in thin film form for several cation combinations, typically with, but not limited to, thickness of from 4 to 100 nm, when carefully chosen deposition parameters are applied. The present invention allows manufacturing electrically insulating ferromagnetic materials whose values can be adjusted. Metrically very similar yet chemically and functionally different layers can be continuously formed by changing the cation concentration during growth. This allows the fabrication of multilayer structures with diminished dislocation density and stress. Among the choice of cations the ATO structure can host, functional layers, e.g., ferromagnetic insulators transparent to visible light can be manufactured. By varying the composition during the deposition functionally different layers, such as ferroelectric or paramagnetic, can be deposited in a single growth cycle. Three dimensional semiconductor industry compliant devices are doable. Therefore, the present invention relates to a $A^{2+}{}_{1+nx}T^{z}{}_{1-x}O_3$ thin film material, termed here as the ATO structure, as claimed in claim 1, and having in particular the structure as depicted in Fig. 1, the thin film being preferably applicable in multilayer devices. Further, the present invention relates to a method to synthesize a thin film comprising a substrate and the thin film material, the thin film being preferably applicable in multilayer devices.

In particular, the present invention relates to the material compositions as specified in claims 1-3 and claims 8-10. In the following, the principles are described in general. This and some of the embodiments include material compositions not covered by the above claims; they are not part of the invention.

- A thin film material having the empirical formula $A_{1+nx} T^z{}_{1-x}O_3$,

  wherein A is at least one element selected from the group consisting of 3d transition metal elements, Mg and Zn,
  wherein $T$= Cr, Ti, V, Mn, Si or Ge,
  wherein $-1 < x < 1$, and wherein preferably x * 0,
  wherein $z$ is the average oxidation state of $T$, calculated as the weighted average of the $T$ cation oxidation states based on the total amount of $T$ in the composition in atomic percentage, and
  wherein $n =(4 - z + zx)/(2x)$,
  characterized in that the structure is described in terms of three axes, $a$, $b$ and $c$ and three angles, $\alpha$ between $b$ and $c$ axes, $\beta$ between $a$ and $c$ axes, and $\gamma$ between a and $b$ axes,
  wherein 0.475 nm (4.75 Å) < $a$ < 0.55 nm (5.5 Å), 0.475 nm (4.75 Å) < $b$< 0.55 nm (5.5 Å), and 1.25 nm (12.5 Å) < $c$ <1.55 nm (15.5 Å), and wherein 85° < $\alpha$ < 95°, 85° < $\beta$ < 95°, and 115° < $\gamma$ < 125°.

- In this regard, the structure is preferably defined in terms of a simplest repeating unit in a crystal which is called a unit cell. Each unit cell is defined in terms of lattice points. Each unit cell has three unit cell edge lengths a, b and c and three internal angles $\alpha$, $\beta$ and $\gamma$, whereby $\alpha$ is between the b and c axis, $\beta$ between the a and c axis, and $\gamma$ between the a and b axis. The three unit cell lengths are part of respective axes a, b, and c. The intersection of the three axes a, b, and c is usually defined as the origin having the coordinates (0;0;0). Thus, a position of an atom or ion can be defined by three coordinates.
- In particular, a thin film material with structural characteristics given in Fig. 1 and which is preferably at room-temperature electrically insulating and ferromagnetic or ferrimagnetic, transparent to visible light and possesses a generic formula $A_{1+nx}T^z{}_{1-x}O_3$ (abbreviated as ATO), where $A$ is at least one element selected from the group consisting of 3d transition metal elements, Mg and Zn or other cation in oxidation state 2+ and $T$ is Ti, Mn, Cr, Si, V or Ge;
- A method of manufacturing a thin film comprising a substrate and a thin film material having the empirical formula $A_{1+nx} T^z{}_{1-x}O_3$ wherein A is at least one element selected from the group consisting of 3dtransition metal elements, Mg and Zn, T = Ti, V, Cr, Mn, Si or Ge, wherein $-1< x< 1$, wherein $z$ is the average oxidation state of $T$, calculated as the weighted average of the $T$ cation oxidation states based on the total amount of $T$ in the composition in atomic percentage, and wherein $n = (4- z + zx)/(2x)$, the method comprising the steps:

  (a) Providing a substrate, wherein the substrate preferably has a surface structure possessing similar periodicity as the desired $A_{1+nx}T^z{}_{1-x}O_3$ crystal plane structure, wherein the difference between the periodicities is preferably below 3 %;
  (b) Providing a target comprising $A$ and a target comprising $T$;
  (c) Deposition of $A$ and $T$ on the substrate, wherein the deposition parameters are adjusted so that $-1 < x< 1$ and $-16 < n < 32$ on the substrate, wherein the in-situ temperature of the substrate is kept in the range of from 673 to 933 K, and wherein the oxygen pressure is kept in the range of from greater than 0 to 2.7 Pa, preferably the oxygen pressure is kept at 1.3 Pa or lower,
  for obtaining a layer of the thin film material;
  (d) Cooling of the substrate obtained from c, wherein the oxygen pressure is kept in the range of from greater than 0 to 2.7 Pa, preferably the oxygen pressure is kept at 1.3 Pa or lower,
  for obtaining a thin film.

- A method for making single phase thin film material and devices from ATO layers in a single growth deposition cycle without detrimental interfaces, illustrated in Fig. 2;
- A method of manufacturing a thin film comprising a substrate and a thin film material as disclosed herein, wherein the growth of the ATO is accelerated.

It has surprisingly been found that the inventive thin film material displays improved properties allowing a wide use in electrical devices also considering its surroundings.

Functional properties, such as magnetization and electrical conductivity, of each layer of the thin film material of the invention can be adjusted by controlling the cation type, their relative concentration and spatial distribution during deposition. In particular, different layers share a continuous oxygen octahedra network and the cation content within the network varies in one, two or three dimensions. Continuous octahedra network can be the key to avoid detrimental interfaces between layers. The average $T$-cation oxidation state is labelled as $z$, $1-x$ gives the $T$-cation content and $n$ is a parameter which can be determined from the charge neutrality condition when $z$ and $x$ are known. This is exemplified by the following preferred, but non limiting, embodiments A, B, and C:

A) If $A$ = $Ni^{2+}$, $Co^{2+}$ and $T$ is $Ti^{4+}$, then $-0.25 < x < 1$, $z = 4$ and $n = 1$ and the generic formula $A_{1+nx}T^{z}_{1-x}O_3$ simplifies to the preferred embodiment $A_{1+2x}Ti_{1-x}O_3$.

B) If $A$ = $Mg^{2+}$ and $T = Ti^{z}$, the $n$, $x$, $z$ parameter space is more complex, typical values in the generic formula being: $2.5 \lesssim z \lesssim 4$, $-1 < x < 0.50$ and $-16 < n < 32$.

C) If $A$ = $Mn^{2+}$ and $T = Ti^{z}$, $z \approx 4+$, $-0.5 < x < 0.5$ and the structure can be summarized as $Mn_{1+2x}Ti_{1-x}O_3$.

It is to be understood that the same element, such as Mn, can be A-cation when its oxidation state is 2+, and T-cation, when it has oxidation state 3+ or 4+.

The inventive ATO films can be grown by different techniques, non limiting but preferred examples being physical deposition techniques such as sputtering or PLD, or chemical deposition techniques involving either gas phase (CVD) or liquid phase growth techniques. A choice of the technique is determined by the boundary conditions, such as the film homogeneity, thickness, epitaxy and the requirements set by the platform on which the films are grown. Low-temperature and small oxygen pressure deposition techniques are preferred in IC manufacturing. The preferred physical deposition techniques according to the invention are pulsed laser deposition and sputtering techniques.

The ATO material typically exhibits a dependence between composition and octahedra filling, which can be one of the structural characteristics which may be controlled by the deposition parameters. The examples of the deposition parameters usually are the substrate heating rate and the substrate temperature during deposition, the oxygen gas pressure, the laser beam fluence, the pulse repetition rate, the number of pulses shot on each target in each cycle, the total number of cycles and the cooling rate, and wherein the substrate heating rate is preferably of from 5 to 30 K/min, substrate temperature is kept in the range of from 500 to 1000 K, preferably of from 673 to 933 K, more preferably of from 673 to 873 K, oxygen gas pressure is preferably of from 0 to 5 Pa, more preferably of from 0.5 to 2 Pa, more preferably of from 1 to 1.5 Pa, laser beam fluence is preferably of from 2 to 4 $Jcm^{-2}$, more preferably of from 2.5 to 3.6 $Jcm^{-2}$, more preferably of from 2.9 to 3.5 $Jcm^{-2}$, pulse repetition rate is of from 1 to 20 Hz, preferably of from 1 to 10 Hz, the number of pulses shot on each target in each cycle is preferably of from 1 to 10, the total number of cycles is preferably of from 100 to 10000 and the cooling rate is preferably of from 5 to 20 K/min. Pressure can be measured using the commonly available pressure measurement systems, such as capacitance manometer, temperature can be measured by a thermocouple and/or pyrometer and the laser beam fluence by measuring the pulse energy, for instance by pyroelectric sensor and determining the spot size on a target by an optical microscope.

The structural characteristics determine the functional properties, such as electrical resistivity and magnetization. The resistivity is preferably in the range of from 1 MS2cm to 400 MS2cm, more preferably in the range of from 50 MS2cm to 300 MS2cm. The magnetization is preferably in the range of from 0 to 2000 $emucm^{-3}$, more preferably in the range of from 0 to 1300 $emucm^{-3}$ and can preferably be adjusted by the choice of cations and their concentration. According to the invention, numerous compounds, which cannot be stabilized in this structure in bulk form, can be deposited in the novel structure. This is preferably achieved by choosing the deposition parameters carefully. In one embodiment the $A$-cations are preferably Ni, Co in $A_{1+2x}Ti_{1-x}O_3$, wherein $-0.25 < x < 1$, and the Ni/Co ratio is preferably of from 0.28 to 2.5. This is achieved by choosing a temperature range preferably of from 723 K to 873 K, an oxygen gas pressure preferably of from 0 to 1.3 Pa, a laser beam fluence preferably of from 3 $Jcm^{-2}$ to 3.4 $Jcm^{-2}$ and an atomic scale mixing by preferably shooting shots of from 1 to 10 on each target at a time after which a switch to next target is carried out.

In a second embodiment the A-cation is Mg and T-cation is Ti in $A_{1+nx}T^{z}_{1-x}O_3$, wherein $2.5 \lesssim z \lesssim 4$, $-1 < x < 0.50$ and $-16 < n < 32$. This is achieved by choosing a temperature range preferably of from 850 to 900 K, an oxygen gas pressure preferably of from 0.5 to 2 Pa and a laser beam fluence preferably of from 2.7 to 3.4 $Jcm^{-2}$. Atomic scale mixing is achieved by preferably shooting shots of from 1 to 10 on each target at a time after which a switch to next target is carried out.

In a third embodiment the A-cation is Mn and $T = Ti^{z}$, wherein $z \approx 4+$ and $-0.5 < x < 0.5$. This is achieved by choosing a temperature range of from 800 K to 850 K, an oxygen gas pressure preferably of from 0.5 to 2 Pa and a laser beam fluence preferably of from 2.9 to 3.5 $Jcm^{-2}$. Atomic scale mixing is preferably achieved by shooting of from 1 to 10 shots on MnO and $Ti_2O_3$ targets at a time after which a switch to next target was carried out.

A further surprising functional property of the inventive ATO films is that a strong ferromagnetism is stable up to a measurement temperature 350 K in the novel structure. The magnetization at 350 K was approximately 90 % of the value measured at 5 K.

As shown in Fig. 1, the ATO structure is particularly characterized by a specific dense octahedra packing in three spatial directions and filling of octahedra. Each octahedron preferably shares a face with octahedron above and below along the vertical axis direction, see left-hand panel in Fig. 1. In the basal plane, shown in Fig. 1 in the center panel, each octahedron shares an edge with each of the six neighboring octahedron of the same basal plane. Above (similarly below) it has six corner sharing octahedra, shown in Fig. 1, right-hand panel. Each octahedron is either vacant or possess A= V, Ni, Co, Mn, Cr or other 3d transition metal cation at oxidation state close to 2+, or Zn or Mg cation in oxidation state close to 2+, or T-cation (T = Ti, V, Mn, Si or Ge) in an average oxidation state $z$. It is referred herein to the average oxidation state since, due to the slightly different environment there is a spatial variation of oxidation state. For instance, transition metal cation on the surface often has a higher oxidation state than in the film. The average oxidation state refers to a composition weighted average value.

The fraction of the filled octahedra is $z_v$ and can be controlled by adjusting the deposition parameters. The fraction refers to an average occupancy and is in the range of from 0.5 to 1.

In preferred embodiments, the ATO structure is characterized by exceptional features. In particular, the structure is characterized by short distances between the nearest neighbor cations, specifically A-A, A-T, and T-T pairs. The shortest cation-cation distances are in particular through the common octahedra face, and are in the range of from 0.22 to 0.25 nm (2.2 to 2.5 Å), the second shortest cation-cation distances through common octahedra edge are in particular in the range of from 0.27 to 0.30 nm (2.7 to 3.0 Å) and the third shortest cation-cation distances are in particularin the range of from 0.36 to 0.40 nm (3.6 to 4.0 Å). The length ranges preferably relate to the aforementioned cations. This can be a very unique feature as it allows a direct 3*d*-orbital overlap and partially covalent bonding between the nearest neighbor cations connected through the octahedra face or edge. In contrast, the dominating interactions in common metal oxides, including magnetic and covalent bonding, involve oxygen. This often favors antiferromagnetic ordering.

Fig. 4 summarizes a route to grow films by PLD. Also the spatial distribution of cations can be controlled by adjusting the deposition parameters. Examples include desired composition and thickness of specific cation filled octahedra layers, homogeneous distribution of cations and vacancies, and desired composition gradients. Thin films possessing this structure can be grown with a minimum thickness of 0.5 nm. The compound has the empirical formula

$$A^{2+}{}_{1+nx}T^{z}{}_{1-x}O_3 \qquad (1)$$

which is based on the following experimentally verified characteristics and the charge neutrality condition:

- Oxygen octahedra network is well preserved as a function of x as confirmed by XRD measurements;
- A-cation has to an excellent accuracy an oxidation state 2+. This, however, is not a stringent condition for the ATO structure;
- The average T-cation oxidation state z can vary as a function of *x*: $z = z(x)$.

A value for *n* for a given *x* is obtained from the charge neutrality condition: $n = (4\text{-}z+zx)/(2x)$. In the special case $x = 0$ charge neutrality condition is applied directly to the formula $A^{2+}T^{z}O_3$ so that $z = 4+$. The present invention focuses on the cases where x differs from zero.

A technologically important figure characterizing the compound is the average of the fraction of octahedra filled by a cation, $z_v = [2 + (n-1)x]/3$. $z_v$ can be adjusted during deposition by adjusting *x* by controlling deposition parameters. A practical way is to change x, which changes electrical, magnetic and structural properties, as demonstrated below.

As an example of a special case, if $z = 4+$ and A-cation oxidation state is 2+, then $n = 1$. Then formula (1) reduces to $A^{2+}{}_{1+2x}T_{1-x}O_3$. This is preferably the case when A is Ni and Co and T is Ti. The interpretation of $n = 1$ value is that each $T^{4+}$ replaced by $A^{2+}$ is accompanied by one more $A^{2+}$ cation placed at the vacant octahedron to preserve the charge neutrality. The compounds are electrically insulating and ferromagnetic.

Another example is a case when T has an average oxidation state differing from 4+. An example of such a case is the substitution of two $T^{3+}$-cations for two $A^{2+}$-cations, which, to preserve charge neutrality, requires an insertion of one more $A^{2+}$-cation into a vacant octahedron.

An example where T oxidation state z deviates from 4+ (unless *x* is close to 0) is the case A = $Mg^{2+}$ and T = Ti in which case the average Ti oxidation state is around 3+. In terms of the formula $A^{2+}{}_{1+nx}T^{z}{}_{1-x}O_3$, compound $Ti_2O_3$ corresponds to the case $x = -1$ and $z = 3+$ and correspondingly $n = 1$. Charge neutrality would also be preserved if all octahedra would be filled by $Mg^{2+}$, which would correspond to the case $x = 1$ and $n = 2$, i.e., formula is reduced to $A^{2+}{}_3O_3$. This limit may not necessarily be achievable: films with Mg/Ti at.% ratio 2.1 possessed the brookite phase as a secondary phase. However, the structure can adopt large amounts of Mg, as demonstrated by a single phase thin film possessing the $A^{2+}{}_{1+nx}Ti^{z}{}_{1-x}O_3$ structure having Mg/Ti at.% ratio 1.7. The compounds are electrically insulating and ferromagnetic.

Furthermore, the octahedra can be filled with desired element ratio and distribution, or left vacant, as summarized by the octahedral filling ratio $z_v$, during the film deposition process. This allows to make a structure consisted of oxygen octahedra network in which the octahedra are, for example filled with Ti, V, Co, Ni, Mn or Mg, or left vacant as desired. Examples are given in Figs. 5-15, 17-19 and Tables 1 and 2. This can only be done if the deposition parameters are correctly chosen. For example, when x= 1 all octahedra are filled by cations, there are no T-cations and the cation density of the ATO structure is 50% higher than in the ilmenite or corundum structures. An example is $(Ni,Co)_3O_3$ in which every octahedron is filled either by $Ni^{2+}$ or $Co^{2+}$. Despite the chemical similarity of $Ni^{2+}$ and $Co^{2+}$ cations, the new structure cannot be formed from cobalt and oxygen alone, since cobalt and oxygen rather form the spinel structure. The cation arrangement and the element type can be crucial for the formation and adjustment of ferromagnetic ordering and electrical resistivity. There is a large octahedral filling fraction range for several 3*d*-transition metal cations in which the octahedra network remains essentially intact. This allows depositing compositionally different layers in which the octahedra network metrics is nearly intact even though the cation distribution, elements and $z_v$, and correspondingly functional properties are significantly different, illustrated in Figs. 2 and 16. Similar metrics can eliminate problematic interfaces, specifically strain and dislocations characteristic to the interfaces joining metrically different layers.

The possibility to combine layers possessing the ATO structure with the lithium niobate, ilmenite and corundum structured compounds provides further technological applications, such as the control of magnetization of the ATO layer via piezoelectric layer possessing the lithium niobate structure. The oxygen octahedra network of the lithium niobate, ilmenite and corundum structures are compatible with the ATO structure. Due to the similar octahedra arrangement, defect-free multilayer structures consisted of ferroelectrics (such as the lithium niobate LiNbOs or lithium tantalite LiTaOs), conducting corundum layers (such as the corundum $V_2O_3$ or 3*d*-element doped corundum $Ti_2O_3$), paramagnetic $Mg_{1.45}Ti_{1.00}O_3$ and the insulating ferromagnetic ATO structure can be fabricated.

**Advantageous effect of invention**

Below reference is made to the paragraph labelling given in section Technical Problem.

**A.** The inventive ATO thin film material can be used in applications requiring

electrically insulating ferromagnets transparent to visible light at least up to 350 K. Thin films comprising the thin film material in which the cations were Ni, Co and Ti had a minimum specific resistance of the order of 1 MS2cm up to several tens of M Ωcm, examples are given in Table 1. Overall Ti-containing samples had an order of magnitude larger specific resistance when compared to samples with no Ti. Measurements conducted on several samples indicate that rather small Ti-concentrations significantly increase specific resistance. Thin films, in which the cations were Mg and Ti, exhibit similar dependency on Mg/Ti content, examples are shown in Table 1.

Table 1. Specific resistance $\rho$, in MS2cm, measured at 1 Hz frequency.

| Sample | $\rho$ |
|---|---|
| $(Ni_{0.42}CO_{0.58})_{2.22}Ti_{0.39}O_3$ | 135 |
| $(Ni_{0.39}CO_{0.61})_3O_3$ | 2.2 |
| $(Ni_{0.46}Co_{0.54})_{1.05}Ti_{0.97}O_3$ | 170 |
| $Mg_{1.64}Ti_{0.98}O_3$ | 0.08 |
| $Mg_{0.73}Ti_{1.38}O_3$ | 252 |

ATO material can, e.g., be deposited as a vertical stack or multilayer structure. Electrical insulation is an advantage allowing the fabrication of energy saving devices as the power loss due to the Eddy currents is inversely proportional to the resistivity. Decrease in Eddy currents implies a decrease in Joule heating. Eddy current loss is also proportional to the square of the rate of the magnetization change, which makes insulating ferromagnetic materials practical for highfrequency applications. In ferromagnetic crystals a further decrease in Joule heating can be achieved by utilizing spin waves, since the signal is conveyed by time dependent changes in the spin phase, which does not involve a charge motion.

The transparency to visible light opens up applications in magneto-optic devices utilizing, for example, Faraday Effect. The Faraday Effect is also used in the processing of electromagnetic waves in microwave region between 1 and 100 GHz [20]. The effect is present in paramagnetic materials, but is typically several orders stronger in ferromagnetic substances, being proportional to the magnetization, and is a sum of the electric and magnetic susceptibility contributions [21]. In the case of a ferromagnetic material the rotation angle per unit path length due to the electric and magnetic contributions are, respectively, $\theta_E = \omega G\langle M^z\rangle/(2c\eta)$ and $\theta_M = \eta\gamma\mu_0\langle M^z\rangle/(2c)$, where $\omega$ is the angular frequency of the light, *G* is the electric susceptibility derivative with respect to magnetization, c is the speed of light in vacuum, $\eta$ is the materials refractive index, $\gamma$ is the gyromagnetic ratio and $\mu_0$ is the permeability of free space. The average magnetization $\langle M^z\rangle$ is assigned to be parallel to the *z*-axis. The term $\theta_E$ is responsible of the frequency dependent Faraday rotation, whereas term $\theta_M$ is frequency independent. Term $\theta_E$ dominates at high frequencies (approximately $10^{14}$ Hz [21]). The Faraday rotation differs from ordinary optical rotation since on reflecting the light beam back through the material the plane of polarization is further rotated, i.e., the material treats the signal in a non-reciprocal manner. Device examples based on Faraday Effect in ferrites include magneto-optic memories, optical isolators, circulators and phase shifters [20].

Another magneto-optic phenomenon suitable for processing optical signal is the Kerr Effect, application examples being magneto-optic memories [20]. Kerr Effect is utilized in applications based on reflection and thus can be applied in non-transparent media.

**B.** In ferromagnetic media the wave-vector-frequency curve of the spin waves shows that also short wavelength range is covered. This allows an efficient miniaturization of the devices. Insulating ferromagnetic materials have lower damping factors of spin waves making them suitable material for spin wave devices. An advantage is found, for example in the devices operating in the microwave range. A layered structure consisting ferromagnetic layers is a route to convert GHz or even THz frequency range electromagnetic radiation into a short wavelength signal. It allows devices operating at shorter wavelengths than the commonly used piezoelectric Surface Acoustic Wave (SAW) filters at the same frequency [22] thus allowing a manufacturing of smaller devices. SAW filters are limited to frequencies below 5 GHz. An application example is a microwave band-stop filter in which layers *A* and *B* form a multilayer structure *ABABAB...* The layers are ferromagnetic with different magnetization values and have an equal thickness $a/2$ so that the period along the packing direction is $a$. Difference in magnetization can be adjusted by adjusting cation concentration. Along the packing direction, band gaps or frequency values which spin waves cannot possess are formed at wavevector $k$ values $k = m\,\pi/a$, where $m$ is a positive integer. Since the present problem was reduced to a one-dimensional case it is sufficient to consider the absolute value of the wavevector. The band-stop filter is characterized by the layer thickness, the number of layers and the material parameters, such as magnetization. If the Bragg condition $m\lambda = 2a \sin\theta$ is satisfied, the spin waves are reflected, otherwise they propagate with small losses. $\lambda$ is the wavelength of the spin wave and $\theta$ is the angle between the propagation direction and the ferromagnetic plane. Dispersion curves, which give the spin-wave frequency as a function of wavelength in the given media, give the frequency ranges. By choosing the layer thicknesses correctly, gaps can be introduced in a desired portion of the dispersion curve frequency range.

Besides stack structures the invention may have advantageous effects on commonly used planar strip antenna (often Cu) deposited on top of a ferromagnetic layer. The electromagnetic signal entering the metal layer is converted to a spin wave propagating in the ferromagnetic layer. To construct a band-stop filter in the planar geometry a periodical modulation in a ferromagnetic layer beneath the metal strip is typically required. Experimentally tested methods to achieve this are ion implantation [23], etching of grooves [24], etching of holes [25] and width modulation of the strip [26]. Tunable devices have been achieved by an external magnetic field [27]. Other techniques, including thermally induced modulations of saturation magnetization by laser, to achieve reconfigurable modulations have been investigated [28]. The ferromagnetic layer in these examples was either YIG or a metallic layer and can be replaced by the ATO material. For a very precise and straightforward filter fabrication a stack structure is a good alternative. In addition to high quality interfaces required for good reflectivity a stable and precise modulation of saturation magnetization is doable by the ATO material through straightforward growth process. Other examples benefiting from precisely controlled compositions and high quality interfaces are phase shifters and spin wave logic gates, which can be constructed using either the planar waveguides or stacks as building blocks. Examples are exclusive-not-OR (XNOR) and not-AND (NAND) gates constructed using two planar spin-wave waveguides [29] based on YIG single crystal layer. In the XNOR device the incoming microwave signal generates a spin-wave which is split to two waveguides so that initially the signals have the same phase. The logical inputs are currents $I_1$ and $I_2$ which generate a magnetic field causing a 180° phase shift or no phase shift. The logical zero is represented by $I$ = 0A and logical one by the current which is necessary to create a 180° phase shift. The output is the amplitude of the microwave interference pattern at the interferometer output terminal.

Spin-wave based computing has been proposed [30] as a way to fulfill the goal to go beyond Complementary-Metal-Oxide-Semiconductor (CMOS) technology, outlined in the Roadmap for Semiconductors [1]. Numerical modeling suggests that significant enhancement over the CMOS technology can be achieved by the multifrequency magnonic circuits [30].

**C.** A further advantageous effect is the possibility to spatially vary a composition without abrupt interfaces opening a way to fabricate layered structures in which layers possessing different magnetization values alternate. Table 2 gives examples of characteristic magnetic properties of $(Ni,Co)_{1-2x}Ti_{1-x}O_3$ thin films.

Table 2. Magnetic properties as a function of composition and temperature extracted from in-plane and out-of-plane measurements.

| Sample and substrate | In-plane, 300 K, $H_c$, $M_r$, $M_s$ | In-plane, 5 K, $H_c$, $M_r$, $M_s$ | Out-of-plane, 5K, $H_c$, $M_r$, $M_s$ | *n* |
|---|---|---|---|---|
| $(Ni_{0.57}Co_{0.43})_{0.51}Ti_{1.24}O_3$ $Al_2O_3$ R-plane | PM | PM | FM,170,2,6 | ∥ |
| $(Ni_{0.39}Co_{0.61})_{1.49}Ti_{0.76}O_3$ $Al_2O_3$ C-plane | PM+FM,131,2,19 | PM+FM,250,5 ,23 | PM+FM,175,5, 25 | ∥ |
| $(Ni_{0.35}Co_{0.65})_{1.75}Ti_{0.63}O_3$ | FM, 153, 1,5 | FM,210,1,14 | FM,490,2,8 | ⊥ |

(continued)

| Sample and substrate | In-plane, 300 K, ***H**$_c$*, ***M**$_r$*, ***M**$_s$* | In-plane, 5 K, ***H**$_c$*, ***M**$_r$*, ***M**$_s$* | Out-of-plane, 5K, ***H**$_c$*, ***M**$_r$*, ***M**$_s$* | *n* |
|---|---|---|---|---|
| $Al_2O_3$ C-plane | | | | |
| $(Ni_{0.39}Co_{0.61})_3O_3$ $Al_2O_3$ C-plane | FM,99,4,28 | FM,230,8,33 | FM,291 ,5,32 | ⊥ |
| $(Ni_{0.42}CO_{0.58})_{2.22}Ti_{0.39}O_3$ $Al_2O_3$ C-plane | FM,93,5,43 | FiM,262,12,50 | FiM,386,12,56 | ⊥ |
| $(Ni_{0.46}Co_{0.54})_{1.05}Ti_{0.97}O_3$ $Al_2O_3$ C-plane | FiM,66,5,47 | FiM,667,25,64 | FiM,1867,38,72 | ⊥ |

Abbreviations are: AFM - Antiferromagnetic, FM - Ferromagnetic, FiM - Ferrimagnetic, PM - Paramagnetic, ***H**$_c$*- coercive field (in units of $1000/(4\pi)Am^{-1}$), ***M**$_r$*- remanence magnetization (in units of 1000 $Am^{-1}$), ***M**$_s$*- saturation magnetization (in units of 1000 $Am^{-1}$). Labeling || and ⊥ indicates easy axis *n* direction parallel and perpendicular to the hexagonal c-axis direction, respectively.

Multilayer structures without detrimental interfaces can be deposited in a single growth cycle. The magnetization, conductivity and the magnetization direction (parallel or perpendicular to the film plane) can be adjusted by adjusting the composition during the growth and choosing the substrates accordingly. The number of unpaired electrons can likewise be controlled by controlling the number of cations possessing the unpaired electrons. A good lattice matching allows matching electronic energy bands in one, two or three dimensions, which is a prerequisite for many applications, such as magnetic tunneling junctions.

D. The inventive ATO thin films can be deposited from semiconductor industry and RoHS directive compliant elements, the use of iron can be avoided, no rare-earth elements are used and the origin of the elements is traceable. Environmental, safety and health requirements are listed in the International Technology Roadmap for Semiconductors [1].

As a 3d-element, Fe can be embedded into the ATO structure, if desired for technological or other reasons. By varying the element ratio different functional layers can be produced yet the structure remains the same even when the elemental ratios are significantly changed. Electric conductivity and magnetism can also be adjusted by doping. When Co and Ni cations are introduced as A-cations and $x \geq 0$, ATO is a ferromagnetic insulator. By introducing a controlled doping by using different oxidation state cations, such as $Cr^{3+}$, physical properties, such as coercive field, can be adjusted while preserving the structure and metrics the same. When A is Mg, both ferromagnetic and paramagnetic films are readily doable.

**E.** Diffusion can be limited by using low processing temperatures and using a minimal set of elements. ATO compounds do not contain highly diffusive elements, such as B, and the impact of diffusion can further be limited by system device specific choice of elements. Diffusion can also be limited by filling all octahedra sites in a layer, which significantly decreases diffusion probability. The layer serves as a capping layer.

**F.** As an oxide the ATO material does not degrade due to the surface oxidation and thus better keeps its performance.

**G.** For magnetic tunneling junctions the advantage is that there are no conducting electrons intermediating exchange coupling and thus undesired coupling between layers are avoided. ATO materials have the desired properties up to and above room-temperature.

**H.** The spin-wave dispersion curve is strongly altered by an external magnetic field, which can be applied as a tuning element. A practical electric field tuning of magnetic properties is achievable through magnetostriction by straining the ATO material. Strain can be controlled by voltage via the converse piezoelectric effect of piezoelectric films.

**I.** Artificial crystals in which structural element, with dimensions characteristically from few nanometers to several hundred nanometers, is periodically repeated at least in one spatial direction can be done by adjusting the ATO layer composition during the deposition. Manufacturing is straightforward and allows making modulated structures with well-characterized internal magnetic fields.

**J.** There is a large variable window in which the single phase insulating ferromagnetic ATO structure exists, and the variable, such as the choice of cations, their mutual concentrations along the three spatial directions, and the fraction of filled octahedra can be controlled. Ability to control structural properties gives a large window to vary functional properties. By adjusting the deposition parameters correctly ferromagnetism is preserved in the ATO structure up to 350 K. Further, antiferromagnetic ordering can also be eliminated if desired.

**K.** ATO materials are grown typically under oxygen pressure of from 0.7 to 1.3 Pa, which is few percent from the pressure values applied in the growth of ferrites. Samples possessing the ATO structure grow already at 773 K.

**L.** Initial growth of $(Ni,Co)_3O_3$ and Cr-doped $(Ni,Co)_3O_3$ can be more than ten times faster on C-plane oriented LiNbOs than on C-plane oriented $Al_2O_3$ substrate. The use of LiNbOs seed layer is a route to accelerate high-quality crystal growth. To introduce even thicker structures, stack structures, such as $LiNbO_3/(Ni,Co)_3O_3/$ $LiNbO_3/(Ni,Co)_3O_3/$ $LiNbO_3/(Ni,Co)_3O_3/$... with or without electrode layers surrounding the LiNbOs layers, can be grown. For example, electrode layers can be thin $V_2O_3$ layers, which can be used to introduce voltage controlled strain. Therefore, the present invention particularly relates to a thin film material having

the empirical formula $A_{1+nx}\,T^{z}_{1-x}O_3$, with compositions according to claims 1-3 and claims 8-10,

wherein $-1 < x < 1$,
wherein $z$ is the average oxidation state of $T$, calculated as the weighted average of the $T$ cation oxidation states based on the total amount of $T$ in the composition in atomic percentage, and
wherein $n = (4 - z + zx)/(2x)$,
characterized in that the structure is described in terms of three axes, *a, b* and *c* and three angles, $\alpha$ between *b* and *c* axes, $\beta$ between *a* and *c* axes, and $\gamma$ between *a* and *b* axes,
wherein 0.475 nm (4.75 Å) < *a* < 0.55 nm (5.5 Å), 0.475 nm (4.75 Å) < *b* < 0.55 nm (5.5 Å), and 1.25 nm (12.5 Å) < *c*<1.55 nm (15.5 Å), and
wherein 85° < $\alpha$ < 95°, 85° < $\beta$ < 95°, and 115° < $\gamma$ < 125°.

It is preferred that x * 0.

According to a first alternative, it is preferred that in a Cartesian coordinate system defined by an abscissa (1+nx) and an ordinate (1-x) a pair of the values 1 +nx and 1-x define a point ((1+nx);(1-x)) within an area defined by the lines 1-x = -(1+nx)+3, 1-x = -0.500(1+nx)+1.500, and 1-x = 1.561(1+nx)+0.44, and the intersections of said lines, wherein preferably a pair of the values 1 +nx and 1-x define a point ((1+nx);(1-x)) within an area defined by the lines 1-x = -(1+nx)+2.9, 1-x = - 0.500(1+nx)+1.550, and 1-x = 1.451(1+nx)+0.70, and the intersections of said lines, wherein more preferably a pair of the values 1+nx and 1-x define a point ((1+nx);(1-x)) within an area defined by the lines 1-x = -0.500(1+nx)+1.9, 1-x = - 0.500(1+nx)+1.550, 1-x = 1.451(1+nx)+0.70, and 1+nx=3, and the intersections of said lines.

According to a second alternative, it is preferred that in a Cartesian coordinate system defined by an abscissa (1+nx) and an ordinate (1-x) a pair of the values 1+nx and 1-x define a point ((1+nx);(1-x)) within an area defined by the lines 1-x = -(1+nx)+3, 1-x = -0.500(1+nx)+1.500, 1-x = 1.561(1+nx)+0.44, and 1-x = 1, and the intersections of said lines, wherein preferably a pair of the values 1 +nx and 1-x define a point ((1+nx);(1-x)) within an area defined by the lines 1-x = -(1+nx)+2.9, 1-x = -0.500(1+nx)+1.550, 1-x = 1.451(1+nx)+0.70, and 1-x = 1, and the intersections of said lines, wherein more preferably a pair of the values 1+nx and 1-x define a point ((1+nx);(1-x)) within an area defined by the lines 1-x = -0.500(1+nx)+1.9, 1-x = -0.500(1+nx)+1.550, 1-x = 1.451(1+nx)+0.70, and 1-x = 1, and the intersections of said lines.

According to a third alternative, it is preferred that in a Cartesian coordinate system defined by an abscissa (1+nx) and an ordinate (1-x) a pair of the values 1+nx and 1-x define a point ((1+nx);(1-x)) within an area defined by the lines 1-x = -0.7206(1+nx)+2.1618, 1-x = -0.500(1+nx)+1.500, and 1-x = 0.6364(1+nx)+0.9155, and the intersections of said lines, wherein preferably a pair of the values 1+nx and 1-x define a point ((1+nx);(1-x)) within an area defined by the lines 1-x = -0.7206(1+nx)+2.1618, 1-x = -0.500(1+nx)+1.500, 1-x = 0.6364(1+nx)+0.9155, 1-x = -0.460(1+nx)+1.735, and 1-x = -0.393(1+nx)+1.667, and the intersections of said lines.

It is preferred that A is selected from the group consisting of Ni, Co, Mg, Mn, V, Cr and mixtures of two or more thereof, wherein A is more preferably Ni and Co.

It is preferred that T is selected from the group consisting of Ti, Mn, V and Cr, wherein T is more preferably Ti.

Regarding the oxidation state, it is preferred that 3+ < z < 4+.

It is preferred that 0.475 nm (4.75 Å) < *a* < 0.55 nm (5.5 Å), 0.475 nm (4.75 Å) < *b* < 0.55 nm (5.5 Å), and 1.25 nm (12.5 Å) < *c* <1.55 nm (15.5 Å), and wherein 85° < $\alpha$ < 95°, 85° < $\beta$ < 95°, and 115° < $\gamma$ < 125°, preferably 0.485 nm (4.85 Å) < *a* < 0.545 nm (5.45 Å), 0.485 nm (4.85 Å) < *b* < 0.545 nm (5.45 Å), and 1.35 nm (13.5 Å) < *c* <1.5 nm (15 Å), and wherein 89° < $\alpha$ < 91°, 89° < $\beta$ < 91°, and 89° < $\gamma$ < 91°.

It is preferred that the atomic sites within the unit cell are described in terms of the following fractional coordinates:

| Site i | Atom | Fractional coordinates | | |
|---|---|---|---|---|
| 1 | A,T | $-0.05<x_1<0.05$ | $-0.05<y_1<0.05$ | $0.3<z_1<0.4$ |
| 2 | A,T | $-0.05<x_2<0.05$ | $-0.05<y_2<0.05$ | $-0.4<z_2<-0.3$ |

(continued)

| Site i | Atom | Fractional coordinates | | |
|---|---|---|---|---|
| 3 | A,T | $-0.05<x_3<0.05$ | $-0.05<y_3<0.05$ | $0.1<z_3<0.2$ |
| 4 | A,T | $-0.05<x_4<0.05$ | $-0.05<y_4<0.05$ | $-0.2<z_4<-0.1$ |
| 5 | A,T | $-0.05<x_5<0.05$ | $-0.05<y_5<0.05$ | $-0.05<z_5<0.05$ |
| 6 | A,T | $-0.05<x_6<0.05$ | $-0.05<y_6<0.05$ | $0.45<z_6<0.55$ |
| 7 | O | $0.25<x_7<0.35$ | $-0.05<y_7<0.05$ | $0.24<z_7<0.35$ |
| 8 | O | $-0.05<x_8<0.05$ | $0.25<y_8<0.35$ | $0.24<z_8<0.35$ |
| 9 | O | $-0.35<x_9<-0.25$ | $-0.35<y_9<-0.25$ | $0.24<z_9<0.35$ |
| 10 | O | $-0.35<x_{10}<-0.25$ | $-0.05<y_{10}<0.05$ | $-0.35<z_{10}<-0.24$ |
| 11 | O | $-0.05<x_{11}<0.05$ | $-0.35<y_{11}<-0.25$ | $-0.35<z_{11}<-0.24$ |
| 12 | O | $0.25<x_{12}<0.35$ | $0.25<y_{12}<0.35$ | $-0.35<z_{12}<-0.24$ |

vectors $v_1 = (\frac{1}{3}, \frac{2}{3}, \frac{2}{3})$ and $v_2 = (\frac{2}{3}, \frac{1}{3}, \frac{1}{3})$, and the lattice parameters,

wherein each position $r_i$ of a site i, wherein i = 1, 2, 3, 4, 5, 6, 7, 8, 9, 10, 11 or 12, is given by the formula $r_i = x_i a + y_i b + z_i c$ ,

wherein each position $r_i$ of a site i, wherein i = 13, 14, 15, 16, 17, 18, 19, 20, 21, 22, 23 or 24, is given by the formula $r_i + v_1$,

wherein each position $r_i$ of a site i, wherein i = 25, 26, 27, 28, 29, 30, 31, 32, 33, 34, 35 or 36, is given by the formula $r_i + v_2$, and

wherein the average occupancy of the A, T atom sites is of from 0.50 to 1.

In the case where the atomic sites within the unit cell are described in terms of the following fractional coordinates as disclosed above, it is preferred that the simulated x-ray diffraction intensities corresponding to the ideal ilmenite and corundum structures possessing the equivalent cation concentrations deviate from the experimental intensities at least by 1%.

It is preferred that 95 to 100 weight-%, preferably 96 to 100 weight-%, more preferably 98 to 100 weight-%, more preferably 99 to 100 weight-%, of the material consists of A, T, and O, wherein the thin film material comprises at least three stacked layers, wherein each of the three layers comprises a hexagonally arranged oxygen octahedra layer, preferably a continuous hexagonally arranged oxygen octahedra layer; wherein each octahedron preferably shares a face with the octahedron above and/or below along the stacking direction, wherein in the basal plane each oxygen octahedron preferably shares an edge with each of the six neighboring octahedron of the same basal plane, and wherein each oxygen octahedron preferably has six corner sharing octahedra above and/or six corner sharing octahedra below.

Alternatively, it is preferred that 75 to 100 weight-%, preferably 80 to 100 weight-%, more preferably 90 to 100 weight-%, more preferably 95 to 100 weight-%, more preferably 99 to 100 weight-%, of the thin film material consists of stacked layers, wherein each layer comprises a continuous hexagonally arranged oxygen octahedra layer; with each octahedron sharing a face with the octahedron above and/or below along the stacking direction, wherein in the basal plane each oxygen octahedron shares an edge with each of the six neighboring octahedron of the same basal plane, and wherein each oxygen octahedron has six corner sharing octahedra above and/or six corner sharing octahedra below.

It is preferred that the thin film material comprises at least two stacked layers, preferably at least three layers, wherein each layer comprises a continuous hexagonally arranged oxygen octahedra layer; with each octahedron sharing a face with the octahedron above and/or below along the stacking direction, wherein in the basal plane each oxygen octahedron shares an edge with each of the six neighboring octahedron of the same basal plane, and wherein each oxygen octahedron has six corner sharing octahedra above and/or six corner sharing octahedra below.

In the case where the thin film material comprises at least one oxygen octahedra layer, it is preferred that the octahedra are vacant or contain an A-cation or a T-cation, wherein the A-cation is more preferably in an average oxidation state 2+ and the T-cation is preferably in an average oxidation state 3+ < z < 4+.

Further in the case where the thin film material comprises at least one oxygen octahedra layer, it is preferred that the shortest cation-cation distances are through the common octahedra face, and wherein the shortest cation-cation distances are preferably in the range of from 0.21 to 0.26 nm (2.1 to 2.6 Å), wherein the second shortest cation-cation distances are preferably through the common octahedra edge, wherein the second shortest cation-cation distances are more preferably in the range of from 0.27 to 0.30 nm (2.7 to 3.0 Å), and wherein the third shortest cation-cation distances are more preferably in the range of from 0.36 to 0.40 nm (3.6 to 4.0 Å).

In the case where the shortest cation-cation distances are as disclosed above, it is preferred that the abundancy of the shortest distances is larger than in the corundum and ilmenite structures when x>0, and smaller than in the corundum and ilmenite structures when x<0.

Further in the case where the thin film material comprises at least one oxygen octahedra layer, it is preferred that at least a fraction of the octahedra are filled by a cation, the octahedra filling fraction is $z_v = [2 + (n-1)x]/3$.

In the case where at least a fraction of the octahedra are filled by a cation, wherein the octahedra filling fraction is $z_v = [2 + (n-1)x]/3$, it is preferred that the atomic sites within the unit cell are described in terms of the fractional coordinates as defined in embodiment 9, wherein the atomic sites 5 and/or 6 are occupied by an A or a T cation, or wherein the atomic sites 5 and/or 6 are empty when $z_v<2/3$.

According to a first alternative, it is preferred that A is at least one element selected from the group consisting of Ni, Co and Cr, wherein T is Ti, and wherein $- 0.25 < x< 1$.

According to a second alternative, it is preferred that A is Mg, wherein T is Ti, and wherein $-1 < x< 0.1$.

According to a third alternative, it is preferred that A is Ni and Co, wherein T is $Ti^z$, wherein $3.6 < z< 4$, and wherein $-0.25 < x< 1$.

According to a fourth alternative, it is preferred that A is Ni and Co, wherein T is $V^z$, wherein $2.5 < z< 4$, and wherein $-1 < x< 1$.

According to a fifth alternative, it is preferred that A is Ni and Co, wherein T is $Cr^z$, wherein $2.5 < z < 4$, and wherein $-1 < x < 1$.

According to a sixth alternative, it is preferred that A is Mg, wherein T is $Ti^z$, wherein $2.5 < z < 4$, and wherein preferably $-0.5 < x < 0.25$.

According to a seventh alternative, it is preferred that A is Mn, wherein T is $Ti^z$, wherein $3 < z < 4$, and wherein $-0.5 < x < 0.5$.

It is preferred that the thin film has a thickness in the range of from 4 to 100 nm, more preferably in the range of from 40 to 80 nm.

It is preferred that the thin film is located on a substrate, wherein the substrate preferably comprises a surface structure possessing similar periodicity as the desired $A_{1+nx}T^z{}_{1-x}O_3$ crystal plane structure, wherein the difference between the periodicities is preferably below 3 %, wherein the substrate more preferably comprises, more preferably consists of, one or more of Si, $Al_2O_3$, LiNbOs, LiTaOs, SiC, and mixtures of two or more thereof, preferably one or more of 100-plane Si, 110-plane Si, 111-plane Si, R-plane $Al_2O_3$, M-plane $Al_2O_3$, C-plane $Al_2O_3$, R-plane LiNbOs, M-plane LiNbOs, C-plane LiNbOs, R-plane LiTaOs, M-plane LiTaOs, C-plane LiNbOs, GaN, SiC, and mixtures of two or more thereof.

Further, the present invention relates to a method of manufacturing a thin film comprising a substrate and a thin film material having the empirical formula $A_{1+nx}\,T^z{}_{1-x}O_3$, with compositions according to claims 1-3 and claims 8-10, wherein $-1 < x < 1$, wherein $z$ is the average oxidation state of *T,* calculated as the weighted average of the *T* cation oxidation states based on the total amount of *T* in the composition in atomic percentage, and wherein $n = (4- z+ zx)/(2x)$, the method comprising the steps:

(a) Providing a substrate, wherein the substrate preferably has a surface structure possessing similar periodicity as the desired $A_{1+nx}T^z{}_{1-x}O_3$ crystal plane structure, wherein the difference between the periodicities is preferably below 3 %;

(b) Providing at least one target comprising *A* and/or *T,* preferably as an oxide, more preferably a target for *A* and a target for *T*;

(c) Deposition of *A* and *T,* or atom clusters containing at least one of the atoms from the group consisting of *A, T* and *O*, on the substrate,

wherein the in-situ temperature of the substrate is kept in the range of from 673 to 933 K, and wherein the oxygen pressure is kept in the range of from greater than 0 to 2.7 Pa, preferably the oxygen pressure is kept at 1.3 Pa or lower,
for obtaining a layer of the thin film material;

(d) Cooling of the substrate obtained from c, wherein the oxygen pressure is kept in the range of from greater than 0 to 2.7 Pa, preferably the oxygen pressure is kept at 1.3 Pa or lower,
for obtaining a thin film.

It is preferred that in (c) the deposition parameters are adjusted so that $2.5 < z < 4$, and that in a Cartesian coordinate system defined by an abscissa (1+nx) and an ordinate (1-x) a pair of the values 1+nx and 1-x define a point ((1+nx);(1-x)) within an area defined by the lines 1-x = -(1+nx)+3, 1-x = -0.500(1+nx)+1.500, and 1-x = 1.561(1+nx)+0.44, and the intersections of said lines, wherein preferably the deposition parameters are adjusted so that $2.5 < z < 4$, and that in a Cartesian coordinate system defined by an abscissa (1+nx) and an ordinate (1-x) a pair of the values 1+nx and 1-x define a point ((1+nx);(1-x)) within an area defined by the lines 1-x = -(1+nx)+2.9, 1-x = -0.500(1+nx)+1.550, and 1-x = 1.451(1+nx)+0.70, and the intersections of said lines, wherein more preferably the deposition parameters are adjusted so that $2.5 < z < 4$, and that in a Cartesian coordinate system defined by an abscissa (1+nx) and an ordinate (1-x) a pair of the values 1+nx and 1-x define a point ((1+nx);(1-x)) within an area defined by the lines 1-x = -0.500(1+nx)+1.9, 1-x = -0.500(1+nx)+1.550, 1-x = 1.451(1+nx)+0.70, and 1+nx=3, and the intersections of said lines.

It is preferred that A is Mg, wherein T is $Ti^z$, wherein in (c) the deposition parameters are adjusted so that $2.5 < z < 4$, and that in a Cartesian coordinate system defined by an abscissa (1+nx) and an ordinate (1-x) a pair of the values 1+nx and 1-x define a point ((1+nx);(1-x)) within an area defined by the lines 1-x = -(1+nx)+3, 1-x = 2.296(1+nx)-0.296, 1-x = -1.407(1+nx)+2.407, 1-x = 1, and the intersections of said lines.

It is preferred that $1.4 \leq (1+nx) \leq 1.6$, $(1+nx) \neq 1.5$, and $|(1-x)-1| > 0.01$.Alternatively, it is preferred that (1+nx) = 1 and 1-x = 1.

It is preferred that the method further comprises after (c) and prior to (d)

(c') in-situ monitoring, preferably via x-ray photoelectron spectroscopy, of the composition of the deposited layer to ensure desired A and T cation concentration,

and/or

(c") adjusting and re-measuring of the cation flux on the substrate to achieve desired A and T cation concentrations.

It is preferred that the target for *A* and/or the target for *T* is selected from the group consisting of Ni, Co, Ti and alloys of two or more thereof, NiTiOs, CoTiOs, $NiCoO_4$, NiO, TiO, CoO, $Ti_2O_3$, $Ni_2O_3$, $Co_3O_4$, $NiCo_2O_4$, $Co_xNi_{1-x}O_3$ where $0<x<1$ and mixtures of two or more thereof, wherein the target for *A* is more preferably selected from the group consisting of NiTiOs, CoTiOs, $NiCoO_4$, and mixtures of two or more thereof, wherein the target for *T* is preferably selected from the group consisting of NiTiOs, CoTiOs, and mixtures of two or more thereof.

It is preferred that the oxygen pressure in (c) is kept in the range of from 0 to 5 Pa, more preferably in the range of from 0 to 2 Pa.

It is preferred that the oxygen pressure in (c) is kept in the range of from 0.5 to 5 Pa, preferably in the range of from 0.5 to 1.5 Pa.

It is preferred that the in-situ temperature of the substrate in (c) is kept in the range of from 650 to 1100 K, more preferably in the range of from 773 to 933 K.

It is preferred that (c) is carried out by sputtering, EBPVD, PLD, CVD, or liquid phase epitaxial technique.

It is preferred that the substrate is selected from the group consisting of Si, $Al_2O_3$, LiNbOs, LiTaOs, SiC, and mixtures of two or more thereof, more preferably from the group consisting of 100-plane Si, 110-plane Si, 111-plane Si, R-plane $Al_2O_3$, M-plane $Al_2O_3$, C-plane $Al_2O_3$, R-plane LiNbOs, M-plane LiNbOs, C-plane LiNbOs, R-plane LiTaOs, M-plane LiTaOs, C-plane LiNbOs, GaN, SiC, and mixtures of two or more thereof.

It is preferred that in (a) LiNbOs or LiTaOs is provided as substrate, or that in (a) a substrate is provided carrying LiNbOs or LiTaOs as a seed layer, wherein (b) further comprises providing a target for LiNbOs or LiTaOs, and wherein (c) comprises

(c.1) Deposition of A and T , or atom clusters containing at least one of the atoms from the group consisting of A, T and O, on the substrate, wherein the deposition parameters are adjusted so that $-1 < x < 1$ and $-16 < n < 32$ on the substrate and wherein the in-situ temperature of the substrate is kept in the range of from 673 to 933 K, and wherein the oxygen pressure is kept in the range of from greater than 0 to 2.7 Pa, preferably the oxygen pressure is kept at 1.3 Pa or lower, for obtaining a layer of the thin film material; and

(c.2) Deposition of LiNbOs or LiTaOs, for obtaining a layer of LiNbOs or LiTaOs.

In the case where the process further comprises (c.1) and (c.2), it is preferred that the layer of LiNbOs or LiTaOs and the layer of the thin film material are repeatedly grown to form a stack structure, wherein the total thickness of the layer of $LiNbO_3$ or $LiTaO_3$ and of the layer of the thin film material obtained from the process is preferably in the range of from 0.5 nanometers to 10 micrometers.

According to a first alternative, it is preferred that A is Ni and Co, T is $Ti^z$, $3.6 < z < 4$, and $-0.25 < x < 1$.

According to a second alternative, it is preferred that A is Ni and Co, T is $V^z$, $2.5 < z < 4$, and $-1 < x < 1$.

According to a third alternative, it is preferred that A is Ni and Co, T is $Cr^z$, $2.5 < z < 4$, and $-1 < x < 1$.

According to a fourth alternative, it is preferred that A is Mg, T is $Ti^z$, $2.5 < z < 4$, and preferably $-0.5 < x < 0.25$.

According to a sixth alternative, it is preferred that A is Mn, T is $Ti^z$, $3 < z < 4$, and $- 0.5 < x < 0.5$.

It is preferred that T = Ti, wherein (c) further comprises adjusting the deposition parameters to vary the Ti-cation concentration, wherein $-1 < x < 1$, preferably $-0.8 < x < 1$, more preferably $-0.5 < x < 1$, more preferably $-0.25 < x < 1$; and wherein (c) is preferably carried out until a film thickness in the range of from 0.5 nanometers to 10 micrometers is achieved.

It is preferred that (c) comprises varying the A and/or T cation content in at least one spatial direction during deposition, wherein the ratio of the concentration of A and the concentration of T concentrations is preferably adjusted as a function of time.

Yet further, the present invention relates to a thin film comprising a substrate and a thin film material according to claims 1-7.

It is preferred that the thin film has a thickness in the range of from 4 to 100 nm, more preferably in the range of from 40 to 80 nm.

It is preferred that the substrate is selected from the group consisting of Si, $Al_2O_3$, LiNbOs, LiTaOs, SiC, and mixtures of two or more thereof, more preferably from the group consisting of 100-plane Si, 110-plane Si, 111-plane Si, R-plane $Al_2O_3$, M-plane $Al_2O_3$, C-plane $Al_2O_3$, R-plane LiNbOs, M-plane LiNbOs, C-plane LiNbOs, R-plane LiTaOs, M-plane LiTaOs, C-plane LiNbOs, GaN, SiC, and mixtures of two or more thereof.

It is preferred that the thin film comprises a thin film material according to any one of the embodiments disclosed herein, wherein the A and/or T cation content is varied in at least one spatial direction during film growth characterized in that the ratio between cation concentrations is adjusted as a function of time so that desired spatial distribution is achieved, preferably a homogeneous mixing of cations in the atomic scale.

Yet further, the present invention relates to a use of a thin film material according to claims 1-7 in an electrical device, preferably in an electrical device comprising an electrically insulating thin film material, wherein the thickness of the thin film material is preferably in the range of from 0.5 nanometers to 10 micrometers.

Yet further, the present invention relates to a method of manufacturing a multilayer device, wherein the multilayer device consists of paramagnetic layers,

wherein at least one layer comprises a thin film comprising a thin film material according to any one of the embodiments disclosed herein,
wherein the thin film is preferably prepared according to the method of any one of the embodiments disclosed herein,
wherein preferably $1.4 \leq (1+nx) \leq 1.6$, $(1+nx) \neq 1.5$, and $|(1-x)-1| > 0.01$, , or wherein preferably $(1+nx)= 1$ and $1-x = 1$.

Yet further, the present invention relates to a method of manufacturing a multilayer device, wherein the multilayer device consists of ferromagnetic layers, wherein at least one layer comprises a thin film material according to claims 1-7, wherein the thin film material is preferably prepared according to the method of any one of the embodiments disclosed herein, wherein $(1+nx) \neq 1.5$, and if $1.45 < (1+nx) < 1.55$ then $|(1-x)-1| > 0.05$ and Mg and Ti cations are mixed within the same basal planes, or wherein $(1+nx) \neq 1.5$, and if $0.95 < (1+nx) < 1.05$ then $|(1-x)-1| > 0.05$ and Mg and Ti cations are mixed within the same basal planes.

Yet further, the present invention relates to a method of manufacturing a multilayer device, wherein the multilayer device consists of ferromagnetic and paramagnetic layers,

wherein at least one layer comprises a thin film comprising a thin film material according claims 1-7,
wherein the thin film is prepared according to the method of any one of the embodiments disclosed herein, wherein $(1+nx) * 1.5$, $1.4 \leq (1+nx) \leq 1.6$, and $|(1-x)-1| > 0.01$, or wherein $(1+nx) = 1$ and $1-x = 1$, and
wherein at least one further layer comprises a thin film comprising a thin film material according to any one of the embodiments disclosed herein, wherein the thin film of the at least one further layer is prepared according to the method of any one of the embodiments disclosed herein, wherein $1+nx \neq 1.5$, and if $1.45 < (1+nx) < 1.55$ then $|(1-x)-1| > 0.05$ and Mg and Ti cations are mixed within the same basal planes, or wherein if $0.95 < (1+nx) < 1.05$ then $|(1-x)-1| > 0.05$ and Mg and Ti cations are mixed within the same basal planes.

Yet further, the present invention relates to a use of a thin film material according to any one of the embodiments disclosed herein in the manufacturing process of a multilayer device as disclosed herein.

Yet further, the present invention relates to a use of a thin film material according to any one of the embodiments disclosed herein in the manufacturing process of a multilayer device disclosed herein through a single growth cycle comprising at least one layer.

Yet further, the present invention relates to a use of a thin film material according to any one of the embodiments disclosed herein or of a thin film according to claims 1-7 in an electrical device, preferably in an electrical device comprising a thin film material, wherein the magnetization of the thin film material increases with increasing temperature, preferably in the range of from $40\times1000\ Am^{-1}$ [40 emu $cm^{-3}$] at 5 K to $60\times1000\ Am^{-1}$ [60 emu $cm^{-3}$] at 300 K. Yet further, the present invention relates to a method of patterning metallic electrodes on the thin film material according to any one of the embodiments disclosed herein by subjecting the thin film material to a localized beam, preferably an electron, a photon or an ion beam, in a reducing atmosphere, wherein

(a) the reducing atmosphere contains a mixture of $H_2$ gas and an inert gas, preferably one or more of $N_2$, Ar, He, Ne, Kr, and Xe;
(b) the thin film material is kept in a temperature between 293 and 1000K.

It is preferred that a thin film material is used having the formula $(Ni,Co)_{1+2x}Ti_{1-x}O_3$, wherein a laser beam is used as localized beam, wherein

(a) the wavelength of the laser beam is in the range of from 190 nm to 10 micrometer, preferably in the range of from 300 to 1100 nm; and
(b) the laser beam power is in the range of from 0.1 to 100 mW.

**Brief description of drawings**

Fig. 1. Specific example for the ATO structure. Left: Octahedra indicated by different patterning can each hold a different type of cation, or be vacant. The cation distribution is adjusted by adjusting the growth parameters during thin film deposition. Octahedra are shown along the stacking direction. Center: Octahedra are closely packed in the basal plane direction. Basal plane is perpendicular to the vertical stacking direction shown on the left. Right: Corner, edge and face sharing of octahedra.

Fig. 2. An example of a growth method of a four-layer device with high-quality interfaces. In the first and fourth phases an electrode layer (ELECTRODE) is deposited by adjusting the composition of the deposited material so that 2/3 of the octahedra are filled. This can be achieved by using V as cations. In the second and third phases the (Ni+Co)/Ti ratio is adjusted so that half of the octahedra and all octahedra are filled, respectively. Two ferromagnetic (FM) layers are deposited, with coercive fields $H_{c1}$ and $H_{c2}$.

Fig. 3. Two common adaptation mechanisms when metrically different layers are attached.

Fig. 4. Flowchart of the $A_{1+nx}T_{1-x}O_3$ thin film synthesis.

Fig. 5. X-ray diffraction patterns collected on $A_{1+2x}Ti_{1-x}O_3$ thin films deposited on difFerently oriented $Al_2O_3$ single crystal substrates, A = Ni,Co. Peaks are indexed in terms of hexagonal axes. The *c*-axis length varies as a function of composition and is approximately 1.46 nm (14.6 Å). The 110 and 220 reflection positions yield hexagonal *a*-axis length 0.54 nm (5.4 Å).

Fig. 6. Room-temperature magnetization versus in-plane magnetic field values for six $A_{1+2x}Ti_{1-x}O_3$ thin films, A = Ni,Co. Composition and the octahedra filling fraction $z_v$ are given on the right-hand side.

Fig. 7. X-ray diffraction patterns collected on $(Ni,Co)_3O_3$ thin films ($x$ = 1, $n$ = 2) deposited on $Al_2O_3$(0001) and Si(111)/$SiO_2$ substrates. Peaks are indexed in terms of hexagonal *c*-axis. The c-axis length varies as a function of composition and is approximately 1.46 nm (14.6 Å).

Fig. 8. X-ray diffraction patterns collected on $V_2O_3$ thin films deposited on $Al_2O_3$(0001), Si(100)/$SiO_2$ and Si(111)/$SiO_2$ substrates. Peaks are indexed in terms of hexagonal axes *a* and *c*, which have approximate lengths of *a* = 0.50 nm (5.0 Å) and *c* = 1.40 nm (14.0 Å).

Fig. 9. X-ray difFraction patterns collected on $Mg_{1+nx}Ti_{1-x}O_3$ thin films deposited on C-plane oriented $Al_2O_3$ single crystal substrates. Peaks are indexed in terms of hexagonal *c*-axis. The *c*-axis length varies as a function of composition and is approximately 1.37 nm (13.7 Å). Grey ellipses indicate the positions of 003, 006, 009, 0012 and 0015 reflections.

Fig. 10. Room-temperature in-plane magnetic moment values as a function of applied magnetic field for five $Mg_{1+nx}Ti_{1-x}O_3$ thin films deposited on C-plane oriented $Al_2O_3$ single crystal substrates. Composition, average Ti-oxidation state and the octahedra filling fraction $z_v$ are given on top of each panel.

Fig. 11. The intensities of the 00/reflections, relative to the 003 reflection, 1= 3, 6, 9, 12, 15. Crosses indicate measured intensities and circles indicate computed intensities.

Fig. 12. X-ray diffraction patterns of two $(Ni,Co)_3O_3$ thin films deposited on C-plane LiNbOs and $Al_2O_3$ substrates. The structure remains the same, but the strain along the *c*-axis direction is 3.3%. Peaks are indexed in terms of hexagonal *c*-axis. The *c*-axis length varies as a function of composition and is approximately 1.46 nm (14.6 Å).

Fig. 13. Hysteresis loops measured between 5 and 350 K from a $(Ni,Co)_3O_3$ thin film deposited on C-plane $Al_2O_3$ substrate showing that the ferromagnetism is preserved up to elevated temperatures. Saturation magnetization at 350 K is 89% from the value measured at 5 K. Film thickness was estimated to be 4 nm and area was 4 mm × 5 mm.

Fig. 14. X-ray diffraction patterns collected on $Mn_{1+nx}Ti_{1-x}O_3$ thin films deposited on C-plane oriented $Al_2O_3$ single crystal substrates. Peaks are indexed in terms of hexagonal axes a and c. The c-axis length varies as a function of composition and is approximately 1.38 nm (13.8 Å).

Fig. 15. Hysteresis loops measured at 5, 150 and 300 K from a $Mn_{0.33}Ti_{1.31}O_3$ thin film deposited on C-plane $Al_2O_3$ substrate.

Fig. 16. A schematic illustration of the defect-free interface between functionally and compositionally different layers. The size and the orientation of the octahedra remain intact at the interfacial plane. In the ATO1 layer all octahedra are filled by Ni or Co. In the ATO2 layer a finite fraction of the octahedra are filled by Ni or Co and Ti. Vacant octahedra are indicated by white color.

Fig. 17. X-ray diffraction patterns collected on $V_2O_3$(1)/$V_2O_3$(2)/ $(Ni,Co)VO_3$ multilayer structure grown on C-plane $Al_2O_3$ substrate in one growth cycle. Peaks are indexed in terms of hexagonal axes. The *c*-axes lengths of $V_2O_3$(1), $V_2O_3$(2), and $(Ni,Co)VO_3$ are 1.46 nm (14.6 Å), 1.35 nm (13.5 Å), and 1.41 nm (14.1 Å), respectively.

Fig. 18. XRD patterns of $(Ni,Co)_3O_3$ and Cr-doped (circa 5 at.% of the cations are Cr) films grown on C-plane $Al_2O_3$ and C-plane LiNbOs substrates. Films of the same pair, specifically 1 and 2, and 3 and 4 were grown in the same growth cycle. Film thicknesses in nm are indicated.

Fig. 19. XRD patterns of the spinel $Co_3O_4$, rocksalt MgO, spinel $(Mn,Mg)_3O_4$ and spinel $Mn_3O_4$. All films were deposited on C-plane sapphire under 1.3 Pa oxygen pressure at 923 K.

Fig. 20. Schematic illustration of a spin filter device and the role of interfacial defects. Antiferromagnetic (AFM) layer clamps the magnetization of the ferromagnetic (FM) layer via exchange bias. Only the pinned fraction of AFM magnetic moments creates exchange bias.

Fig. 21. Schematic illustration of the defect-free spin filter carried out by ATO thin films. AFM layer clamps the FM layer via exchange bias.

Fig. 22. Schematic illustration of the bandpass filter carried out by ATO thin films.

Fig. 23. The structural variants with the corresponding computed magnetization values. The fraction of unpaired electrons per rhombohedral cell, dominantly localized at Ti, is given. ET is given in eV. When the optimization algorithm converged to an initial value dependent minimum, the difference between competing magnetic structures is given in meV.

Fig. 24. The triangle, limited by the lines G1, G2 and L1 and the intersections of said lines, gives the generic parameter values for depositing ATO thin films. The crosses falling into line G1 correspond to $A_{1+2x}Ti_{1-x}O_3$ films, A is Ni,Co and T is Ti. Grey area, enclosed by dashed lines L1, L2, L3 and L4, and the intersections of said lines, gives the parameter space for depositing ferromagnetic $Mg_{1+nx}Ti_{1-x}O_3$ films. Exceptions are indicated. Diamond symbols are experimental values of $Mg_{1+nx}Ti_{1-x}O_3$ films (cf. Example 4 as disclosed herein), and circles are from DFT-computations. The hatched circle at point (1.5;1.5) corresponds to the ferrimagnetic LN4 structure, Fig. 23. Arrows indicate points in which ferromagnetic coupling can be prevented by intervening Mg-O layers.

Fig. 25. XRD pattern of $(Ni,Co)_3O_3$ film grown on GaN/Si(111) substrate.

Fig. 26. XRD patterns collected on $(Ni,Co)_3O_3$ and $(Ni,Co)TiO_3$ thin films before and after reducing in 4%$H_2$+96%Ar-gas atmosphere. Reduction results in a formation of metallic (Ni,Co) phase.

Fig. 27. Electrode patterning on $(Ni,Co)_{1+2x}Ti_{1-x}O_3$ films by laser beam in reducing atmosphere. (Ni,Co) electrode is presented by black colour. $T_{red}(1)$ and $T_{red}(2)$ refer to the reduction temperatures of the NC and NCT films, respectively. Reduction in lateral and depth dimensions is controlled. Right-hand side illustrates the pattern from up, and left-hand side shows the cross-sectional view.

## Description of embodiments

First preferred group of embodiments: $A_{1+nx}T_{1-x}O_3$ thin films, wherein preferably A = Ni, Co; T = Ti.

Figure 4 shows the flowchart describing the Pulsed Laser Deposition (PLD) growth of the ATO thin films. Typically, film thicknesses were of from 40 to 80 nm, though thinner ferromagnetic films with thicknesses of a few nm were also deposited, see Figs. 12, 13 and 18. ATO phase formation requires correct, composition dependent in-situ substrate temperature $T_s$, typically low oxygen gas pressure $p(O_2)$ and atomic scale mixing of elements. The Ni/Co ratio was of from 0.28 to 2.5. Ni is required as cobalt and oxygen would not form the ATO structure, but rather crystallizes in the spinel structure, see Fig. 19. Typical values applied in the PLD of $(Ni,Co)_{1+2x}Ti_{1-x}O_3$ films were: 723 K < $T_s$ < 873 K, 0 < $p(O_2)$ < 1.3 Pa, and 3 $Jcm^{-2}$ < laser beam fluence < 3.4 $Jcm^{-2}$. Atomic scale mixing was achieved by shooting of from 1 to 10 shots on each target at a time after which a switch to next target was carried out. The shot ratio and the total number of shots were adjusted so that the desired thin film composition was achieved. XRD, x-ray photoelectron spectroscopy and Raman spectroscopy measurements verified the structure and composition.

Second preferred group of embodiments: $A_{1+nx}T_{1-x}O_3$ thin films, wherein preferably A = Mg and T = Ti.

The procedure summarized in Fig. 4 was applied to deposit $Mg_{1+nx}Ti_{1-x}O_3$ films. XRD patterns collected on $Mg_{1+nx}Ti_{1-x}O_3$ films are shown in Fig. 9. In contrast, when Mg and O alone are mixed the rocksalt MgO structure is formed, instead of the desired ATO structure, Fig. 19. Thus, it is necessary to preferably introduce Ti to stabilize the ATO structure. Typical values applied in the PLD were $T_s$ = 873 K, $p(O_2)$ = 1.3 Pa and laser beam fluence 3.2 $Jcm^{-2}$. Atomic scale mixing was achieved by shooting of from 1 and 10 shots on each target at a time after which a switch to next target was carried out. The shot ratios on MgO and $Ti_2O_3$ targets were adjusted so that the desired composition was achieved.

Third preferred group of embodiment: $A_{1+nx}T_{1-x}O_3$ thin films, wherein A = Mn and T = Ti
The procedure summarized in Fig. 4 was applied to deposit $Mn_{1+nx}Ti_{1-x}O_3$ films. XRD patterns collected on $Mn_{1+nx}Ti_{1-x}O_3$ films are shown in Fig. 14. In contrast, when Mn and O alone are mixed the spinel $Mn_3O_4$ structure is formed, instead of the desired ATO structure, see Fig. 19. Thus, it is necessary to preferably introduce Ti to stabilize the ATO structure. Also the mixing of Mg, Mn and O yields the spinel structure, Fig. 19. Typical values applied in the PLD were $T_s$ = 823 K, $p(O_2)$ = 1.3 Pa and laser beam fluence of from 3 to 3.4 $Jcm^{-2}$. Atomic scale mixing was achieved by shooting of from 1 to 10 shots on MnO and $Ti_2O_3$ targets at a time after which a switch to next target was carried out. The shot ratios were adjusted to achieve desired composition.

Fourth preferred group of embodiments: Multilayer devices

By adjusting the shot ratios on targets during the deposition cycle ATO layers with different values of *x* and with different A-cation distribution can be formed during a single growth cycle to form multilayer structures schematically exemplified in Figs. 2 and 16. Devices are further constructed from multilayer structures, as illustrated in Figs. 20, 21 and 22.

**Examples** (Note: Examples not covered by claims 1-3 and claims 8-10 are not part of the invention.)

Example 1: Growth of $A_{1+nx}T_{1-x}O_3$, A = Ni, Co and T = Ti and *n* = 2 thin films

$(Ni,Co)_{1+2x}Ti_{1-x}O_3$ thin films were deposited by Pulsed Laser Deposition (PLD) growth. XRD patterns collected on the thin films are shown in Fig. 5. Fig. 6 shows room-temperature magnetization-versus-applied-field hysteresis loops measured from the films.

Films were grown on C-, M- and R-plane single crystal sapphire substrates which were annealed at 1373 K for 6 hours in order to form a terrace structure to facilitate film growth. Substrates were fixed by silver paste on a metal plate adjacent to a heating element. Temperature was measured by a thermocouple and a pyrometer. Heating ramp was 10 K/(60s) and during growth the in-situ substrate temperature was 873 K. Oxygen gas pressure was 1.3 Pa during heating, deposition and cooling. Films were grown by ablating NiTiOs, CoTiOs, and $NiCoO_4$ targets. The targets were rotated during ablation. Laser wavelength was 248 nm and the pulse repetition rate was 10 Hz. Laser beam fluence was of from 3 to 3.3 $Jcm^{-2}$. Laser beam fluence was adjusted by measuring the pulse size on target and then adjusting the laser beam pulse energy to a desired level. Typically the rectangular spot area was close to 0.01 $cm^{-2}$. Atomic scale mixing was achieved by shooting of from 1 to 10 shots on each target at a time after which a switch to next target was carried out. The shot ratio and the total number of shots were adjusted so that the desired thin film composition was achieved. Typically the rectangular spot had dimensions 0.85 mm $\times$ 1.3 mm and the pulse energy was approximately 35 mJ. Table 3 summarizes the pulses shot on each target to achieve the films shown in Fig. 5. A cycle was consisted of shots on each target, and the total number of cycles was adjusted so that a typical film thickness 50 nm was achieved.

Table 3. Shot distribution and the total number of cycles N. The total number of pulses was N$\times$(sum of shots on targets in one cycle) and was 5000 or close to 5000.

| Film | Shots on $NiTiO_3$ target | Shots on $CoTiO_3$ target | Shots on $NiCoO_4$ target | N | Substrate |
|---|---|---|---|---|---|
| $(Ni_{0.46}Co_{0.54})_{1.05}Ti_{0.97}O_3$ | 4 | 5 | 4 | 385 | C-plane $Al_2O_3$ |
| $(Ni_{0.42}Co_{0.58})_{2.22}Ti_{0.39}O_3$ | 2 | 2 | 12 | 313 | C-plane $Al_2O_3$ |
| $(Ni_{0.42}Co_{0.58})_{2.22}Ti_{0.39}O_3$ | 2 | 2 | 12 | 313 | M-plane $Al_2O_3$ |
| $(Ni_{0.39}Co_{0.61})_3O_3$ | 0 | 0 | 1 | 5000 | C-plane $Al_2O_3$ |
| $(Ni_{0.39}Co_{0.61})_3O_3$ | 0 | 0 | 1 | 5000 | M-plane $Al_2O_3$ |
| $(Ni_{0.39}Co_{0.61})_3O_3$ | 0 | 0 | 1 | 5000 | R-plane $Al_2O_3$ |

In Table 3, films with no titanium correspond to the case in which all octahedra are filled. In that particular case of $(Ni,Co)_3O_3$ films the space group is *P*$6_3$*/mmc* (No. 194). The Ni/Co ratio was of from 0.28 to 2.5. Ni is required as cobalt and oxygen do not form the ATO structure, but crystallizes in the spinel structure, see Fig. 19. The unexpected results is that the thin films possess a new structure not found in bulk materials and, crucially for device manufacturing, were found to be electrically insulating ferromagnetic compounds. The formation of the new, single phase ATO structure requires that the in-situ substrate temperature is in a correct range, typically of from 723 to 923 K, and preferably of from 800 to 873K, low oxygen pressure of from 0 to 2.7Pa, and the presence of both $Ni^{2+}$ and $Co^{2+}$. Surprisingly, despite their chemical similarity, the desired ATO structure is not formed if there are no Ni and/or Ti in addition to Co: use of Co and oxygen only results in a formation of the spinel structure. The desired structure is formed under the given processing conditions if Ni, Co and oxygen are used in the growth of the films.

In strong contrast to ferromagnetic ATO structured films, NiTiOs and CoTiOs ilmenites are paramagnetic down to 23 and 38 K, respectively. Below 23 K (NiTiOs) and 38 K (CoTiOs) compounds are antiferromagnetic. Magnetization of ATO thin films changes as a function of composition and oxygen octahedra filling fraction $z_v$. Figs. 6 and 13 show that there is a broad composition range which correspond to magnetization values suitable for practical applications. By tuning the composition lattice parameters can be adjusted to avoid detrimental interfaces. The choice of composition also controls the specific resistivity, see Table 1.

To achieve similar films with other thin film growth techniques, such as sputtering or chemical vapor deposition, sufficiently low *T* and $p(O_2)$ should be applied. Also atomic scale mixing during growth must be ensured.

Example 2: Growth of $(Ni,Co)_3O_3$ films on oxidized silicon

Fig. 7 shows XRD patterns of the $(Ni,Co)_3O_3$ films grown on C-plane $Al_2O_3$, Si(100)/$SiO_2$ and Si(111)/$SiO_2$ substrates. Silicon substrates were in-situ oxidized before deposition at 923 K at 13.3Pa $O_2$ pressure after which the pressure was decreased to 1.3 Pa. 10000 pulses were shot on $NiCoO_4$ target at 10 Hz repetition rate. Fluence was 3.1 $Jcm^{-2}$. For comparison, a film on C-place $Al_2O_3$ was grown at the same time. In-situ substrate temperature was adjusted to 875 K. The structure is ATO with all octahedra filled.

Example 3: Strained $(Ni,Co)_{1+2x}Ti_{1-x}O_3$ thin films

Fig. 12 shows XRD patterns of the oriented single phase $(Ni,Co)_3O_3$ films grown on C-plane $Al_2O_3$ and LiNbOs substrates. 250 pulses were shot at pulse repetition rate 1 Hz. Fluence was 3.1 $Jcm^{-2}$. In-situ substrate heating temperature was 923 K and $O_2$ pressure was 1.3 Pa. The structure of $(Ni,Co)_3O_3$ films can sustain large strain: Strain along the c-axis direction is 3.3 %. Experiments showed that the lattice parameters of the films grown on C-plane $Al_2O_3$ substrates remain constant with increasing film thickness, whereas the layers grown on $LiNbO_3$ relax after the critical thickness is exceeded. The relaxed c-axis value was found to be identical to the value found in films grown on the C-plane $Al_2O_3$. Thus the strain was estimated as
[c(film on $Al_2O_3$)-*c*(film on $LiNbO_3$)]/*c*(film on $Al_2O_3$).

Fig. 13 shows that $(Ni,Co)_3O_3$ films are ferromagnetic up to the highest measurement temperature, 350 K. Magnetization decreased by 11% when temperature increased from 5 K to 350 K. The thickness of the film deposited on the C-plane $Al_2O_3$ was approximately 4 nm. The magnetization value of the thinnest films, Fig. 13, is 10 times the magnetization value $130\times 1000\ Am^{-1}$ [130G] commonly referred to YIG. YIG is commonly considered as the prototype insulating ferromagnetic material.

Materials ability to sustain large strain without a change in the structure forms a basis for tunable devices. Strain can be generated in a controlled manner by an adjacent piezoelectric layer via magnetostriction. Large, voltage controlled strain can also be generated by a cantilever structure in which a beam (e.g., etched on silicon wafer) is sandwiched between piezoelectric layers. Large bending is achieved when one layer contracts along the beam length direction and the other expands. Strain controlled magnetization is a key requirement in tunable RF-components.

Example 4: $A_{1+nx}T_{1-x}O_3$, A = Mg and T = Ti films

Fig. 9 shows XRD pattern collected on five $Mg_{1+nx}Ti_{1-x}O_3$ thin film samples grown on C-plane sapphire substrates and Fig. 10 shows hysteresis data measured from the films at 5 and 350 K temperature. Table 4 summarizes the pulses shot on each target to achieve the films shown in Fig. 9. A cycle was consisted of shots on each target, and the total number of cycles was adjusted so that the desired thickness was achieved. The laser pulse repetition rate was 10 Hz. Fluence was 3.2 $Jcm^{-2}$. In-situ substrate heating temperature was 889 K and $O_2$ pressure was 1.3 Pa.

Table 4. Shot distribution and the total number of cycles N. The total number of pulses was N×(sum of shots on targets in one cycle).

| Film | Shots on MgO target | Shots on $Ti_2O_3$ target | N | Substrate |
|---|---|---|---|---|
| $Mg_{0.73}Ti_{1.38}O_3$ | 2 | 8 | 500 | C-plane $Al_2O_3$ |
| $Mg_{1.01}Ti_{1.27}O_3$ | 3 | 7 | 500 | C-plane $Al_2O_3$ |
| $Mg_{1.24}Ti_{1.17}O_3$ | 4 | 6 | 500 | C-plane $Al_2O_3$ |
| $Mg_{1.49}Ti_{1.03}O_3$ | 5 | 5 | 500 | C-plane $Al_2O_3$ |
| $Mg_{1.64}Ti_{0.98}O_3$ | 5 | 4 | 556 | C-plane $Al_2O_3$ |

Confirmation of the ATO structure was based on the XPS and XRD measurements.

Fractional coordinates of the atoms in the primitive cell of the ATO structure applied for computing the structure factor is given in Table 5.

The positions are given in terms of the hexagonal axes. The corresponding hexagonal unit cell has three primitive cells, at positions (0,0,0), $(\frac{1}{3},\frac{2}{3},\frac{2}{3})$ and $(\frac{2}{3},\frac{1}{3},\frac{1}{3})$. The z-coordinates and the occupancies of the sites are adjusted so that the 00*l*, *l*= 3, 6, 9, 12, 15, reflection intensities are reproduced. The sites occupancies give the octahedra filling factor. In the general ATO structure the cation *x* and *y* coordinates can deviate from zero and the symmetry relationship implied by fractional coordinate dependencies listed below do not necessary hold. A characteristic feature of the ATO structure is the filling of sites 5 and 6.

The octahedra filling can be determined by refining anion and cation positions and occupancies so that the measured XRD patterns, Fig. 9, are reproduced. Fig. 9 shows that in all samples the *c*-axis is perpendicular to the substrate. The distinctive feature seen in the diffraction intensities is that 009 and 0015 reflections are absent, which, together with the observed intensities of 003, 006 and 0012 reflections allow to determine the ATO structure.

Table 5. Fractional coordinates of the atoms in the primitive cell of the ATO structure where A = $Mg^{2+}$ and T = $Ti^{3+}$. Site specific atomic form factors are tabulated.

| Site | Atom | Fractional coordinates | | | Atomic form factor |
|---|---|---|---|---|---|
| 1 | Mg,Ti | 0 | 0 | $z_1$ | $f_A$ |
| 2 | Mg,Ti | 0 | 0 | $-z_1$ | $f_A$ |
| 3 | Mg,Ti | 0 | 0 | $z_2$ | $f_B$ |
| 4 | Mg,Ti | 0 | 0 | $-z_2$ | $f_B$ |
| 5 | Mg,Ti | 0 | 0 | 0 | $f_C$ |
| 6 | Mg,Ti | 0 | 0 | ½ | $f_D$ |
| 7 | O | *x* | *y* | $z_3$ | $f_O$ |
| 8 | O | *-y* | *x-y* | $z_3$ | $f_O$ |
| 9 | O | *-x+y* | *-x* | $z_3$ | $f_O$ |
| 10 | O | *-x* | *-y* | $-z_3$ | $f_O$ |
| 11 | O | *y* | *-x+y* | $-z_3$ | $f_O$ |
| 12 | O | *x-y* | *x* | $-z_3$ | $f_O$ |

The cation and oxygen fractions were determined by XPS measurements and were held fixed. The cation distribution in the sites 1-6 was adjusted so that the XRD intensities were reproduced. The filling of sites 5 and 6 is the origin of the absence of 009 and 0015 reflections.

In the present case, consistently with Fig. 9, the structure factor $S_{00l}$ can be written as

$$S_{00l} = 2f_A \cos 2\pi l z_1 + 2f_B \cos 2\pi l z_2 + f_C + f_D(-1)^l + 3f_O \cos 2\pi l z_3$$

where the cation site occupancy is of from 0 to 1 and each cation site can hold an average scatterer consisted of a fraction of $Ti^{3+}$ and $Mg^{2+}$ cations. In this case the structure factors possess no imaginary part and the intensity of the 00*l* reflection is directly proportional to the square of the structure factor. The atomic form factors of cations are labelled as $f_A$,$f_B$,$f_C$,$f_D$, and oxygen as $f_O$, as specified in Table 5. Atomic form factors for cations and oxygen were estimated from equation $f(\sin\theta/\lambda) = \sum_{i=1}^{4} a_i \exp(-b_i \sin^2\theta/\lambda^2) + c$, where the parameters $a_i$, $b_i$ and *c* were taken from ref. 31. When the same site shares both $Mg^{2+}$ and $Ti^{3+}$ cations in atomic percentage fractions *x* and 1-*x*, respectively, the atomic form factor was taken as $xf_{Mg} + (1-x)f_{Ti}$. Polarization, Lorentz and geometrical factors were modelled by multiplying the square of the structure factor by a function $g(\theta) = (1 + \cos^2 2\theta)/(\sin^2\theta \cos\theta)$.

Tables 6 and 7 tabulate the fractional z-coordinates and site occupancies for five single phase thin films. Only values corresponding to sites 1, 3, and 5-7 are tabulated. Values for other sites follow from symmetry, Table 5.

Table 6. Cation and oxygen displacements $z_1$, $z_2$ and $z_3$, site occupancies (SO) and *c*-axis length as determined from 003, 006, 009, 0012 and 0015 XRD peak intensities and positions for Mg-rich $Mg_{1+nx}Ti_{1-x}O_3$ films.

| Site, atom | *z* | $Mg_{1.64}Ti_{0.98}O_3$ *c*= 1.3877 nm (13.877 Å) | | $Mg_{1.49}Ti_{1.03}O_3$ *c*=1.3880 nm (13.880 Å) | | $Mg_{1.24}Ti_{1.17}O_3$ *c*=1.3872 nm (13.872 Å) | |
|---|---|---|---|---|---|---|---|
| | | *z* | SO | *z* | SO | *z* | SO |
| 1, Mg | $z_1$ | 0.369 | 0.864 | 0.363 | 1 | 0.374 | 0.984 |
| 1, Ti | $z_1$ | 0.369 | 0.136 | 0.363 | 0 | 0.374 | 0.016 |
| 3, Mg | $z_2$ | 0.126 | 0.136 | 0.125 | 0 | 0.124 | 0.016 |
| 3, Ti | $z_2$ | 0.126 | 0.844 | 0.125 | 1 | 0.124 | 0.984 |
| 5, Mg | 0 | 0 | 0.312 | 0 | 0 | 0 | 0.120 |
| 5, Ti | 0 | 0 | 0 | 0 | 0.06 | 0 | 0.211 |
| 6, Mg | ½ | ½ | 0.968 | ½ | 0.98 | ½ | 0.360 |
| 6, Ti | ½ | ½ | 0 | ½ | 0 | ½ | 0.129 |
| 7, O | $z_3$ | 0.255 | 1 | 0.268 | 1 | 0.257 | 1 |

Table 7. Cation and oxygen displacements $z_1$, $z_2$ and $z_3$, site occupancies (SO) and c-axis length as determined from 003, 006, 009, 0012 and 0015 XRD peak intensities and positions of Ti-rich $Mg_{1+nx}Ti_{1-x}O_3$ films.

| Site, atom | *z* | $Mg_{1.01}Ti_{1.27}O_3$ *c*=1.3801 nm (13.801 Å) | | $Mg_{0.73}Ti_{1.33}O_3$ *c*=1.3746 nm (13.746 Å) | |
|---|---|---|---|---|---|
| | | *z* | SO | *z* | SO |
| 1, Mg | $z_1$ | 0.373 | 0.938 | 0.375 | 0.346 |
| 1, Ti | $z_1$ | 0.373 | 0.061 | 0.375 | 0.654 |
| 3, Mg | $z_2$ | 0.131 | 0.061 | 0.124 | 0.346 |
| 3, Ti | $z_2$ | 0.131 | 0.938 | 0.124 | 0.654 |
| 5, Mg | 0 | 0 | 0.016 | 0 | 0.038 |
| 5, Ti | 0 | 0 | 0.430 | 0 | 0.072 |
| 6, Mg | ½ | ½ | 0.004 | ½ | 0.038 |
| 6, Ti | ½ | ½ | 0.110 | ½ | 0.072 |
| 7, O | $z_3$ | 0.288 | 1 | 0.257 | 1 |

Fig. 11 shows the computed relative intensities of the 00/(/=3,6,9,12,15) reflections as expected for the aforementioned model, together with the experimentally determined values. In a more general case the structure determination can be very involved and specific methods, such as described in refs. [32-35] can be applied.

Hysteresis data, Fig. 10, shows that by choosing the elemental ratio correctly a soft ferromagnetic compound can be formed. In contrast, stoichiometric bulk $MgTiO_3$ ilmenite is a paramagnetic dielectric material. Magnetism is preserved up to the highest measurement temperature 350 K. The thicknesses of the $Mg_{1.01}Ti_{1.27}O_3$ and $Mg_{0.73}Ti_{1.38}O_3$ films were 50 and 59 nm, respectively, and the lateral dimensions were 5 mm × 5 mm, yielding saturation magnetizations of 5× 1000 $Am^{-1}$ and 13×1000 $Am^{-1}$ [5 and 13 $emucm^{-3}$], respectively. The thicknesses were estimated from the subsidiary maxima in the XRD patterns. Also paramagnetic layer can be formed, as demonstrated in the first panel in Fig 10.

Example 5: $A_{1+nx}T_{1-x}O_3$, A = Mn and T = Ti films

The deposition parameters of $Mn_{1+nx}Ti_{1-x}O_3$ films grown on sapphire substrates were: laser pulse repetition rate 10 Hz, fluence 3.4 $Jcm^{-2}$, in-situ substrate heating temperature 873 K and $O_2$ pressure was 1.3Pa. Table 8 summarizes the pulses shot on each target for achieving the films whose XRD patterns are shown in Fig. 14. A cycle was consisted of shots on each target, and the total number of cycles was adjusted so that the desired thickness was achieved.

Table 8. Shot distribution and the total number of cycles N. The total number of pulses was N×(sum of shots on targets in one cycle).

| Film | Shots on MnO target | Shots on $Ti_2O_3$ target | N | Substrate |
|---|---|---|---|---|
| $Mn_{0.10}Ti_{1.46}O_3$ | 1 | 9 | 500 | C-plane $Al_2O_3$ |
| $Mn_{0.21}Ti_{1.40}O_3$ | 2 | 8 | 500 | C-plane $Al_2O_3$ |
| $Mn_{0.31}Ti_{1.38}O_3$ | 3 | 7 | 500 | C-plane $Al_2O_3$ |
| $Mn_{0.33}T_{11.31}O_3$ | 1 | 3 | 1250 | C-plane $Al_2O_3$ |

Fig. 15 shows hysteresis data measured from $Mn_{0.33}Ti_{1.31}O_3$ thin film at 5, 150 and 300 K, indicating that by choosing the elemental ratio correctly a soft ferromagnetic compound can be formed. Saturation magnetization increases by 7 % when temperature increases from 5 K to 300 K. In contrast, stoichiometric $MnTiO_3$ ilmenite is a paramagnetic dielectric material down to 41 K at which temperature an antiferromagnetic ordering onsets. The thicknesses of the films were of from 70 to 80 nm. Data shown in Fig. 15 were collected on a film with lateral dimensions of 4 mm × 5 mm, yielding saturation magnetization of 44×1000 $Am^{-1}$ [44$emucm^{-3}$]. Thicknesses were estimated from the subsidiary maxima in the XRD patterns.

Example 6: Multilayers

The procedure summarized in Fig. 4 was applied to deposit $V_2O_3$ electrode films. Films were grown in vacuum by ablating $V_2O_3$ target and the in-situ substrate temperature was adjusted to 923K. Laser beam fluence was 3 $Jcm^{-2}$ and the pulse repetition rate was 10 Hz.

Fig. 8 shows XRD patterns measured from $V_2O_3$ films grown on C-plane $Al_2O_3$ and Si(111)/$SiO_2$ substrates.

$V_2O_3$ is electrically conducting at room-temperature and can be applied as an electrode layer. Deposition in excessive (>13 Pa) $O_2$-pressure results in a formation of undesired phases. Deposition of multilayer structures from the ATO compound and $V_2O_3$ necessitates that the in-situ deposition parameters are adjusted for each layer, as indicated by the loop connecting phases 2 and 3 in Fig. 4.

As an example of a multilayer structure, $V_2O_3$(1)/$V_2O_3$(2)/(Ni,Co)$VO_3$ layer was deposited. C-plane $Al_2O_3$ substrate was heated to 921 K temperature. This temperature was kept constant during the entire deposition. Laser beam fluence was adjusted to 2.7 $Jcm^{-2}$. In the first step, $V_2O_3$(1) layer was deposited in vacuum by shooting 100 pulses on $V_2O_3$ target at 1 Hz pulse repetition rate, after which 100 pulses were shot on $V_2O_3$ target, and during this growth step the oxygen pressure was increased from 0 to 2.7Pa. Vacuum deposition was applied to get a good initial seed layer. The seed layer is strained in the substrate plane direction, resulting in a shorter *a*-axis length (in-plane) and longer c-axis length (out-of-plane). In the next phase $V_2O_3$(2) layer was deposited in $p(O_2)$=1.3Pa atmosphere by shooting 4800 pulses on $V_2O_3$ target. Finally, (Ni,Co)$VO_3$ layer was formed by shooting 5000 pulses on $NiCoO_4$ target at 10 Hz pulse repetition rate. Small amount of vanadium cations were diffused into the $(Ni,Co)_3O_3$ layer. Fig. 17 shows XRD pattern measured from a $V_2O_3$(1)/$V_2O_3$(2)/(Ni,Co)$VO_3$ multilayer structure grown on C-plane $Al_2O_3$ substrate during one growth cycle.

Example 7: Accelerated film growth on $LiNbO_3$ substrate

Fig. 18 compares two film pairs. For both pairs, XRD-patterns collected from a film deposited on a C-plane $Al_2O_3$ and C-plane $LiNbO_3$ substrates are given. The shift of the peaks grown on different substrates is due to the different in-plane stress: films on $LiNbO_3$ are under a compressive biaxial stress, whereas there is almost no stress on films grown on $Al_2O_3$. Films 1 and 2 were grown by shooting one laser pulse on $Cr_2O_3$ target and then nine shots on $NiCoO_4$ target at 1 Hz pulse repetition rate after which the cycle was repeated. Laser beam fluence was 3.3 $Jcm^{-2}$. The total number of the cycles was 25, so that 25 pulses were shot on $Cr_2O_3$ target and 225 on $NiCoO_4$ target. Films 3 and 4 were grown by shooting 500 pulses on $NiCoO_4$ target at 1 Hz pulse repetition rate. Laser beam fluence was 3.2 $Jcm^{-2}$.

Example 8: Spin-filter

A more advanced device, a spin filter allowing only one of the electron spin currents to go through is shown in Fig. 20. The magnetization direction of the non-clamped layer is switched by an applied field. If the magnetization directions of the non-clamped and clamped layers are parallel electrons with spin up can flow through, and electrons with spin down are blocked. If the magnetization directions are antiparallel, no current flows through. Fig. 20 also shows the crucial interface between the antiferromagnetic and ferromagnetic layer. Antiferromagnetic layer clamps the magnetization of the ferromagnetic layer. This layer is critical and the defects influence the pinned magnetization. Fig. 21 shows the spin filter device doable by ATO multilayer structure, which can be deposited by a single growth cycle. The antiferromagnetic structure can be constructed from materials known to be antiferromagnetic at room-temperature and being compatible with the ATO structure, such as $Cr_2O_3$, $NiMnO_3$ or $CoMnO_3$. Another possibility is to make an artificial antiferromagnetic layer from ATO materials by constructing two thin layers magnetized in antiparallel fashion. This can be done, for instance, by applying a magnetic field during deposition.

Example 9: Tunable RF-filter

Fig. 22 shows a tunable RF-range bandpass filter based on a ferroelectric layer, which changes the ferromagnetic resonance frequency of the ferromagnetic layer via the magnetostriction effect. Ferroelectric layer is piezoelectric and thus its dimensions can be controlled by an applied voltage. Incoming RF-signal is strongly absorbed at the ferromagnetic resonance frequency and is converted into propagating spin waves. Depending on the geometry magnetostatic surface waves, magnetostatic backward volume waves and magnetostatic forward volume waves can be excited. The composition of the ferromagnetic layer can be similar to the four strongest magnetic layers shown in Fig. 6. Composition can be adjusted to correspond to the technical needs. Ferroelectric layer can, for instance, be $LiNbO_3$ or $LiTaO_3$ film. To enhance the magnitude of the strain one can strain the film in the vertical direction, instead of a lateral strain. Larger strains can be generated by implementing the components to be a part of a microelectromechanical system (MEMS), an example being a cantilever structure. There are characteristically several absorption frequencies, and the material composition, thickness, and lateral dimensions can be adjusted so that absorption occurs at desired frequency.

Example 10: parameters for preparing paramagnetic and ferromagnetic and ferrimagnetic $A_{1+nx}T_{1-x}O_3$ thin films, wherein A = Mg and T = Ti

Prior art, refs. 7 and 8, considers the case in which the structure is preserved as the ideal ilmenite, with 1/3 of the octahedra being vacant. Particularly, excess Ti replaces Mg without changing the fraction of vacant octahedra, or their position. One of the characteristic features in the present invention is that these two constraints are no longer valid. Another characteristic feature is that segregating cations in Mg and Ti rich layers is no longer valid. For technical applications this can make a drastic difference:
In bulk materials magnetization, in units of $emug^{-1}$ in refs. 7 and 8, were of the order of 0.1 $emug^{-1}$ and were limited to temperatures below 290 K. For comparison, sample $Mg_{1.24}Ti_{1.17}O_3$ had a room-temperature saturation magnetization 10 $emug^{-1}$. The film value is estimated from Fig. 10 using the lattice parameter estimates a =0.5084 nm, $c$ =1.3872 nm, film dimensions, area 5 mm $\times$ 5 mm and a thickness of 62 nm, and atomic masses.

A rich set of different magnetic phases can be obtained in thin films by cation arrangement. The same set of Mg and Ti cations can be located in the octahedra in numerous ways. Fig. 23 shows 6 variants of the lithium niobate (LN) and 9 variants of the ilmenite (I) structure, which differ in the way the octahedra vacant in the LN and I structures are occupied. The values are obtained from the density functional theory (DFT) computations. Stoichiometrically equivalent structures have different magnetic properties. As an example, structures I2 and I3 differ only in the way excess Ti is inserted into the structure: in the I2 structure the 3b site is occupied and 3a is empty, and in the I3 structure 3a site is occupied, whereas site 3b is empty. The difference in magnetic properties is drastic. A second point concerns the mixing of Mg and Ti in the same basal plane. In the ilmenite structure the Mg-O layers alternate with the Ti-O layers along the hexagonal c-axis, whereas in the ideal lithium niobate structure each plane perpendicular to the c-axis has equal amount of Mg and Ti. Overall this improves the chances to form ferromagnetic compounds, see Fig. 23 which indicates that the only non-ferromagnetic LN structures are Nos 1 (paramagnetic) and 4 (ferrimagnetic). This is a feature which can be adjusted during atomic scale growth of the film: LN structures can ensure a good mixing of Mg and Ti cations and there are no pure Mg-O layers blocking the ferromagnetic coupling. A third technologically relevant characteristic feature is provided by the sample $Mg_{1.49}Ti_{1.03}O_3$, which is paramagnetic due to the Mg-O type layers. According to the XRD measurements, the 3b site is nearly completely occupied in $Mg_{1.49}Ti_{1.03}O_3$, corresponding to the atom 6 in Table 6. The sample structure is similar to the structure I4, in which Ti-O layers are predicted to be ferromagnetic. The diamagnetic Mg-O layers intervene the Ti-O layers and prevent the ferromagnetic coupling between the Ti-O layers. In contrast, by mixing Ti in each layer, e.g., by filling the 3a and/or 3b sites is a route to introduce net magnetization, see Fig. 10. Deliberately growing alternating Mg-O layers between the Ti-O layers is a route to grow paramagnetic insulating layers, which find technological applications. On the contrary, to ensure ferromagnetism the growth parameters are adjusted so that mixing of Ti and Mg in each layer is ensured. Atomic scale depositions suit well for this purpose.

In contrast, both $Mg^{2+}Ti^{4+}O_3$ ilmenite and $Mg^{2+}Ti^{4+}O_3$ lithium niobate structures are predicted to be paramagnetic. The first is confirmed by the experiments, and illustrates the crucial role of cations distribution and cation valence.

Example 11: Multilayer structures consisted from paramagnetic and ferromagnetic $A_{1+nx}T_{1-x}O_3$ films, wherein A = Mg and T = Ti.

Example 10 shows that Mg and Ti at.% can significantly differ in thin films. By adjusting Ti-content (1-x) to a value 0.95<1-x<1.05 and Mg-content (1+nx) to a value 0.95<1+nx<1.05, or alternatively adjusting Ti- content (1-x) to a value 0.95<1-x<1.05 and Mg-content (1+nx) to a value 1.45<1+nx<1.55, a room-temperature paramagnetic electrically insulating layer can be formed. By excluding the aforementioned composition values and adjusting Ti-content and Mg-content to be within the grey area limited by four lines in Fig. 24, a ferro- or ferrimagnetic layer can be formed. In Fig. 24 L1 is a limit line obtained from the condition that all octahedra are filled. By controlling the composition during the deposition process multilayer structures with desired number and order of paramagnetic and ferromagnetic layers can be formed. Both controlled cation distribution in each layer and filling of octahedra vacancies are necessary and cannot be achieved by bulk processing techniques. Bulk processing, as prior art 7 and 8 show, result in the ilmenite structure.

Example 12: $(Ni,Co)_3O_3$ thin film on GaN/Si(111) substrate

Figure 25 shows $(Ni,Co)_3O_3$ thin film deposited on GaN/Si(111) substrate. Film was grown by shooting 250 pulses on $NiCoO_4$ target, $p(O_2)$ = 1.3 Pa, in-situ heating temperature was 967 K and laser beam fluence 3.1 $Jcm^{-2}$. The thin film has c-axis perpendicular to the substrate plane.

Example 13: Formation of metallic films by reducing $(Ni,Co)_3O_3$ and $(Ni,Co)TiO_3$ films

Figure 26 shows the XRD patterns of the $(Ni,Co)_3O_3$ and $(Ni,Co)TiO_3$ thin films before and after annealing in 4 volume-% $H_2$ + 96 volume-% Ar-gas atmosphere at 573 K and 873 K, respectively. Thin films, grown on C-plane $Al_2O_3$ substrates, were inserted into a chamber in which gas flow and temperature were controlled.

Reduction was in-situ monitored by observing the film color and measuring Raman spectra. A reducing temperature $T_{red}$ is defined as a temperature in which onset of film reduction is recorded. An onset of reduction in $(Ni,Co)TiO_3$ films occurred after keeping the thin film approximately 20 minutes at $T_{red}$ = 873 K, with no signs of reduction at lower temperatures. Reduction in $(Ni,Co)TiO_3$ thin film was interrupted by cooling when approximately half of the film area was reduced. $(Ni,Co)_3O_3$ thin film was reduced at significantly lower temperature, $T_{red}$ = 573 K. At this temperature, the whole $(Ni,Co)_3O_3$ thin film was reduced into a dark color, shining metallic film in less than 20 minutes. This is seen in XRD pattern, shown in Fig. 26, as a loss of the 006 reflection characteristic to the ATO structure: only the 111 reflection at two-theta value 44.5°, corresponding to the (Ni,Co) face centered cubic structure, is seen. The orientation of the (Ni,Co) metal layer is thus preserved when oxygen are removed. The specific resistance of the film was approximately 1Ωcm. As XRD patterns show, the metallic phase was absent before the reducing treatment. The results indicate that an electrode patterning on NC films in 4 volume-% $H_2$ + 96 volume-% Ar gas atmosphere can be manufactured by, for instance, laser, electron or ion beam. As an example, focused laser beam locally heats the area within the spot, and the substrate temperature and laser beam power can be adjusted so that reduction occurs only in a desired region. In depth direction reduction can be inhibited by growing the NC film to be patterned on a $(Ni,Co)TiO_3$ thin film, which is reduced at significantly higher temperature. Metallic phase is not limited to the face centered cubic structure, but also other structural variants, such as NisTi type may be formed. When referring to these structures, it is understood that Ni and Ti sites can be occupied by Ni, Co, and Ti. This largely depends on the cations present and their distribution in the oxide film. Reduction temperatures are too low for cation rearrangements. The advantages of reduction-based patterning are the simple processing, good interfacial matching between the magnetic and electrode layers, and the formation of electrodes within electrically resisting layers. The formation of terminals within insulating layer diminishes cross-talk between the terminals. If required, a capping layer from the ATO material, including electrically insulating non-magnetic layers suitable for diminishing crosstalk due to the capacitive and inductive coupling, can be grown on top of the electrode layers. The preserved orientation of the metal layer facilitates oriented growth of the ATO layer. An example of an electrode patterning is illustrated in Fig. 27.

## Industrial applicability

Tunable radio-frequency devices, such as phase shifters, bandpass filters, delay lines in which the technical property is adjusted by an applied electric field.

Devices based on the tuning of ferromagnetic resonance frequency.
Spintronic devices, such as spin filters, spin-FET and spin-MOSFET.
Logical devices, such as NOT, XOR, NAND and XNOR gates.
Magnetic memory cells.
Sensors.
Magnetic field sensors.

Magnetic tunneling junction based applications requiring thin (few nm thick) films which are electrically insulating and ferromagnetic at room-temperature. Magneto-optical devices requiring the processing of electromagnetic waves in the microwave region between 1 Hz and few THz. Examples include isolators, gyrators, phase shifters, and circulators.
Magneto-optic memory devices in which the memory state is recorded as a different magnetic state and read optically. Optical reading can, for example, be based on the Faraday Effect or magneto-optic Kerr Effect.
Devices based on insulating ferromagnetic layers deposited on structurally similar topological insulator layers, such as $Bi_2Te_3$, $Bi_2Se_3$ and $TlBiSe_2$ and $TlBiTe_2$, in which the ferromagnetic layers eliminates the time-reversal symmetry.

## Citation list

Non-patent literature

[1] The International Technology Roadmap for Semiconductors 2.0.2015 Edition, Executive summary.
[2] S. Manipatruni, D. E. Nikonov and I. A. Young. Material targets for scaling all-spin logic. Phys. Rev. Appl., 014002, vol. 5 (2016).
[3] F. Laermer and A. Urban. Milestones in deep reactive ion etching. Tansducers ' 05, Digest of Technical Papers, 1118, vols 1 and 2, (2005).
[4] N. Drebov, A. Martinez-Limia, L. Kunz, A. Gola, T. Shigematsu, T. Eckl, P. Gumbsch and C. Elsässer. Ab initio screening methodology applied to the search for new permanent magnetic materials. New Journal of Physics, 125023, vol. 15 (2013).
[5] V. Harris. Modern microwave ferrites. IEEE Transactions on magnetics, 1075, vol. 48, 1075 (2012).
[6] M. M. Schieber. Experimental Magnetochemistry: Nonmetallic Magnetic Materials. North-Holland Publishing Company, Amsterdam (1967).
[7] Y. Fujioka, J. Frantti, et al. Itinerant-Electron Ferromagnetism in a Titanium-Rich Magnesium Titanate Ilmenite Solid Solution. J. Phys. Chem. C., vol. 115, 1457 (2011).
[8] Y. Fujioka, J. Frantti, et al. Ferromagnetism in MgTiO3-Ti2O3 solid solutions, Materials Science Forum Vol. 700, 23 (2012).
[9] Y. Fujioka, J. Frantti, C.M. Rouleau, A. Puretzky, H.M. Meyer. Vacancy filled nickel-cobalt-titanate thin films. Phys. Status Solidi B. vol. 254, 1600799 (2017).
[10] K. W. Kolasinski. Surface Science: Foundations of catalysis and nanoscience. Second Edition. John Wiley & Sons, Ltd., Chippenham, Wiltshire (2008).
[11] K. Lee and S. H. Kang. Control of switching current asymmetry by magnetostatic field in MgO-based magnetic tunnel junctions. IEEE Electronic Device Lett. 1353, vol. 30 (2009).
[12] N. I. Kourov, V. V. Marchenkov, A. V. Korolev, K. A. Belozerova, and H. W. Weber. High-field magnetization of Heusler Alloys Fe2XY (X=Ti,V,Cr,Mn,Fe,Co,Ni; Y=Al,Si). Physics of the Solid State. 1500, vol. 58 (2016).
[13] F. Dahmane, B. Doumi, Y. Mogulkoc, A. Tadjer, D. Prakash, K. D. Verma, D. Varshney, M. A. Ghebouli, S. Bin Omran, and R. Khenata. Investigations of the structural, electronic, magnetic, and half-metallic behavior of Co2MnZ (Z=Al,Ge,Si,Ga) full-Heusler compounds. J. Supercond. Nov. Magn. 809, vol. 29 (2016).
[14] T. Miyajima et al. Transmission electron microscopy study on the crystallization and boron distribution of CoFeB/MgO/CoFeB magnetic tunnel junctions with various capping layers. Appl. Phys. Lett. 122501, vol. 94 (2009).
[15] E. C. Mattson, D. J. Michalak, J. F. Veyan and Y. J. Chabal. Cobalt and iron segregation and nitrite formation plasma treatment of CoFeB surfaces. J. Chem. Phys. 052805, vol. 146 (2017).
[16] A. Vedyayev, D. Bagrets, A. Bagrets and B. Dieny. Resonant spin-dependent tunneling in spin-valve junctions in the presence of paramagnetic impurities. Phys. Rev. B. 064429, vol. 63 (2001).

[17] F. J. Morin. Magnetic Susceptibility of aFe203 and aFe203 with Added Titanium. Phys. Rev. 819, vol. 78 (1950).
[18] Y. Ishikawa and S. Akimoto. Magnetic properties of the FeTiO3-Fe2O3 solid-solution series. Journal of the Physical Society of Japan, 1083, vol. 12 (1957).
[19] Z. Chen and V. G. Harris. Ferrite film growth on semiconductor substrates towards microwave and millimeter wave integrated circuits. Journal of Applied Physics 112, 081101 (2012).
[20] R. E. Newnham. Properties of Materials: Anisotropy, Symmetry, Structure. Oxford University Press, Inc., New York (2005).
[21] W. Hayes and R. Loudon. Scattering of Light by Crystals. Dover Publications, Inc., Mineola, New York (2004).
[22] B. Lenk, H. Ulrichs, F. Garbs and M. Münzenberg. The building block of magnonics. Arxiv:1101.0479v2.
[23] B. Obry, P. Pirro, T. Brächer, A. V. Chumak, J. Osten, F. Ciubotaru, A. A. Serga, J. Fassbender, and B. Hillebrands. A micro-structured ion-implanted magnonic crystal. App. Phys. Lett. 202403, vol. 102 (2013).
[24] C. G. Sykes, J. D. Adam and J. H. Collins. Magnetostatic wave propagation in a periodic structure. App. Phys. Lett. 388, vol. 29 (1976).
[25] Y. V. Gulyaev, S. A. Nikitov, L. V. Zhivotovskii, A. A. Klimov, Ph. Tailhades, L. Presmanes, C. Bonningue, C. S. Tsai, S. L. Vysotskii, and Y. A. Filimonov. Ferromagnetic films with magnon bandgap periodic structures: magnon crystals. JETP Lett. 567, vol. 77 (2003).
[26] K-S. Lee, D-S. Soo and S-K. Kim. Physical origin and generic control of magnonic band gaps of dipole-exchange spin waves in width-modulated nanostrip waveguides. Phys. Rev. Lett. 127202, vol. 102 (2009).
[27] B. K. Kuanr, I. R. Harward, R. T. Deiotte, R. E. Camley and Z. Celinski. Magnetically tunable micro-strip band-stop filter: Design optimization and characterization. J. Appl. Phys. 10Q103, vol. 97 (2005).
[28] A. V. Chumak, A. A. Serga and B. Hillebrands. Magnonic crystals for data processing. J. Phys. D: Appl. Phys. 244001, vol. 50 (2017).
[29] T. Schneider, A. A. Serga, B. Leven, B. Hillebrands, R. L. Stamps, and M. P. Kostylev. Realization of spin-wave logic gates. Appl. Phys. Lett. 022505, vol. 92 (2008).
[30] A. Khitun. Multi-frequency magnonic logic circuits for parallel data processing. J. Appl. Phys. 054307, vol. 111 (2012).
[31] P. J. Brown, A. G. Fox, E. N. Maslen, M. A. O'Keefe and B. T. M. Willis. Intensity of diffracted intensities, in International Tables for Crystallography, Volume C (Ed. E. Prince), Kluwer Academic Publishers, Dordrecht/Boston/London (2004).
[33] J. Frantti, Y. Fujioka, J. Zhang, J. Zhu, S. C. Vogel, and Y. Zhao. Microstrain in tetragonal lead-zirconate-titanate: The effect of pressure on the ionic displacements. Review of Scientific Instruments 85, 083901 (2014).
[34] J. Frantti and Y. Fujioka. Computational modeling of x-ray scattering intensities during domain reversal in lead-zirconate-titanate nanosize clusters. Materials Today: Proceedings 3, 92-98 (2016).
[35] J. Frantti and Y. Fujioka. X-ray and neutron scattering on disordered nanosize clusters: a case study of lead-zirconate-titanate solid solutions. Annalen der Physics. 527, 219-237 (2015).

Patent literature

[32] J. Frantti and Y. Fujioka. Method and system for analysing data obtained using scattering measurements from disordered material. EPO 2464962.

## Claims

**1.** A thin film material having the empirical formula $A_{1+nx}T^{z}_{1-x}O_3$,

wherein A is selected from the group consisting of Mg and Mn
wherein Tis Ti,
wherein

$$-1 < x < 1,$$

wherein *z* is the average oxidation state of *T,* calculated as the weighted average of the *T* cation oxidation states based on the total amount of *T* in the composition in atomic percentage, and
wherein

$$n = (4 - z + zx)/(2x),$$

**characterized in that** the structure is described in terms of three axes, *a, b* and *c* and three angles, $\alpha$ between *b* and *c* axes, $\beta$ between *a* and *c* axes, and $\gamma$ between *a* and *b* axes,
wherein 0.475 nm (4.75 Å) < *a* < 0.55 nm (5.5 Å), 0.475 nm (4.75 Å) < *b* < 0.55 nm (5.5 Å), and 1.25 nm (12.5 Å) < *c*<1.55 nm (15.5 Å), and wherein 85° < $\alpha$ < 95°, 85° < $\beta$ < 95°, and 115° < $\gamma$ < 125°,
wherein the material comprises at least two stacked layers, wherein each layer comprises a continuous hexagonally arranged oxygen octahedra layer; with each octahedron sharing a face with the octahedron above and/or below along the stacking direction, wherein in the basal plane each oxygen octahedron shares an edge with each of the six neighboring octahedron of the same basal plane, and wherein each oxygen octahedron has six corner sharing octahedra above and/or six corner sharing octahedra below,
wherein the octahedra are vacant or contain an A-cation or a T-cation, wherein at least a fraction of the octahedra are filled by a cation, wherein the octahedra filling fraction is $z_v$ = [2 + (n-1)x]/3.

**2.** A thin film material having the empirical formula $A_{1+nx}T^{z}_{1-x}O_3$,

wherein *A* is Ni and Co,
wherein *T* is selected from the group consisting of V and Cr,
wherein

$$-1 < x < 1,$$

wherein *z* is the average oxidation state of *T,* calculated as the weighted average of the *T* cation oxidation states based on the total amount of *T* in the composition in atomic percentage, and
wherein

$$n = (4 - z + zx)/(2x),$$

**characterized in that** the structure is described in terms of three axes, *a*, *b* and *c* and three angles, $\alpha$ between *b* and *c* axes, $\beta$ between *a* and *c* axes, and $\gamma$ between *a* and *b* axes,
wherein 0.475 nm (4.75 Å) < *a* < 0.55 nm (5.5 Å), 0.475 nm (4.75 Å) < *b* < 0.55 nm (5.5 Å), and 1.25 nm (12.5 Å) < *c* <1.55 nm (15.5 Å), and wherein 85° < $\alpha$ < 95°, 85° < $\beta$ < 95°, and 115° < $\gamma$ < 125°,
wherein the material comprises at least two stacked layers, wherein each layer comprises a continuous hexagonally arranged oxygen octahedra layer; with each octahedron sharing a face with the octahedron above and/or below along the stacking direction, wherein in the basal plane each oxygen octahedron shares an edge with each of the six neighboring octahedron of the same basal plane, and wherein each oxygen octahedron has six corner sharing octahedra above and/or six corner sharing octahedra below,
wherein the octahedra are vacant or contain an A-cation or a T-cation, wherein at least a fraction of the octahedra are filled by a cation, wherein the octahedra filling fraction is $z_v$ = [2 + (n-1)x]/3.

**3.** A thin film material having the empirical formula $A_{1+nx}T^{z}_{1-x}O_3$,

wherein *A* is Mg,
wherein *T* is selected from the group consisting of Cr, V and Mn,
wherein

$$-1 < x < 1,$$

wherein *z* is the average oxidation state of *T,* calculated as the weighted average of the *T* cation oxidation states based on the total amount of *T* in the composition in atomic percentage, and
wherein

$$n = (4 - z + zx)/(2x),$$

**characterized in that** the structure is described in terms of three axes, *a*, *b* and *c* and three angles, $\alpha$ between *b and* c axes, $\beta$ between a and c axes, and $\gamma$ between a and *b* axes,
wherein 0.475 nm (4.75 Å) < *a* < 0.55 nm (5.5 Å), 0.475 nm (4.75 Å) < *b* < 0.55 nm (5.5 Å), and 1.25 nm (12.5 Å) < c<1.55 nm (15.5 Å), and wherein 85° < $\alpha$ < 95°, 85° < $\beta$ < 95°, and 115° < $\gamma$ < 125°,
wherein the material comprises at least two stacked layers, wherein each layer comprises a continuous hexagonally arranged oxygen octahedra layer; with each octahedron sharing a face with the octahedron above and/or below along the stacking direction, wherein in the basal plane each oxygen octahedron shares an edge with each of the six neighboring octahedron of the same basal plane, and wherein each oxygen octahedron has six corner sharing octahedra above and/or six corner sharing octahedra below,
wherein the octahedra are vacant or contain an A-cation or a T-cation, wherein at least a fraction of the octahedra are filled by a cation, wherein the octahedra filling fraction is $z_v = [2 + (n-1)x]/3$.

**4.** The thin film material according to any one of claims 1 to 3, wherein in a Cartesian coordinate system defined by an abscissa (1+nx) and an ordinate (1-x) a pair of the values 1+nx and 1-x define a point ((1+nx);(1-x)) within an area defined by the lines

$$1-x = -(1+nx)+3,$$

$$1-x = -0.500(1+nx)+1.500,$$

and

$$1-x = 1.561(1+nx)+0.44,$$

and the intersections of said lines.

**5.** The thin film material according to any one of claims 1 to 4, wherein

$$2.7+ < z < 4+.$$

**6.** The thin film material according to any one of claims 1 to 5, wherein the atomic sites within the unit cell are described in terms of the following fractional coordinates:

| Site i | Atom | Fractional coordinates | | |
|---|---|---|---|---|
| 1 | A,T | $-0.05<x_1<0.05$ | $-0.05<y_1<0.05$ | $0.3<z_1<0.4$ |
| 2 | A,T | $-0.05<x_2<0.05$ | $-0.05<y_2<0.05$ | $-0.4<z_2<-0.3$ |
| 3 | A,T | $-0.05<x_3<0.05$ | $-0.05<y_3<0.05$ | $0.1<z_3<0.2$ |
| 4 | A,T | $-0.05<x_4<0.05$ | $-0.05<y_4<0.05$ | $-0.2<z_4<-0.1$ |
| 5 | A,T | $-0.05<x_5<0.05$ | $-0.05<y_5<0.05$ | $-0.05<z_5<0.05$ |
| 6 | A,T | $-0.05<x_6<0.05$ | $-0.05<y_6<0.05$ | $0.45<z_6<0.55$ |
| 7 | O | $0.25<x_7<0.35$ | $-0.05<y_7<0.05$ | $0.24<z_7<0.35$ |
| 8 | O | $-0.05<x_8<0.05$ | $0.25<y_8<0.35$ | $0.24<z_8<0.35$ |
| 9 | O | $-0.35<x_9<-0.25$ | $-0.35<y_9<-0.25$ | $0.24<z_9<0.35$ |
| 10 | O | $-0.35<x_{10}<-0.25$ | $-0.05<y_{10}<0.05$ | $-0.35<z_{10}<-0.24$ |
| 11 | O | $-0.05<x_{11}<0.05$ | $-0.35<y_{11}<-0.25$ | $-0.35<z_{11}<-0.24$ |
| 12 | O | $0.25<x_{12}<0.35$ | $0.25<y_{12}<0.35$ | $-0.35<z_{12}<-0.24$ |

vectors $v_1 = (\frac{1}{3}, \frac{2}{3}, \frac{2}{3})$ and $v_2 = (\frac{2}{3}, \frac{1}{3}, \frac{1}{3})$, and the lattice parameters,
wherein each position $r_i$ of a site i, wherein i = 1, 2, 3, 4, 5, 6, 7, 8, 9, 10, 11 or 12, is given by the formula $r_i = x_i a + y_i b + z_i c$ ,
wherein each position $r_i$ of a site i, wherein i = 13, 14, 15, 16, 17, 18, 19, 20, 21, 22, 23 or 24, is given by the formula $r_i + v_1$,
wherein each position $r_i$ of a site i, wherein i = 25, 26, 27, 28, 29, 30, 31, 32, 33, 34, 35 or 36, is given by the formula $r_i + v_2$, and
wherein the average occupancy of the A, T atom sites is of from 0.50 to 1.

**7.** The thin film material according to any one of claims 1 to 6, wherein the material comprises at least three layers, wherein each layer comprises a continuous hexagonally arranged oxygen octahedra layer; with each octahedron sharing a face with the octahedron above and/or below along the stacking direction, wherein in the basal plane each oxygen octahedron shares an edge with each of the six neighboring octahedron of the same basal plane, and wherein each oxygen octahedron has six corner sharing octahedra above and/or six corner sharing octahedra below.

**8.** A method of manufacturing a thin film comprising a substrate and a thin film material having the empirical formula $A_{1+nx} T^z_{1-x}O_3$ wherein A is selected from the group consisting of Mg and Mn, T is Ti, wherein $-1< x < 1$, wherein $z$ is the average oxidation state of $T$, calculated as the weighted average of the $T$ cation oxidation states based on the total amount of Tin the composition in atomic percentage, and wherein $n = (4- z+ zx)/(2x)$, the method comprising the steps:

(a) Providing a substrate, wherein the substrate preferably has a surface structure possessing similar periodicity as the desired $A_{1+nx}T^z_{1-x}O_3$ crystal plane structure, wherein the difference between the periodicities is preferably below 3 %;
(b) Providing at least one target comprising *A* and/or *T,* preferably as an oxide, more preferably a target for *A* and a target for *T*;
(c) Deposition of *A* and *T,* or atom clusters containing at least one of the atoms from the group consisting of *A, T* and O, on the substrate, wherein the deposition parameters are adjusted so that $-1 < x < 1$ and $-16 < n < 32$ on the substrate, wherein the in-situ temperature of the substrate is kept in the range of from 673 to 933 K, and wherein the oxygen pressure is kept in the range of from greater than 0 to 2.7 Pa, preferably the oxygen pressure is kept at 1.3 Pa or lower,
for obtaining a layer of the thin film material;
(d) Cooling of the substrate obtained from c, wherein the oxygen pressure is kept in the range of from greater than 0 to 2.7 Pa, preferably the oxygen pressure is kept at 1.3 Pa or lower,
for obtaining a thin film,

wherein (c) comprises varying the A and/or T cation content in at least one spatial direction during deposition.

**9.** A method of manufacturing a thin film comprising a substrate and a thin film material having the empirical formula $A_{1+nx} T^z_{1-x}O_3$ wherein A is Ni and Co, T is selected from the group consisting of V and Cr, wherein $-1 < x < 1$, wherein $z$ is the average oxidation state of $T,$ calculated as the weighted average of the $T$ cation oxidation states based on the total amount of Tin the composition in atomic percentage, and wherein $n = (4- z+ zx)/(2x)$, the method comprising the steps:

(a) Providing a substrate, wherein the substrate preferably has a surface structure possessing similar periodicity as the desired $A_{1+nx}T^z_{1-x}O_3$ crystal plane structure, wherein the difference between the periodicities is preferably below 3 %;
(b) Providing at least one target comprising *A* and/or *T,* preferably as an oxide, more preferably a target for *A* and a target for *T*;
(c) Deposition of *A* and *T,* or atom clusters containing at least one of the atoms from the group consisting of *A, T* and O, on the substrate, wherein the deposition parameters are adjusted so that $-1 < x < 1$ and $-16 < n < 32$ on the substrate, wherein the in-situ temperature of the substrate is kept in the range of from 673 to 933 K, and wherein the oxygen pressure is kept in the range of from greater than 0 to 2.7 Pa, preferably the oxygen pressure is kept at 1.3 Pa or lower,
for obtaining a layer of the thin film material;

(d) Cooling of the substrate obtained from c, wherein the oxygen pressure is kept in the range of from greater than 0 to 2.7 Pa, preferably the oxygen pressure is kept at 1.3 Pa or lower,
for obtaining a thin film,

wherein (c) comprises varying the A and/or T cation content in at least one spatial direction during deposition.

**10.** A method of manufacturing a thin film comprising a substrate and a thin film material having the empirical formula $A_{1+nx}\,T^{z}_{1-x}O_3$ wherein A is Mg, T is selected from the group consisting of Cr, V and Mn, wherein $-1 < x < 1$, wherein $z$ is the average oxidation state of $T$, calculated as the weighted average of the $T$ cation oxidation states based on the total amount of $T$ in the composition in atomic percentage, and wherein $n = (4 - z + zx)/(2x)$, the method comprising the steps:

(a) Providing a substrate, wherein the substrate preferably has a surface structure possessing similar periodicity as the desired $A_{1+nx}T^{z}_{1-x}O_3$ crystal plane structure, wherein the difference between the periodicities is preferably below 3 %;
(b) Providing at least one target comprising *A* and/or *T,* preferably as an oxide, more preferably a target for *A* and a target for *T*;
(c) Deposition of *A* and *T,* or atom clusters containing at least one of the atoms from the group consisting of *A, T* and O, on the substrate, wherein the deposition parameters are adjusted so that $-1 < x < 1$ and $-16 < n < 32$ on the substrate, wherein the in-situ temperature of the substrate is kept in the range of from 673 to 933 K, and wherein the oxygen pressure is kept in the range of from greater than 0 to 2.7 Pa, preferably the oxygen pressure is kept at 1.3 Pa or lower,
for obtaining a layer of the thin film material;
(d) Cooling of the substrate obtained from c, wherein the oxygen pressure is kept in the range of from greater than 0 to 2.7 Pa, preferably the oxygen pressure is kept at 1.3 Pa or lower,
for obtaining a thin film,

wherein (c) comprises varying the A and/or T cation content in at least one spatial direction during deposition.

**11.** The method of claim 8, wherein the target for Tis selected from the group consisting of Ti, $NiTiO_3$, $CoTiO_3$, TiO, $Ti_2O_3$, and mixtures of two or more thereof, wherein the target for Tis preferably selected from the group consisting of $NiTiO_3$, $CoTiO_3$, and mixtures of two or more thereof.

**12.** The method of claim 9, wherein the target for *A* is selected from the group consisting of alloys of Ni and Co, $NiCoO_4$, $NiCo_2O_4$, $Co_xNi_{1-x}O_3$ where $0<x<1$, and mixtures of two or more thereof, wherein the target for *A* is preferably $NiCoO_4$.

**13.** The method according to any one of claims 8 to 12, wherein (c) is carried out by sputtering, PLD, EBPVD, CVD, or liquid phase epitaxial technique.

**14.** The method according to any one of claims 8 to 13,

wherein in (a) $LiNbO_3$ or $LiTaO_3$ is provided as substrate, or
wherein in (a) a substrate is provided carrying $LiNbO_3$ or $LiTaO_3$ as a seed layer,
wherein (b) further comprises providing a target for $LiNbO_3$ or $LiTaO_3$, and
wherein (c) comprises

(c.1) Deposition of A and T , or atom clusters containing at least one of the atoms from the group consisting of A, T and O, on the substrate, wherein the deposition parameters are adjusted so that $-1 < x < 1$ and $-16 < n < 32$ on the substrate and wherein the in-situ temperature of the substrate is kept in the range of from 673 to 933 K, and wherein the oxygen pressure is kept in the range of from greater than 0 to 2.7 Pa, preferably the oxygen pressure is kept at 1.3 Pa or lower, for obtaining a layer of the thin film material; and
(c.2) Deposition of $LiNbO_3$ or $LiTaO_3$, for obtaining a layer of $LiNbO_3$ or $LiTaO_3$.

**15.** The method according to any one of claims 8 to 14, wherein the ratio of the concentration of A and the concentration of T concentrations is adjusted as a function of time.

**16.** A thin film comprising a thin film material according to any one of claims 1 to 7.

**17.** Use of a thin film material according to any one of claims 1 to 7 or of a thin film according to claim 16 in an electrical device, preferably in an electrical device comprising an electrically insulating thin film material, wherein the thickness of the thin film material is preferably in the range of from 0.5 nanometers to 10 micrometers.

**18.** A method of manufacturing a multilayer device, wherein at least one layer comprises a thin film material according to any one of claims 1 to 7, **characterized in that**

the interfaces between structurally similar layers have lattice mismatch *e* = (*b*-*a*)/*a* below the dislocation formation limit, where *a* and *b* are the corresponding octahedra edge lengths in the adjacent layers, respectively, wherein e is preferably smaller than 0.01; and
wherein a composition gradient is introduced in the vicinity of the interface to lessen e below dislocation formation limit.

**Patentansprüche**

**1.** Dünnschichtmaterial mit der Summenformel $A_{1+nx}T^{z}{}_{1-x}O_3$,

wobei A aus der Gruppe ausgewählt ist, bestehend aus Mg und Mn
wobei T Ti ist,
wobei

$$-1 < x < 1$$

ist,
wobei z die durchschnittliche Oxidationsstufe von T ist, die als der gewichtete Durchschnitt der Oxidationsstufen der T-Kationen auf der Grundlage der Gesamtmenge an T in der Zusammensetzung in Atomprozent berechnet wird, und
wobei

$$n = (4 - z + zx)/(2x)$$

ist,
**dadurch gekennzeichnet, dass** die Struktur mit Bezug auf drei Achsen, a, b und c, und drei Winkel, α zwischen den Achsen b und c, β zwischen den Achsen a und c und γ zwischen den Achsen a und b, beschrieben ist, wobei 0,475 nm (4,75 Ä) < a < 0,55 nm (5,5 Å), 0,475 nm (4,75 Ä) < b < 0,55 nm (5,5 Ä) und 1,25 nm (12,5 Ä) < c < 1,55 nm (15,5 Ä) ist und wobei 85° < α < 95°, 85° < β < 95° und 115° < γ < 125° ist,
wobei das Material mindestens zwei gestapelte Schichten umfasst, wobei jede Schicht eine durchgehende hexagonal angeordnete Sauerstoff-Oktaederschicht umfasst; wobei jedes Oktaeder eine Fläche mit dem Oktaeder darüber und/oder darunter entlang der Stapelrichtung teilt, wobei in der Grundebene jedes Sauerstoff-Oktaeder eine Kante mit jedem der sechs benachbarten Oktaeder der gleichen Grundebene teilt und wobei jedes Sauerstoff-Oktaeder sechs Oktaeder mit gemeinsamen Ecken darüber und/oder sechs Oktaeder mit gemeinsamen Ecken darunter aufweist,
wobei die Oktaeder vakant sind oder ein A-Kation oder ein T-Kation enthalten,
wobei mindestens ein Anteil der Oktaeder mit einem Kation gefüllt ist, wobei der Füllungsanteil der Oktaeder

$$z_v = [2 + (n - 1)x]/3$$

ist.

**2.** Dünnschichtmaterial mit der Summenformel $A_{1+nx}T^{z}{}_{1-x}O_3$,

wobei A Ni und Co ist,
wobei T aus der Gruppe ausgewählt ist, bestehend aus V und Cr,
wobei

$$-1 < x < 1$$

ist,
wobei z die durchschnittliche Oxidationsstufe von T ist, die als der gewichtete Durchschnitt der Oxidationsstufen der T-Kationen auf der Grundlage der Gesamtmenge an T in der Zusammensetzung in Atomprozent berechnet wird, und
wobei

$$n = (4 - z + zx)/(2x)$$

ist,
**dadurch gekennzeichnet, dass** die Struktur mit Bezug auf drei Achsen, a, b und c, und drei Winkel, $\alpha$ zwischen den Achsen b und c, $\beta$ zwischen den Achsen a und c und $\gamma$ zwischen den Achsen a und b, beschrieben ist, wobei 0,475 nm (4,75 Ä) < a < 0,55 nm (5,5 Å), 0,475 nm (4,75 Ä) < b < 0,55 nm (5,5 Ä) und 1,25 nm (12,5 Ä) < c < 1,55 nm (15,5 Ä) ist und wobei 85° < $\alpha$ < 95°, 85° < $\beta$ < 95° und 115° < $\gamma$ < 125° ist,
wobei das Material mindestens zwei gestapelte Schichten umfasst, wobei jede Schicht eine durchgehende hexagonal angeordnete Sauerstoff-Oktaederschicht umfasst; wobei jedes Oktaeder eine Fläche mit dem Oktaeder darüber und/oder darunter entlang der Stapelrichtung teilt, wobei in der Grundebene jedes Sauerstoff-Oktaeder eine Kante mit jedem der sechs benachbarten Oktaeder der gleichen Grundebene teilt und wobei jedes Sauerstoff-Oktaeder sechs Oktaeder mit gemeinsamen Ecken darüber und/oder sechs Oktaeder mit gemeinsamen Ecken darunter aufweist,
wobei die Oktaeder vakant sind oder ein A-Kation oder ein T-Kation enthalten,
wobei mindestens ein Anteil der Oktaeder mit einem Kation gefüllt ist, wobei der Füllungsanteil der Oktaeder

$$z_v = [2 + (n - 1)x]/3$$

ist.

**3.** Dünnschichtmaterial mit der Summenformel $A_{1+nx}T^{z}_{1-x}O_3$, wobei A Mg ist,

wobei T aus der Gruppe ausgewählt ist, bestehend aus Cr, V und Mn,
wobei

$$-1 < x < 1$$

ist,
wobei z die durchschnittliche Oxidationsstufe von T ist, die als der gewichtete Durchschnitt der Oxidationsstufen der T-Kationen auf der Grundlage der Gesamtmenge an T in der Zusammensetzung in Atomprozent berechnet wird, und
wobei

$$n = (4 - z + zx)/(2x)$$

ist,
**dadurch gekennzeichnet, dass** die Struktur mit Bezug auf drei Achsen, a, b und c, und drei Winkel, $\alpha$ zwischen den Achsen b und c, $\beta$ zwischen den Achsen a und c und $\gamma$ zwischen den Achsen a und b, beschrieben ist, wobei 0,475 nm (4,75 Ä) < a < 0,55 nm (5,5 Å), 0,475 nm (4,75 Ä) < b < 0,55 nm (5,5 Ä) und 1,25 nm (12,5 Ä) < c < 1,55 nm (15,5 Ä) ist und wobei 85° < $\alpha$ < 95°, 85° < $\beta$ < 95° und 115° < $\gamma$ < 125° ist,
wobei das Material mindestens zwei gestapelte Schichten umfasst, wobei jede Schicht eine durchgehende hexagonal angeordnete Sauerstoff-Oktaederschicht umfasst; wobei jedes Oktaeder eine Fläche mit dem Oktaeder darüber und/oder darunter entlang der Stapelrichtung teilt, wobei in der Grundebene jedes Sauerstoff-Oktaeder eine Kante mit jedem der sechs benachbarten Oktaeder der gleichen Grundebene teilt und wobei jedes Sauerstoff-Oktaeder sechs Oktaeder mit gemeinsamen Ecken darüber und/oder sechs Oktaeder mit gemeinsamen Ecken darunter aufweist,
wobei die Oktaeder vakant sind oder ein A-Kation oder ein T-Kation enthalten,
wobei mindestens ein Anteil der Oktaeder mit einem Kation gefüllt ist, wobei der Füllungsanteil der Oktaeder

$$z_V = [2 + (n - 1)x]/3$$

ist.

**4.** Dünnschichtmaterial nach einem der Ansprüche 1 bis 3, wobei in einem kartesischen Koordinatensystem, das durch eine Abszisse (1°+°nx) und eine Ordinate (1°-°x) definiert ist, ein Wertepaar 1°+°nx und 1°-°x einen Punkt ((1°+°nx);(1°-°x)) in einer Fläche definiert, die durch die folgenden Linien

$$1 - x = -(1 + nx) + 3,$$

$$1 - x = -0,500(1 + nx) + 1,500$$

und

$$1 - x = 1,561(1 + nx) + 0,44$$

und die Schnittpunkte dieser Linien definiert ist.

**5.** Dünnschichtmaterial nach einem der Ansprüche 1 bis 4, wobei 2,7+ < z < 4+ ist.

**6.** Dünnschichtmaterial nach einem der Ansprüche 1 bis 5, wobei die Atomorte innerhalb der Einheitszelle in Bezug auf die folgenden fraktionellen Koordinaten:

| Ort i | Atom | Fraktionelle Koordinaten | | |
|---|---|---|---|---|
| 1 | A,T | $-0,05 < x_1 < 0,05$ | $-0,05 < y_1 < 0,05$ | $0,3 < z_1 < 0,4$ |
| 2 | A,T | $-0,05 < x_2 < 0,05$ | $-0,05 < y_2 < 0,05$ | $-0,4 < z_2 < -0,3$ |
| 3 | A,T | $-0,05 < x_3 < 0,05$ | $-0,05 < y_3 < 0,05$ | $0,1 < z_3 < 0,2$ |
| 4 | A,T | $-0,05 < x_4 < 0,05$ | $-0,05 < y_4 < 0,05$ | $-0,2 < z_4 < -0,1$ |
| 5 | A,T | $-0,05 < x_5 < 0,05$ | $-0,05 < y_5 < 0,05$ | $-0,05 < z_5 < 0,05$ |
| 6 | A,T | $-0,05 < x_6 < 0,05$ | $-0,05 < y_6 < 0,05$ | $0,45 < z_6 < 0,55$ |
| 7 | O | $0,25 < x_7 < 0,35$ | $-0,05 < y_7 < 0,05$ | $0,24 < z_7 < 0,35$ |
| 8 | O | $-0,05 < x_8 < 0,05$ | $0,25 < y_8 < 0,35$ | $0,24 < z_8 < 0,35$ |
| 9 | O | $-0,35<x_9<-0,25$ | $-0,35<y_9<-0,25$ | $0,24<z_9<0,35$ |
| 10 | O | $-0,35<x_{10}<-0,25$ | $-0, 05<y_{10}<0,05$ | $-0, 35<z_{10}<-0,24$ |
| 11 | O | $-0,05<x_{11}<0,05$ | $-0, 35<y_{11}<-0,25$ | $-0, 35<z_{11}<-0,24$ |
| 12 | O | $0,25<x_{12}<0,35$ | $0,25<y_{12}<0,35$ | $-0, 35<z_{12}<-0, 24$ |

die Vektoren $v_1 = (\frac{1}{3}, \frac{2}{3}, \frac{2}{3})$ und $v_2 = (\frac{2}{3}, \frac{1}{3}, \frac{1}{3})$ und die Gitterparameter beschrieben sind,

wobei jede Position $r_i$ eines Ortes i, wobei i = 1, 2, 3, 4, 5, 6, 7, 8, 9, 10, 11 oder 12 ist, durch die Formel $r_i$ =

$x_i a$ + yib + $z_i c$ gegeben ist,
wobei jede Position $r_i$ eines Ortes i, wobei i = 13, 14, 15, 16, 17, 18, 19, 20, 21, 22, 23 oder 24 ist, durch die Formel $r_i + v_1$ gegeben ist,
wobei jede Position $r_i$ eines Ortes i, wobei i = 25, 26, 27, 28, 29, 30, 31, 32, 33, 34, 35 oder 36 ist, durch die Formel $r_i + v_2$ gegeben ist und
wobei die durchschnittliche Belegung der A-, T-Atomorte zwischen 0,50 und 1 beträgt.

**7.** Dünnschichtmaterial nach einem der Ansprüche 1 bis 6, wobei das Material mindestens drei Schichten umfasst, wobei jede Schicht eine durchgehende hexagonal angeordnete Sauerstoff-Oktaederschicht umfasst; wobei jedes Oktaeder eine Fläche mit dem Oktaeder darüber und/oder darunter entlang der Stapelrichtung teilt, wobei in der Grundebene jedes Sauerstoff-Oktaeder eine Kante mit jedem der sechs benachbarten Oktaeder der gleichen Grundebene teilt und wobei jedes Sauerstoff-Oktaeder sechs Oktaeder mit gemeinsamen Ecken darüber und/oder sechs Oktaeder mit gemeinsamen Ecken darunter aufweist.

**8.** Verfahren zum Herstellen einer Dünnschicht, ein Substrat und ein Dünnschichtmaterial mit der Summenformel $A_{1+nx}T^z{}_{1-x}O_3$ umfassend, wobei A aus der Gruppe ausgewählt ist, bestehend aus Mg und Mn, T Ti ist, wobei -1 < x < 1 ist, wobei z die durchschnittliche Oxidationsstufe von T ist, die als der gewichtete Durchschnitt der Oxidationsstufen der T-Kationen auf der Grundlage der Gesamtmenge an T in der Zusammensetzung in Atomprozent berechnet wird, und wobei n = (4 - z + zx)/(2x) ist, das Verfahren die folgenden Schritte umfassend:

(a) Bereitstellen eines Substrats, wobei das Substrat vorzugsweise eine Oberflächenstruktur aufweist, die eine ähnliche Periodizität wie die erwünschte Kristallebenenstruktur $A_{1+nx}T^z{}_{1-x}O_3$ besitzt, wobei die Differenz zwischen den Periodizitäten vorzugsweise kleiner als 3°% ist;
(b) Bereitstellen mindestens eines Targets, das A und/oder T vorzugsweise als ein Oxid umfasst, besonders bevorzugt eines Targets für A und eines Targets für T;
(c) Abscheiden von A und T oder von Atomclustern, die mindestens eines der Atome aus der Gruppe enthalten, bestehend aus A, T und O, auf dem Substrat, wobei die Abscheidungsparameter so eingestellt sind, dass -1 < x < 1 und -16 < n < 32 auf dem Substrat sind, wobei die in-situ-Temperatur des Substrats im Bereich zwischen 673 und 933 K gehalten wird und wobei der Sauerstoff-Druck im Bereich zwischen 0 und 2,7 Pa gehalten wird, vorzugsweise der Sauerstoff-Druck bei 1,3 Pa oder weniger gehalten wird,
um eine Schicht des Dünnschichtmaterials zu erlangen;
(d) Kühlen des aus c erlangten Substrats, wobei der Sauerstoff-Druck im Bereich zwischen 0 und 2,7 Pa gehalten wird, vorzugsweise der Sauerstoff-Druck bei 1,3 Pa oder weniger gehalten wird,
um eine Dünnschicht zu erlangen,
wobei (c) Variieren des A- und/oder T-Kationengehalts in mindestens einer Raumrichtung während der Abscheidung umfasst.

**9.** Verfahren zum Herstellen einer Dünnschicht, ein Substrat und ein Dünnschichtmaterial mit der Summenformel $A_{1+nx}T^z{}_{1-x}O_3$ umfassend, wobei A Ni und Co ist, T aus der Gruppe ausgewählt ist, bestehend aus V und Cr, wobei -1 < x < 1 ist, wobei z die durchschnittliche Oxidationsstufe von T ist, die als der gewichtete Durchschnitt der Oxidationsstufen der T-Kationen auf der Grundlage der Gesamtmenge an T in der Zusammensetzung in Atomprozent berechnet wird, und wobei n = (4 - z + zx)/(2x) ist, das Verfahren die folgenden Schritte umfassend:

(a) Bereitstellen eines Substrats, wobei das Substrat vorzugsweise eine Oberflächenstruktur aufweist, die eine ähnliche Periodizität wie die erwünschte Kristallebenenstruktur $A_{1+nx}T^z{}_{1-x}O_3$ besitzt, wobei die Differenz zwischen den Periodizitäten vorzugsweise kleiner als 3°% ist;
(b) Bereitstellen mindestens eines Targets, das A und/oder T vorzugsweise als ein Oxid umfasst, besonders bevorzugt eines Targets für A und eines Targets für T;
(c) Abscheiden von A und T oder von Atomclustern, die mindestens eines der Atome aus der Gruppe enthalten, bestehend aus A, T und O, auf dem Substrat, wobei die Abscheidungsparameter so eingestellt sind, dass -1 < x < 1 und -16 < n < 32 auf dem Substrat sind, wobei die in-situ-Temperatur des Substrats im Bereich zwischen 673 und 933 K gehalten wird und wobei der Sauerstoff-Druck im Bereich zwischen 0 und 2,7 Pa gehalten wird, vorzugsweise der Sauerstoff-Druck bei 1,3 Pa oder weniger gehalten wird,
um eine Schicht des Dünnschichtmaterials zu erlangen;
(d) Kühlen des aus c erlangten Substrats, wobei der Sauerstoff-Druck im Bereich zwischen 0 und 2,7 Pa gehalten wird, vorzugsweise der Sauerstoff-Druck bei 1,3 Pa oder weniger gehalten wird,
um eine Dünnschicht zu erlangen,
wobei (c) Variieren des A- und/oder T-Kationengehalts in mindestens einer Raumrichtung während der Abscheidung umfasst.

**10.** Verfahren zum Herstellen einer Dünnschicht, ein Substrat und ein Dünnschichtmaterial mit der Summenformel $A_{1+nx}T^{z}_{1-x}O_3$ umfassend, wobei A Mg ist, T aus der Gruppe ausgewählt ist, bestehend aus Cr, V und Mn, wobei -1 < x < 1 ist, wobei z die durchschnittliche Oxidationsstufe von T ist, die als der gewichtete Durchschnitt der Oxidationsstufen der T-Kationen auf der Grundlage der Gesamtmenge an T in der Zusammensetzung in Atomprozent berechnet wird, und wobei n = (4 - z + zx)/(2x) ist, das Verfahren die folgenden Schritte umfassend:

(a) Bereitstellen eines Substrats, wobei das Substrat vorzugsweise eine Oberflächenstruktur aufweist, die eine ähnliche Periodizität wie die erwünschte Kristallebenenstruktur $A_{1+nx}T^{z}_{1-x}O_3$ besitzt, wobei die Differenz zwischen den Periodizitäten vorzugsweise kleiner als 3°% ist;
(b) Bereitstellen mindestens eines Targets, das A und/oder T vorzugsweise als ein Oxid umfasst, besonders bevorzugt eines Targets für A und eines Targets für T,
(c) Abscheiden von A und T oder von Atomclustern, die mindestens eines der Atome aus der Gruppe enthalten, bestehend aus A, T und O, auf dem Substrat, wobei die Abscheidungsparameter so eingestellt sind, dass -1 < x < 1 und -16 < n < 32 auf dem Substrat sind, wobei die in-situ-Temperatur des Substrats im Bereich zwischen 673 und 933 K gehalten wird und wobei der Sauerstoff-Druck im Bereich zwischen 0 und 2,7 Pa gehalten wird, vorzugsweise der Sauerstoff-Druck bei 1,3 Pa oder weniger gehalten wird,
um eine Schicht des Dünnschichtmaterials zu erlangen;
(d) Kühlen des aus c erlangten Substrats, wobei der Sauerstoff-Druck im Bereich zwischen 0 und 2,7 Pa gehalten wird, vorzugsweise der Sauerstoff-Druck bei 1,3 Pa oder weniger gehalten wird,
um eine Dünnschicht zu erlangen,
wobei (c) Variieren des A- und/oder T-Kationengehalts in mindestens einer Raumrichtung während der Abscheidung umfasst.

**11.** Verfahren nach Anspruch 8, wobei das Target für T aus der Gruppe ausgewählt ist, bestehend aus Ti, $NiTiO_3$, $CoTiO_3$, TiO, $Ti_2O_3$ und Mischungen von mindestens zwei davon, wobei das Target für T vorzugsweise aus der Gruppe ausgewählt ist, bestehend aus $NiTiO_3$, CoTiOs und Mischungen von mindestens zwei davon.

**12.** Verfahren nach Anspruch 9, wobei das Target für A aus der Gruppe ausgewählt ist, bestehend aus Legierungen aus Ni und Co, $NiCoO_4$, $NiCo_2O_4$, $Co_xNi_{1-x}O_3$, wobei 0 < x < 1 ist, und Mischungen von mindestens zwei davon, wobei das Target für A vorzugsweise $NiCoO_4$ ist.

**13.** Verfahren nach einem der Ansprüche 8 bis 12, wobei (c) durch Sputtern, PLD, EBPVD, CVD oder Flüssigphasen-Epitaxietechnik ausgeführt wird.

**14.** Verfahren nach einem der Ansprüche 8 bis 13,

wobei in (a) $LiNbO_3$ oder $LiTaO_3$ als Substrat bereitgestellt wird oder
wobei in (a) ein Substrat bereitgestellt wird, das $LiNbO_3$ oder $LiTaO_3$ als eine Impfschicht trägt, wobei (b) weiterhin das Bereitstellen eines Targets für $LiNbO_3$ oder $LiTaO_3$ umfasst und wobei (c) Folgendes umfasst

(c. 1) Abscheiden von A und T oder von Atomclustern, die mindestens eines der Atome aus der Gruppe enthalten, bestehend aus A, T und O, auf dem Substrat, wobei die Abscheidungsparameter so eingestellt sind, dass -1 < x < 1 und -16 < n < 32 auf dem Substrat sind und wobei die in-situ-Temperatur des Substrats im Bereich zwischen 673 und 933 K gehalten wird und wobei der Sauerstoff-Druck im Bereich zwischen 0 und 2,7 Pa gehalten wird, vorzugsweise der Sauerstoff-Druck bei 1,3 Pa oder weniger gehalten wird, um eine Schicht des Dünnschichtmaterials zu erlangen; und
(c.2) Abscheiden von $LiNbO_3$ oder $LiTaO_3$, um eine Schicht aus $LiNbO_3$ oder $LiTaO_3$ zu erlangen.

**15.** Verfahren nach einem der Ansprüche 8 bis 14, wobei das Verhältnis der Konzentration von A und der Konzentration von T als eine Funktion der Zeit eingestellt wird.

**16.** Dünnschicht, ein Dünnschichtmaterial nach einem der Ansprüche 1 bis 7 umfassend.

**17.** Verwendung eines Dünnschichtmaterials nach einem der Ansprüche 1 bis 7 oder einer Dünnschicht nach Anspruch 16 in einer elektrischen Vorrichtung, vorzugsweise in einer elektrischen Vorrichtung, die ein elektrisch isolierendes Dünnschichtmaterial umfasst, wobei die Dicke des Dünnschichtmaterials vorzugsweise im Bereich zwischen 0,5 Nanometer und 10 Mikrometer liegt.

18. Verfahren zum Herstellen einer mehrschichtigen Vorrichtung, wobei mindestens eine Schicht ein Dünnschichtmaterial nach einem der Ansprüche 1 bis 7 umfasst, **dadurch gekennzeichnet, dass** die Grenzflächen zwischen strukturell ähnlichen Schichten eine Gitterfehlanpassung e = (b - a)/a unter der Versetzungsbildungsgrenze aufweisen, wobei a bzw. b die entsprechenden Oktaederkantenlängen in den benachbarten Schichten sind, wobei e vorzugsweise kleiner als 0,01 ist; und
wobei ein Zusammensetzungsgradient in der Umgebung der Grenzfläche eingeführt wird, um e unter die Versetzungsbildungsgrenze zu verringern.

## Revendications

1. Matériau en couche mince ayant la formule empirique $A_{1+nx}T^{z}{}_{1-x}O_3$,

   dans lequel *A* est choisi dans le groupe constitué par Mg et Mn,
   dans lequel *T* est Ti,
   dans lequel

$$-1 < x < 1,$$

   dans lequel *z* est l'état d'oxydation moyen de *T*, calculé comme la moyenne pondérée des états d'oxydation des cations *T* rapportée à la quantité totale de *T* dans la composition en pourcentage atomique, et
   dans lequel

$$n = (4-z+zx)/(2x),$$

   **caractérisé en ce que** la structure est décrite par trois axes, *a*, *b* et *c*, et trois angles, *a* entre les axes *b* et *c*, $\beta$ entre les axes *a* et *c*, et $\gamma$ entre les axes *a* et *b*,
   dans lequel 0,475 nm (4,75 Å) < *a* < 0,55 nm (5,5 Å), 0, 475 nm (4, 75 Å) < *b* < 0,55 nm (5, 5 Å), et 1,25 nm (12,5 Å) < c < 1,55 nm (15,5 Å), et
   dans lequel 85° < $\alpha$ < 95°, 85° < $\beta$ < 95°, et 115° < $\gamma$ < 125°,
   le matériau comprenant au moins deux couches empilées, dans lequel chaque couche comprend une couche continue d'octaèdres d'oxygène agencés en hexagones, chaque octaèdre partageant une face avec l'octaèdre au-dessus et/ou en dessous le long de la direction d'empilement, dans lequel, dans le plan de base, chaque octaèdre d'oxygène partage un bord avec chacun des six octaèdres voisins du même plan de base, et dans lequel chaque octaèdre d'oxygène a des octaèdres partageant six coins au-dessus et/ou des octaèdres partageant six coins en dessous,
   dans lequel les octaèdres sont vacants ou contiennent un cation A ou un cation *T*,
   dans lequel au moins une fraction des octaèdres sont remplis par un cation, la fraction de remplissage des octaèdres étant

$$z_v = [2+(n-1)x]/3.$$

2. Matériau en couche mince ayant la formule empirique $A_{1+nx}T^{z}{}_{1-x}O_3$,

   dans lequel *A* est Ni et Co,
   dans lequel *T* est choisi dans le groupe constitué par V et Cr,
   dans lequel

$$-1 < x < 1,$$

   dans lequel z est l'état d'oxydation moyen de *T*, calculé comme la moyenne pondérée des états d'oxydation des cations *T* rapportée à la quantité totale de *T* dans la composition en pourcentage atomique, et dans lequel

$$n = (4-z+zx)/(2x),$$

**caractérisé en ce que** la structure est décrite par trois axes, *a*, *b* et c, et trois angles, *a* entre les axes *b* et *c*, $\beta$ entre les axes *a* et *c*, et $\gamma$ entre les axes *a* et *b*,
dans lequel 0,475 nm (4,75 Å) < *a* < 0,55 nm (5,5 Å), 0, 475 nm (4, 75 Å) < *b* < 0,55 nm (5, 5 Å), et 1,25 nm (12,5 Å) < c < 1,55 nm (15,5 Å), et
dans lequel 85° < $\alpha$ < 95°, 85° < $\beta$ < 95°, et 115° < $\gamma$ < 125°,
le matériau comprenant au moins deux couches empilées, dans lequel chaque couche comprend une couche continue d'octaèdres d'oxygène agencés en hexagones, chaque octaèdre partageant une face avec l'octaèdre au-dessus et/ou en dessous le long de la direction d'empilement, dans lequel, dans le plan de base, chaque octaèdre d'oxygène partage un bord avec chacun des six octaèdres voisins du même plan de base, et dans lequel chaque octaèdre d'oxygène a des octaèdres partageant six coins au-dessus et/ou des octaèdres partageant six coins en dessous,
dans lequel les octaèdres sont vacants ou contiennent un cation *A* ou un cation *T*,
dans lequel au moins une fraction des octaèdres sont remplis par un cation, la fraction de remplissage des octaèdres étant

$$z_V = [2+(n-1)x]/3.$$

**3.** Matériau en couche mince ayant la formule empirique $A_{1+nx}T^{z}_{1-x}O_3$,

dans lequel *A* est Mg,
dans lequel *T* est choisi dans le groupe constitué par Cr, V et Mn,
dans lequel

$$-1 < x < 1,$$

dans lequel *z* est l'état d'oxydation moyen de *T*, calculé comme la moyenne pondérée des états d'oxydation des cations *T* rapportée à la quantité totale de *T* dans la composition en pourcentage atomique, et
dans lequel

$$n = (4-z+zx)/(2x),$$

**caractérisé en ce que** la structure est décrite par trois axes, *a*, *b* et *c*, et trois angles, *a* entre les axes *b* et *c*, $\beta$ entre les axes *a* et *c*, et $\gamma$ entre les axes *a* et *b*,
dans lequel 0,475 nm (4,75 Å) < *a* < 0,55 nm (5,5 Å), 0, 475 nm (4, 75 Å) < *b* < 0,55 nm (5, 5 Å), et 1,25 nm (12,5 Å) < *c* < 1,55 nm (15,5 Å), et
dans lequel 85° < $\alpha$ < 95°, 85° < $\beta$ < 95°, et 115° < $\gamma$ < 125°,
le matériau comprenant au moins deux couches empilées, dans lequel chaque couche comprend une couche continue d'octaèdres d'oxygène agencés en hexagones, chaque octaèdre partageant une face avec l'octaèdre au-dessus et/ou en dessous le long de la direction d'empilement, dans lequel, dans le plan de base, chaque octaèdre d'oxygène partage un bord avec chacun des six octaèdres voisins du même plan de base, et dans lequel chaque octaèdre d'oxygène a des octaèdres partageant six coins au-dessus et/ou des octaèdres partageant six coins en dessous,
dans lequel les octaèdres sont vacants ou contiennent un cation A ou un cation T,
dans lequel au moins une fraction des octaèdres sont remplis par un cation, la fraction de remplissage des octaèdres étant

$$z_V = [2+(n-1)x]/3.$$

**4.** Matériau en couche mince selon l'une quelconque des revendications 1 à 3 dans lequel, dans un système de coordonnées cartésiennes défini par une abscisse (1+nx) et une ordonnée (1-x), une paire des valeurs 1+nx et 1-x définit un point ((1+nx);(1-x)) à l'intérieur d'une zone définie par les lignes

$$1-x = -(1+nx)+3,$$

$$1-x = -0,500(1+nx)+1,500,$$

et

$$1-x = 1,561(1+nx)+0,44,$$

et les intersections desdites lignes.

**5.** Matériau en couche mince selon l'une quelconque des revendications 1 à 4, dans lequel

$$2,7+ < z < 4+.$$

**6.** Matériau en couche mince selon l'une quelconque des revendications 1 à 5, dans lequel les sites atomiques à l'intérieur de la cellule unitaire sont décrits par les coordonnées fractionnaires suivantes :

| Site i | Atome | Coordonnées fractionnaires | | |
|---|---|---|---|---|
| 1 | A,T | $-0,05<x_1<0,05$ | $-0,05<y_1<0,05$ | $0,3<z_1<0,4$ |
| 2 | A,T | $-0,05<x_2<0,05$ | $-0,05<y_2<0,05$ | $-0,4<z_2<-0,3$ |
| 3 | A,T | $-0,05<x_3<0, 05$ | $-0,05<y_3<0,05$ | $0,1<z_3<0,2$ |
| 4 | A,T | $-0,05<x_4<0,05$ | $-0,05<y_4<0,05$ | $-0,2<z_4<-0,1$ |
| 5 | A,T | $-0,05<x_5<0,05$ | $-0,05<y_3<0,05$ | $-0,05<z_5<0,05$ |
| 6 | A,T | $-0,05<x_6<0,05$ | $-0,05<y_6<0,05$ | $0,45<z_6<0,55$ |
| 7 | O | $0,25<x_7<0,35$ | $-0,05<y_7<0,05$ | $0,24<z_7<0,35$ |
| 8 | O | $-0,05<x_8<0,05$ | $0,25<y_8<0,35$ | $0,24<z_8<0,35$ |
| 9 | O | $-0,35<x_9<-0,25$ | $-0,35<y_9<-0,25$ | $0,24<z_9<0,35$ |
| 10 | O | $-0,35<x_{10}<-0,25$ | $-0,05<y_{10}<0,05$ | $-0,35<z_{10}<-0,24$ |
| 11 | O | $-0,05<x_{11}<0,05$ | $-0,35<y_{11}<-0,25$ | $-0,35<z_{11}<-0,24$ |
| 12 | O | $0,25<x_{12}<0,35$ | $0,25<y_{12}<0,35$ | $-0,35<z_{12}<-0,24$ |

les vecteurs $v_1=\left(\frac{1}{3},\frac{2}{3},\frac{2}{3}\right)$ et $v_2=\left(\frac{2}{3},\frac{1}{3},\frac{1}{3}\right)$, et les paramètres de réseau,

dans lequel chaque position $r_i$ d'un site i, où i = 1, 2, 3, 4, 5, 6, 7, 8, 9, 10, 11 ou 12, est donnée par la formule $r_i = x_ia + y_ib + z_ic$,
dans lequel chaque position $r_i$ d'un site i, où i = 13, 14, 15, 16, 17, 18, 19, 20, 21, 22, 23 ou 24, est donnée par la formule $r_i + v_1$,
dans lequel chaque position $r_i$ d'un site i, où i = 25, 26, 27, 28, 29, 30, 31, 32, 33, 34, 35 ou 36, est donnée par la formule $r_i + v_2$, et
dans lequel l'occupation moyenne des sites des atomes A, T est de 0,50 à 1.

**7.** Matériau en couche mince selon l'une quelconque des revendications 1 à 6, le matériau comprenant au moins trois couches, dans lequel chaque couche comprend une couche continue d'octaèdres d'oxygène agencés en hexagones, chaque octaèdre partageant une face avec l'octaèdre au-dessus et/ou en dessous le long de la direction d'empilement, dans lequel, dans le plan de base, chaque octaèdre d'oxygène partage un bord avec chacun des six octaèdres voisins du même plan de base, et dans lequel chaque octaèdre d'oxygène a des octaèdres partageant six coins au-dessus et/ou des octaèdres partageant six coins en dessous.

**8.** Procédé de fabrication d'une couche mince comprenant un substrat et un matériau en couche mince ayant la formule empirique $A_{1+nx}T^{z}{}_{1-x}O_3$ dans lequel A est choisi dans le groupe constitué par Mg et Mn, T est Ti, dans lequel $-1 < x < 1$, dans lequel z est l'état d'oxydation moyen de T, calculé comme la moyenne pondérée des états d'oxydation des cations T rapportée à la quantité totale de T dans la composition en pourcentage atomique, et dans lequel $n = (4-z+zx)/(2x)$, le procédé comprenant les étapes suivantes :

(a) obtention d'un substrat, le substrat ayant de préférence une structure de surface possédant une périodicité similaire à celle de la structure des plans cristallins de $A_{1+nx}T^{z}{}_{1-x}O_3$ souhaitée, la différence entre les périodicités étant de préférence inférieure à 3 % ;
(b) obtention d'au moins une cible comprenant *A* et/ou *T*, de préférence sous forme d'oxyde, mieux encore d'une cible pour *A* et d'une cible pour *T* ;
(c) dépôt de *A* et *T*, ou de groupes d'atomes contenant au moins un des atomes du groupe constitué par *A*, *T* et O, sur le substrat, les paramètres de dépôt étant ajustés de telle sorte que $-1 < x < 1$ et $-16 < n < 32$ sur le substrat, la température in situ du substrat étant maintenue dans la plage de 673 à 933 K, et la pression d'oxygène étant maintenue dans la plage de plus de 0 à 2,7 Pa, la pression d'oxygène étant de préférence maintenue à 1,3 Pa ou moins,
pour obtenir une couche du matériau en couche mince ;
(d) refroidissement du substrat obtenu en c, la pression d'oxygène étant maintenue dans la plage de plus de 0 à 2,7 Pa, la pression d'oxygène étant de préférence maintenue à 1,3 Pa ou moins,
pour obtenir une couche mince,
dans lequel (c) comprend la variation de la teneur en cations A et/ou *T* dans au moins une direction spatiale pendant le dépôt.

**9.** Procédé de fabrication d'une couche mince comprenant un substrat et un matériau en couche mince ayant la formule empirique $A_{1-nx}T^{z}1\text{-}xO_3$ dans lequel *A* est Ni et Co, *T* est choisi dans le groupe constitué par V et Cr, dans lequel $-1 < x < 1$, dans lequel *z* est l'état d'oxydation moyen de *T*, calculé comme la moyenne pondérée des états d'oxydation des cations *T* rapportée à la quantité totale de *T* dans la composition en pourcentage atomique, et dans lequel $n = (4-z+zx)/(2x)$, le procédé comprenant les étapes suivantes :

(a) obtention d'un substrat, le substrat ayant de préférence une structure de surface possédant une périodicité similaire à celle de la structure des plans cristallins de $A_{1+nx}T^{z}{}_{1-x}O_3$ souhaitée, la différence entre les périodicités étant de préférence inférieure à 3 % ;
(b) obtention d'au moins une cible comprenant *A* et/ou *T*, de préférence sous forme d'oxyde, mieux encore d'une cible pour *A* et d'une cible pour *T* ;
(c) dépôt de *A* et *T*, ou de groupes d'atomes contenant au moins un des atomes du groupe constitué par *A*, *T* et O, sur le substrat, les paramètres de dépôt étant ajustés de telle sorte que $-1 < x < 1$ et $-16 < n < 32$ sur le substrat, la température in situ du substrat étant maintenue dans la plage de 673 à 933 K, et la pression d'oxygène étant maintenue dans la plage de plus de 0 à 2,7 Pa, la pression d'oxygène étant de préférence maintenue à 1,3 Pa ou moins,
pour obtenir une couche du matériau en couche mince ;
(d) refroidissement du substrat obtenu en c, la pression d'oxygène étant maintenue dans la plage de plus de 0 à 2,7 Pa, la pression d'oxygène étant de préférence maintenue à 1,3 Pa ou moins,
pour obtenir une couche mince,
dans lequel (c) comprend la variation de la teneur en cations *A* et/ou *T* dans au moins une direction spatiale pendant le dépôt.

**10.** Procédé de fabrication d'une couche mince comprenant un substrat et un matériau en couche mince ayant la formule empirique $A_{1+nx}T^{z}{}_{1-x}O_3$ dans lequel *A* est Mg, *T est* choisi dans le groupe constitué par Cr, V et Mn, dans lequel $-1 < x < 1$, dans lequel *z* est l'état d'oxydation moyen de *T*, calculé comme la moyenne pondérée des états d'oxydation des cations *T* rapportée à la quantité totale de *T* dans la composition en pourcentage atomique, et dans lequel $n = (4-z+zx)/(2x)$, le procédé comprenant les étapes suivantes :

(a) obtention d'un substrat, le substrat ayant de préférence une structure de surface possédant une périodicité similaire à celle de la structure des plans cristallins de $A_{1+nx}T^{z}{}_{1-x}O_3$ souhaitée, la différence entre les périodicités étant de préférence inférieure à 3 % ;
(b) obtention d'au moins une cible comprenant A et/ou *T*, de préférence sous forme d'oxyde, mieux encore d'une cible pour *A* et d'une cible pour *T* ;
(c) dépôt de *A* et *T*, ou de groupes d'atomes contenant au moins un des atomes du groupe constitué par *A*, *T* et O, sur le substrat, les paramètres de dépôt étant ajustés de telle sorte que $-1 < x < 1$ et $-16 < n < 32$ sur le substrat, la température in situ du substrat étant maintenue dans la plage de 673 à 933 K, et la pression d'oxygène étant maintenue dans la plage de plus de 0 à 2,7 Pa, la pression d'oxygène étant de préférence maintenue à 1,3 Pa ou moins,
pour obtenir une couche du matériau en couche mince ;
(d) refroidissement du substrat obtenu en c, la pression d'oxygène étant maintenue dans la plage de plus de 0 à 2,7 Pa, la pression d'oxygène étant de préférence maintenue à 1,3 Pa ou moins,
pour obtenir une couche mince,
dans lequel (c) comprend la variation de la teneur en cations *A* et/ou *T* dans au moins une direction spatiale pendant le dépôt.

**11.** Procédé selon la revendication 8, dans lequel la cible pour *T* est choisie dans le groupe constitué par Ti, $NiTiO_3$, $CoTiO_3$, TiO, $Ti_2O_3$, et les mélanges d'au moins deux d'entre eux, la cible pour *T* étant de préférence choisie dans le groupe constitué par $NiTiO_3$, $CoTiO_3$, et les mélanges d'au moins deux d'entre eux.

**12.** Procédé selon la revendication 9, dans lequel la cible pour A est choisie dans le groupe constitué par les alliages de Ni et Co, $NiCoO_4$, $NiCo_2O_4$, $Co_xNi_{1-x}O_3$ où $0<x<1$, et les mélanges d'au moins deux d'entre eux, la cible pour A étant de préférence $NiCoO_4$.

**13.** Procédé selon l'une quelconque des revendications 8 à 12, dans lequel (c) est réalisé par pulvérisation, PLD, EBPVD, CVD, ou une technique épitaxiale en phase liquide.

**14.** Procédé selon l'une quelconque des revendications 8 à 13,

dans lequel, en (a), $LiNbO_3$ ou $LiTaO_3$ est prévu comme substrat, ou
dans lequel, en (a), un substrat portant $LiNbO_3$ ou $LiTaO_3$ comme couche d'ensemencement est prévu,
dans lequel (b) comprend en outre l'obtention d'une cible pour $LiNbO_3$ ou $LiTaO_3$, et
dans lequel (c) comprend

(c.1) le dépôt de *A* et *T*, ou de groupes d'atomes contenant au moins un des atomes du groupe constitué par A, T et O, sur le substrat, les paramètres de dépôt étant ajustés de telle sorte que $-1 < x < 1$ et $-16 < n < 32$ sur le substrat et la température in situ du substrat étant maintenue dans la plage de 673 à 933 K, et la pression d'oxygène étant maintenue dans la plage de plus de 0 à 2,7 Pa, la pression d'oxygène étant de préférence maintenue à 1,3 Pa ou moins, pour obtenir une couche du matériau en couche mince ; et
(c.2) le dépôt de $LiNbO_3$ ou $LiTaO_3$, pour obtenir une couche de $LiNbO_3$ ou $LiTaO_3$.

**15.** Procédé selon l'une quelconque des revendications 8 à 14, dans lequel le rapport des concentrations entre la concentration de *A* et la concentration de *T* est ajusté en fonction du temps.

**16.** Couche mince comprenant un matériau en couche mince selon l'une quelconque des revendications 1 à 7.

**17.** Utilisation d'un matériau en couche mince selon l'une quelconque des revendications 1 à 7 ou d'une couche mince selon la revendication 16 dans un dispositif électrique, de préférence dans un dispositif électrique comprenant un matériau en couche mince électriquement isolant, dans laquelle l'épaisseur du matériau en couche mince se situe de préférence dans la plage de 0,5 nanomètre à 10 micromètres.

**18.** Procédé de fabrication d'un dispositif multicouche, dans lequel au moins une couche comprend un matériau en couche mince selon l'une quelconque des revendications 1 à 7,
**caractérisé en ce que**

les interfaces entre couches structuralement similaires ont un désaccord de maille $e = (b-a)/a$ inférieur à la limite de formation de dislocations, où a et *b* sont les longueurs des bords des octaèdres correspondants dans les couches adjacentes, respectivement, dans lequel e est de préférence inférieur à 0,01 ; et
dans lequel un gradient de composition est introduit à proximité de l'interface pour faire baisser e en dessous de la limite de formation de dislocations.

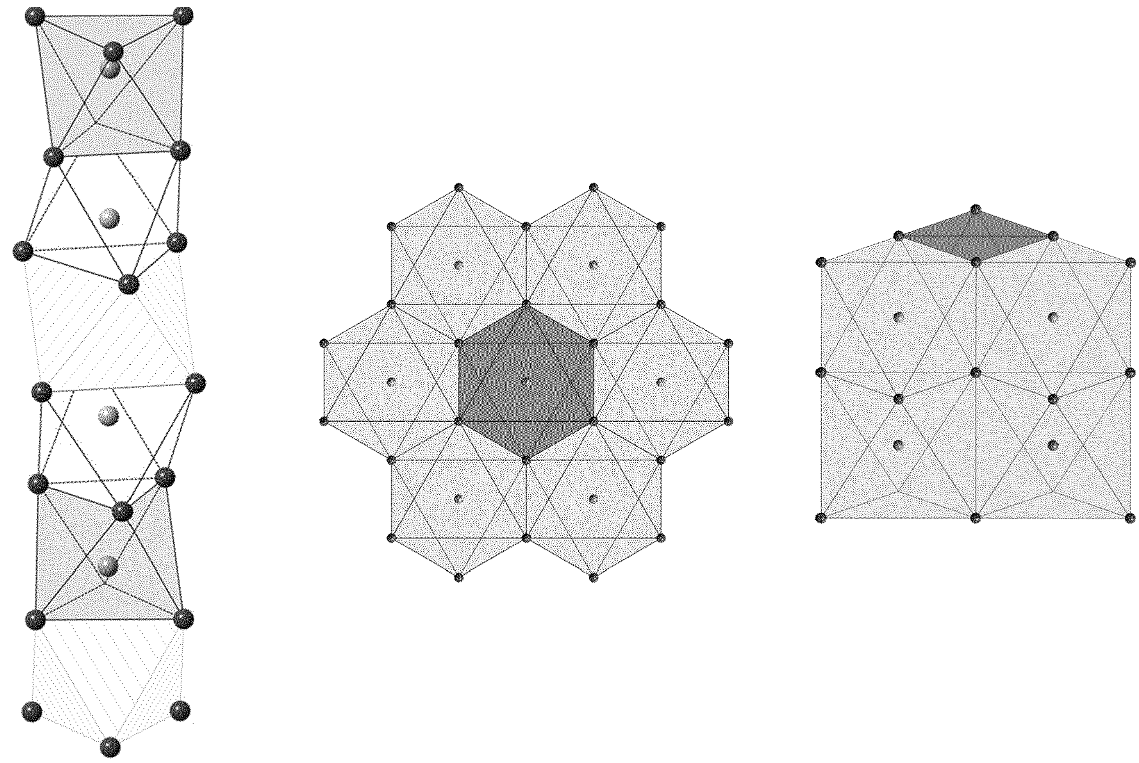

FIG. 1.

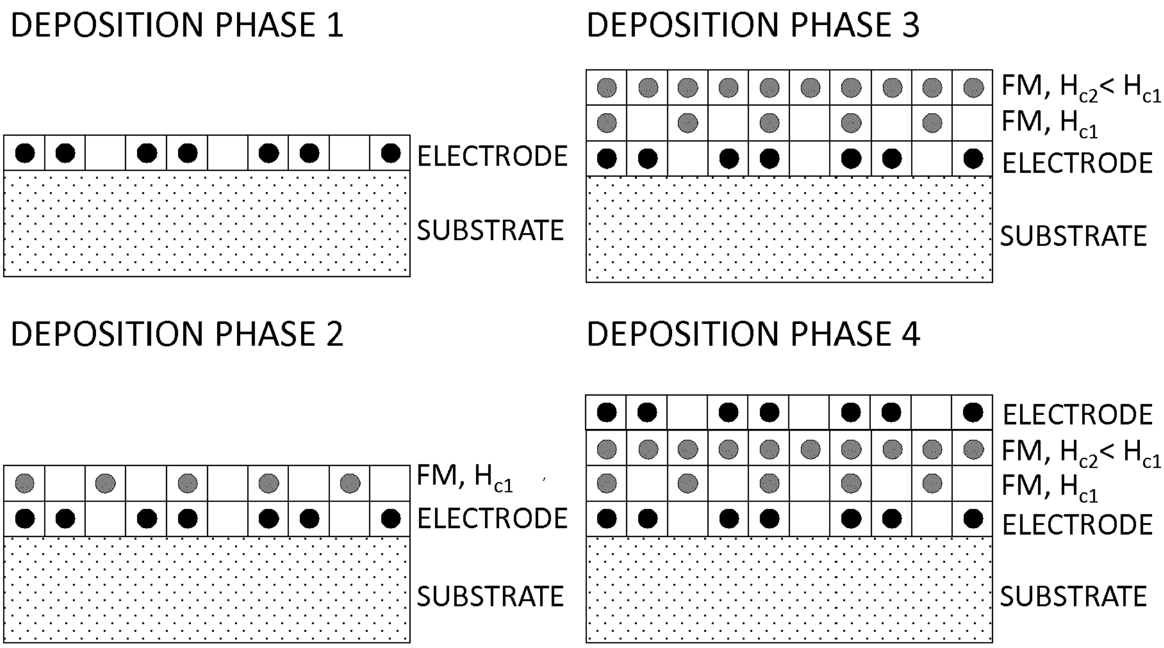
DEPOSITION PHASE 1
ELECTRODE
SUBSTRATE
DEPOSITION PHASE 3
FM, $H_{c2} < H_{c1}$
FM, $H_{c1}$
ELECTRODE
SUBSTRATE
DEPOSITION PHASE 2
FM, $H_{c1}$
ELECTRODE
SUBSTRATE
DEPOSITION PHASE 4
ELECTRODE
FM, $H_{c2} < H_{c1}$
FM, $H_{c1}$
ELECTRODE
SUBSTRATE

FIG. 2.

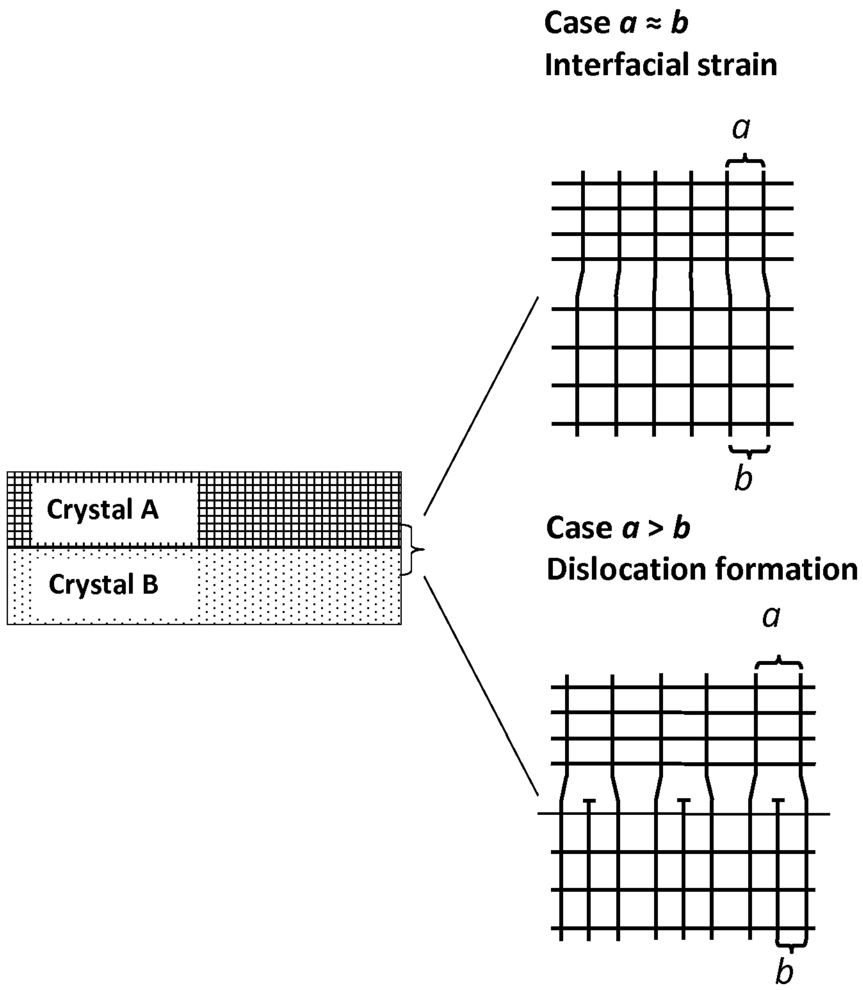
Case a ≈ b
Interfacial strain
a
b
Crystal A
Crystal B
Case a > b
Dislocation formation
a
b

FIG. 3.

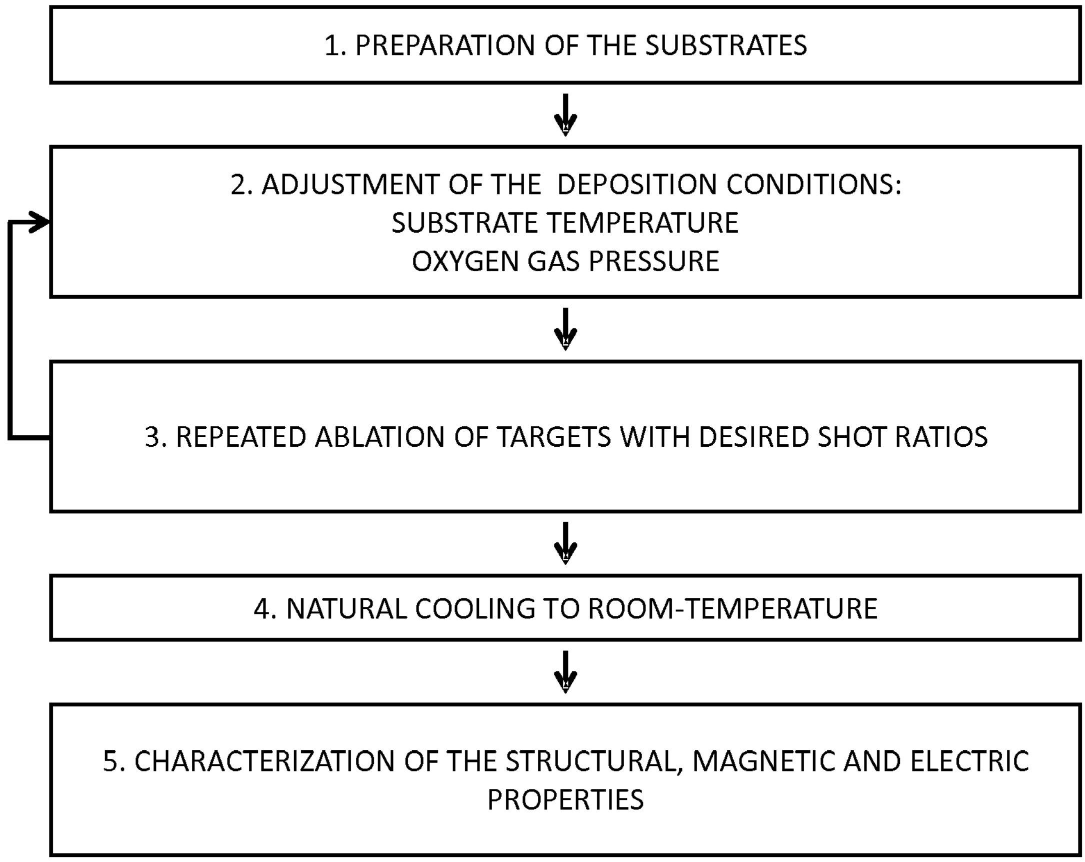
1. PREPARATION OF THE SUBSTRATES
2. ADJUSTMENT OF THE DEPOSITION CONDITIONS:
SUBSTRATE TEMPERATURE
OXYGEN GAS PRESSURE
3. REPEATED ABLATION OF TARGETS WITH DESIRED SHOT RATIOS
4. NATURAL COOLING TO ROOM-TEMPERATURE
5. CHARACTERIZATION OF THE STRUCTURAL, MAGNETIC AND ELECTRIC PROPERTIES

FIG. 4.

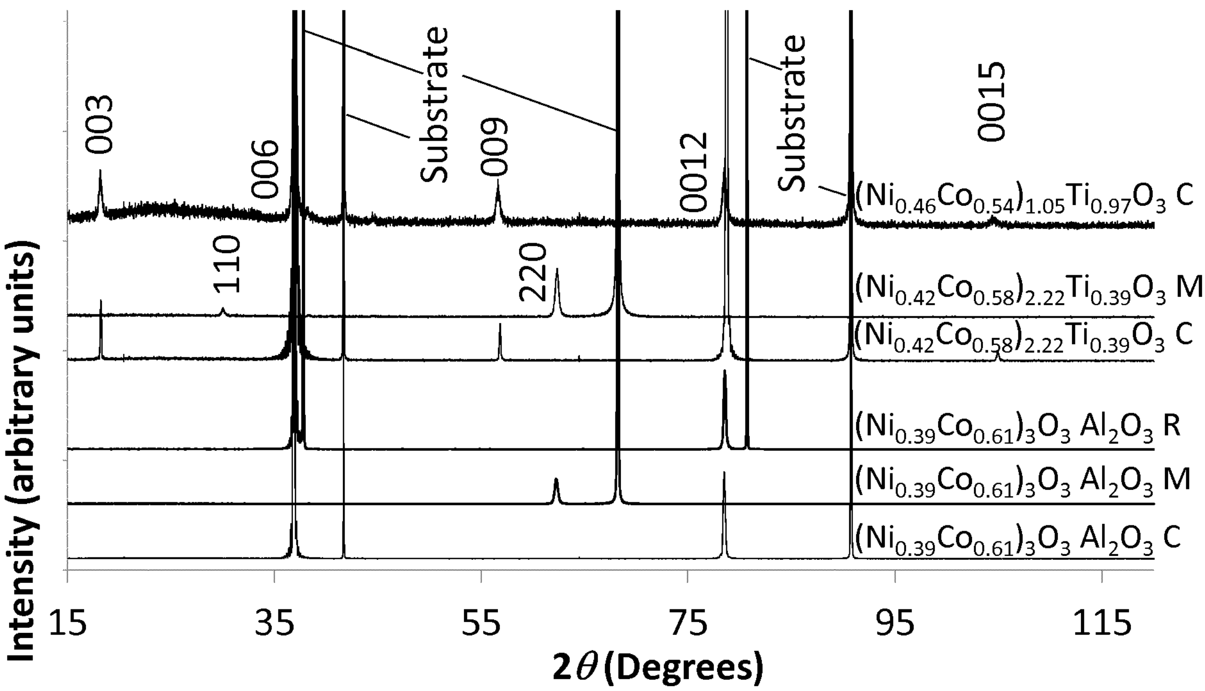
003
006
Substrate
009
0012
Substrate
0015
110
220
$(Ni_{0.46}Co_{0.54})_{1.05}Ti_{0.97}O_3$ C
$(Ni_{0.42}Co_{0.58})_{2.22}Ti_{0.39}O_3$ M
$(Ni_{0.42}Co_{0.58})_{2.22}Ti_{0.39}O_3$ C
$(Ni_{0.39}Co_{0.61})_3O_3$ $Al_2O_3$ R
$(Ni_{0.39}Co_{0.61})_3O_3$ $Al_2O_3$ M
$(Ni_{0.39}Co_{0.61})_3O_3$ $Al_2O_3$ C
Intensity (arbitrary units)
15
35
55
75
95
115
2θ (Degrees)

FIG. 5.

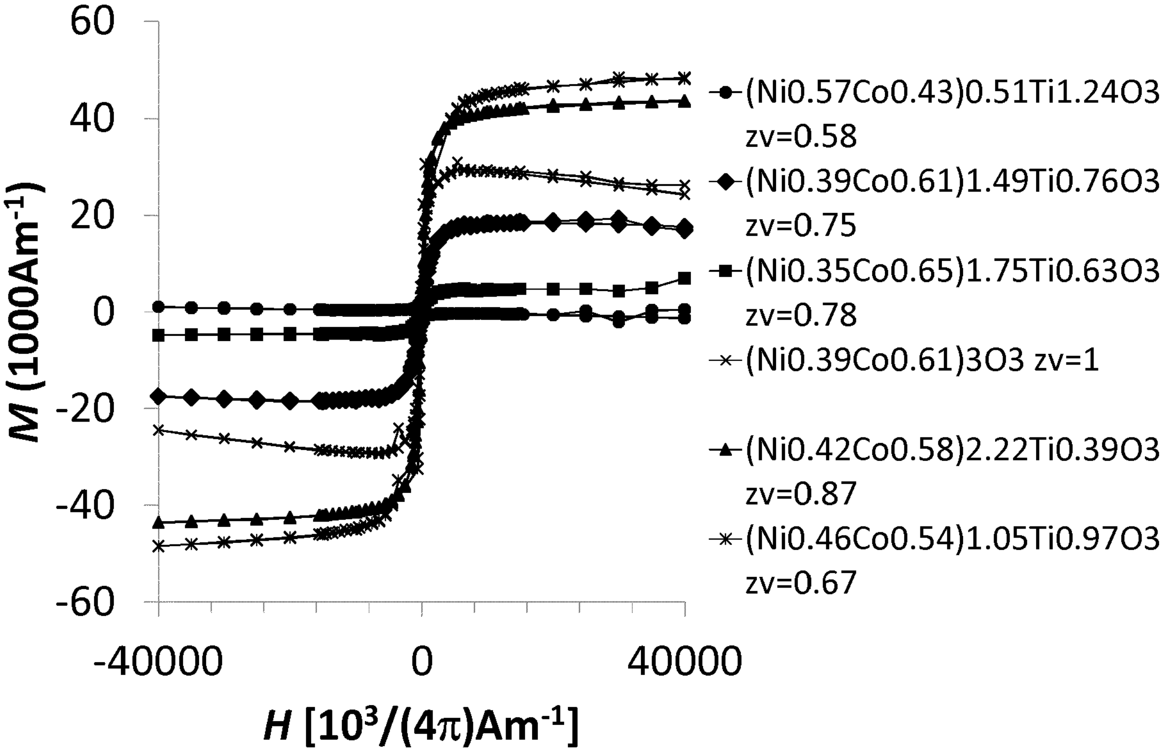
60
40
20
0
-20
-40
-60
-40000
0
40000
M (1000Am-1)
H [10³/(4π)Am-1]
(Ni0.57Co0.43)0.51Ti1.24O3 zv=0.58
(Ni0.39Co0.61)1.49Ti0.76O3 zv=0.75
(Ni0.35Co0.65)1.75Ti0.63O3 zv=0.78
(Ni0.39Co0.61)3O3 zv=1
(Ni0.42Co0.58)2.22Ti0.39O3 zv=0.87
(Ni0.46Co0.54)1.05Ti0.97O3 zv=0.67

FIG. 6.

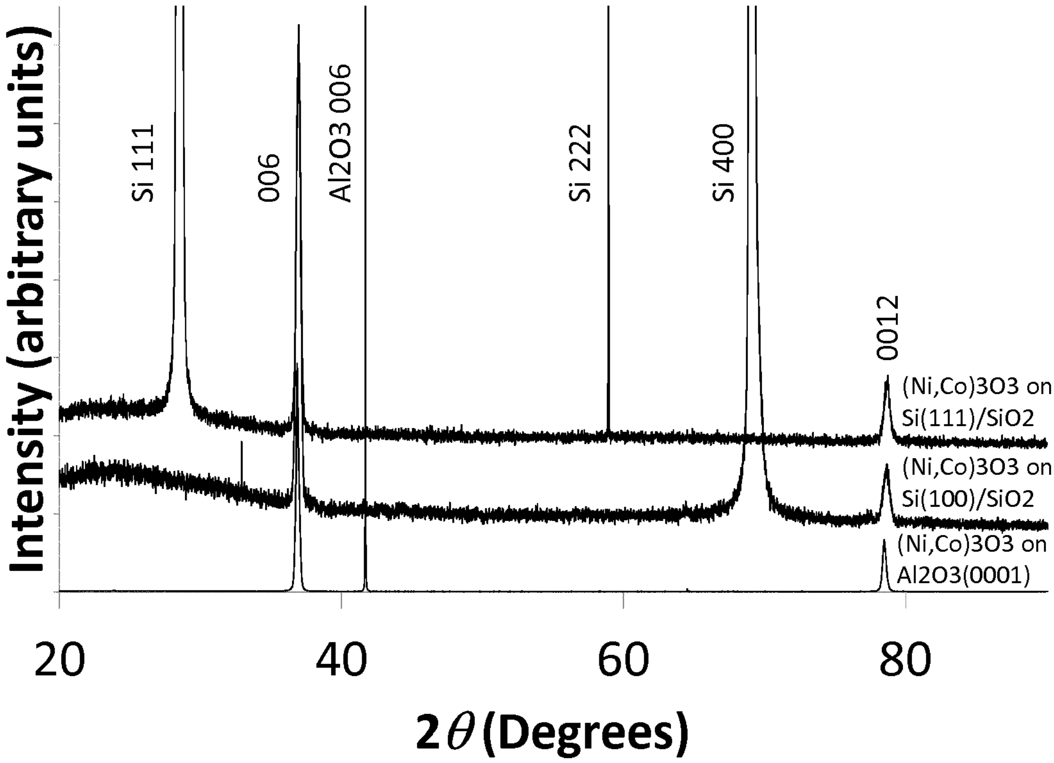
Intensity (arbitrary units)
Si 111
006
Al2O3 006
Si 222
Si 400
0012
(Ni,Co)3O3 on Si(111)/SiO2
(Ni,Co)3O3 on Si(100)/SiO2
(Ni,Co)3O3 on Al2O3(0001)
20
40
60
80
2θ (Degrees)

FIG. 7.

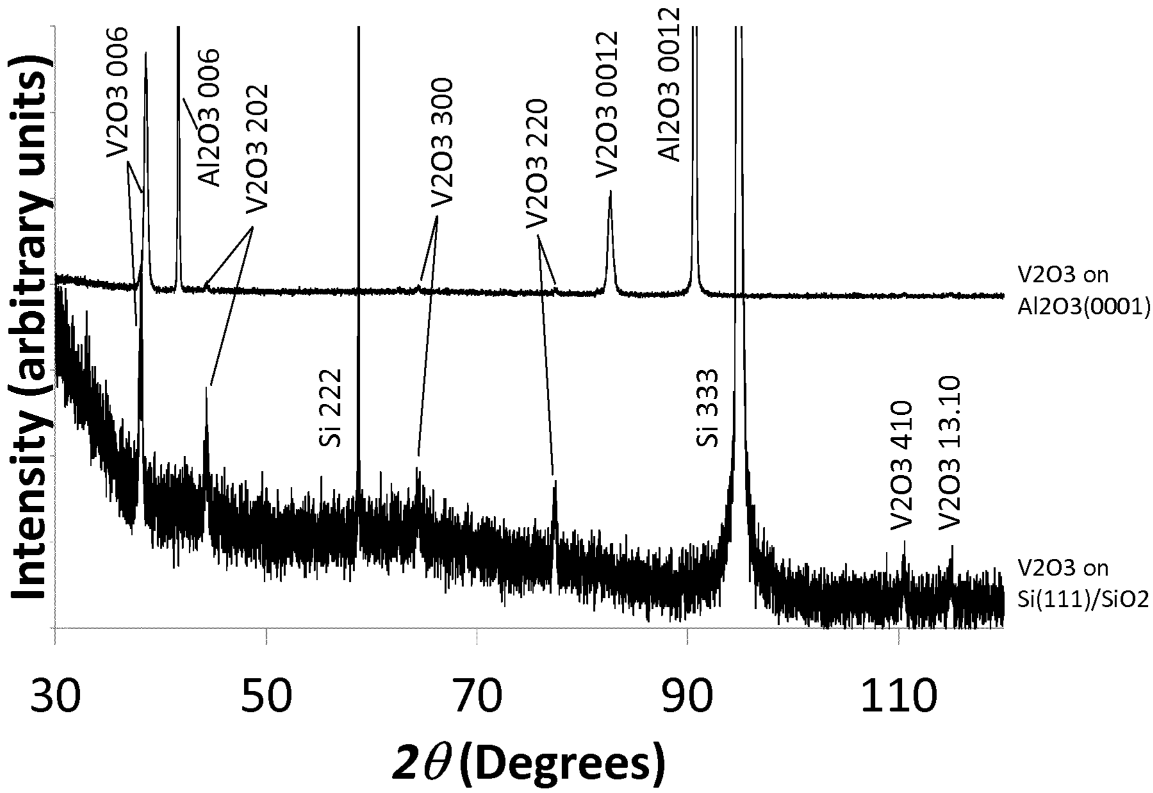
V2O3 006
Al2O3 006
V2O3 202
Si 222
V2O3 300
V2O3 220
V2O3 0012
Al2O3 0012
Si 333
V2O3 410
V2O3 13.10
V2O3 on Al2O3(0001)
V2O3 on Si(111)/SiO2
Intensity (arbitrary units)
30
50
70
90
110
2θ (Degrees)

FIG. 8.

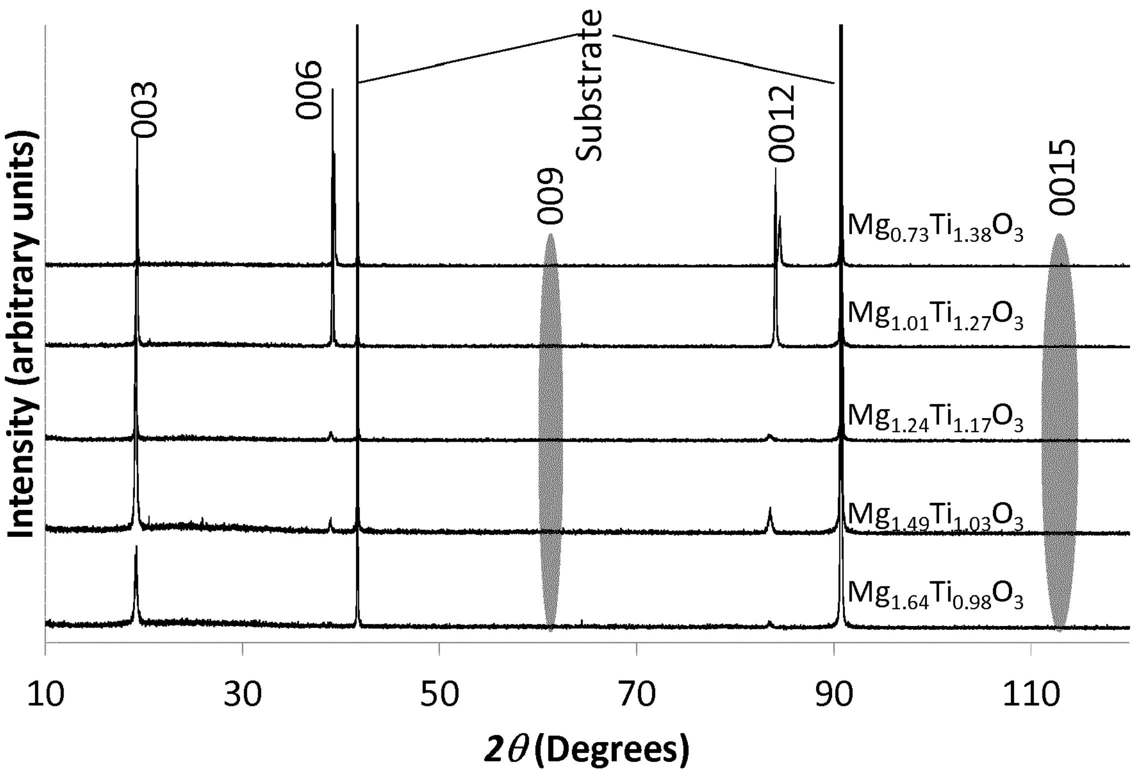
Intensity (arbitrary units)
003
006
Substrate
009
0012
0015
Mg0.73Ti1.38O3
Mg1.01Ti1.27O3
Mg1.24Ti1.17O3
Mg1.49Ti1.03O3
Mg1.64Ti0.98O3
10
30
50
70
90
110
2θ (Degrees)

FIG. 9.

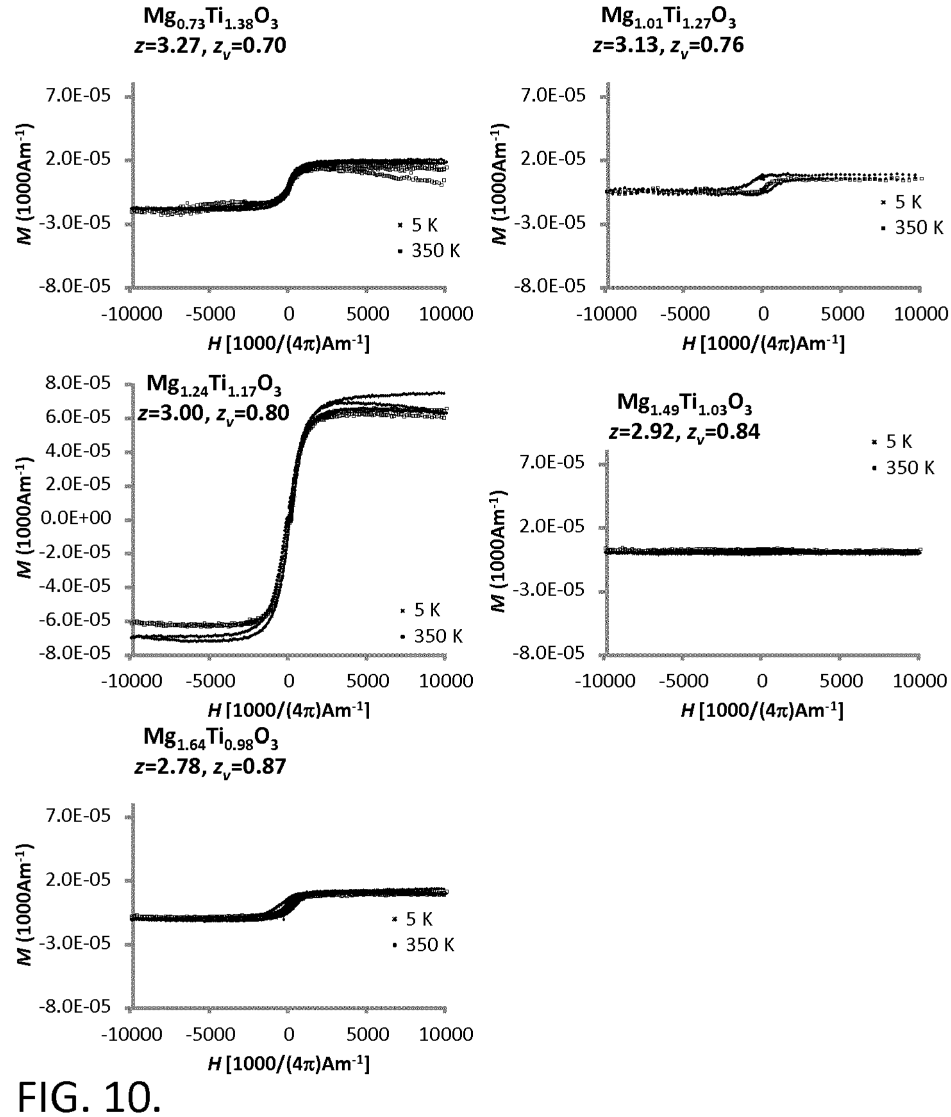
$Mg_{0.73}Ti_{1.38}O_3$
$z$=3.27, $z_v$=0.70
$Mg_{1.01}Ti_{1.27}O_3$
$z$=3.13, $z_v$=0.76
$Mg_{1.24}Ti_{1.17}O_3$
$z$=3.00, $z_v$=0.80
$Mg_{1.49}Ti_{1.03}O_3$
$z$=2.92, $z_v$=0.84
$Mg_{1.64}Ti_{0.98}O_3$
$z$=2.78, $z_v$=0.87
$M$ (1000Am$^{-1}$)
$H$ [1000/(4$\pi$)Am$^{-1}$]
5 K
350 K
8.0E-05
7.0E-05
6.0E-05
4.0E-05
2.0E-05
0.0E+00
-2.0E-05
-3.0E-05
-4.0E-05
-6.0E-05
-8.0E-05
-10000
-5000
0
5000
10000

FIG. 10.

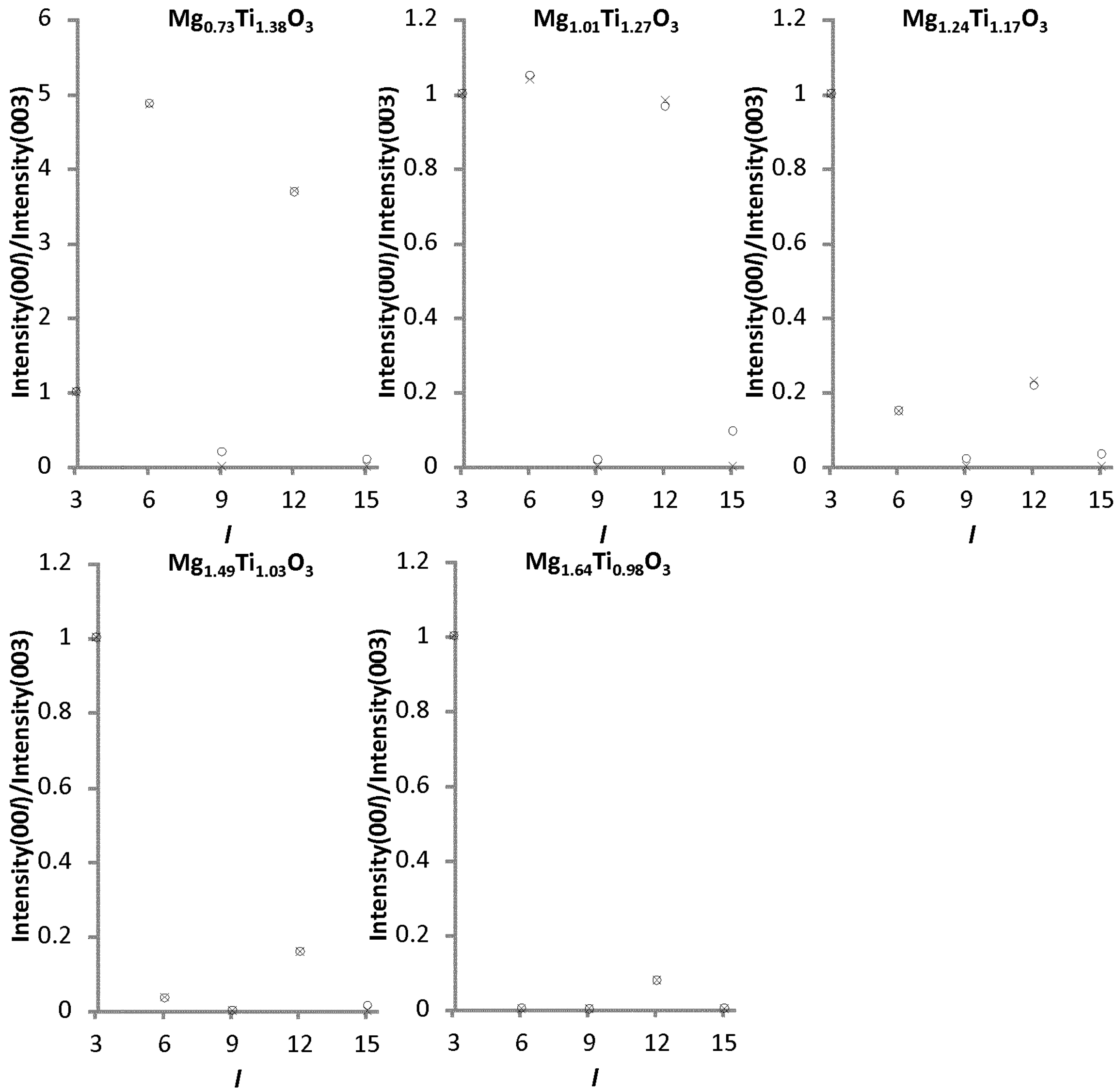
$Mg_{0.73}Ti_{1.38}O_3$
$Mg_{1.01}Ti_{1.27}O_3$
$Mg_{1.24}Ti_{1.17}O_3$
$Mg_{1.49}Ti_{1.03}O_3$
$Mg_{1.64}Ti_{0.98}O_3$
Intensity(00*l*)/Intensity(003)
*l*
0
1
2
3
4
5
6
0.2
0.4
0.6
0.8
1.2
9
12
15

FIG. 11.

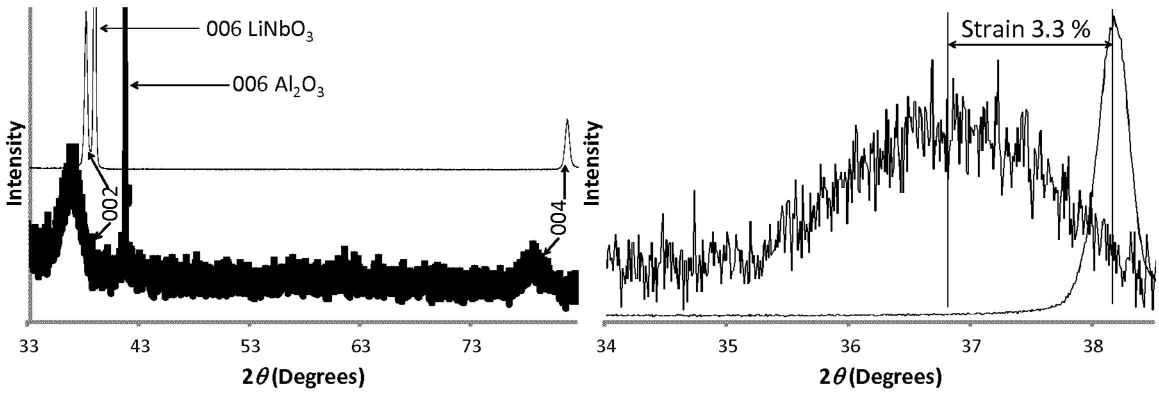
006 LiNbO3
006 Al2O3
Intensity
002
004
33
43
53
63
73
2θ(Degrees)
Strain 3.3 %
Intensity
34
35
36
37
38
2θ(Degrees)

FIG. 12.

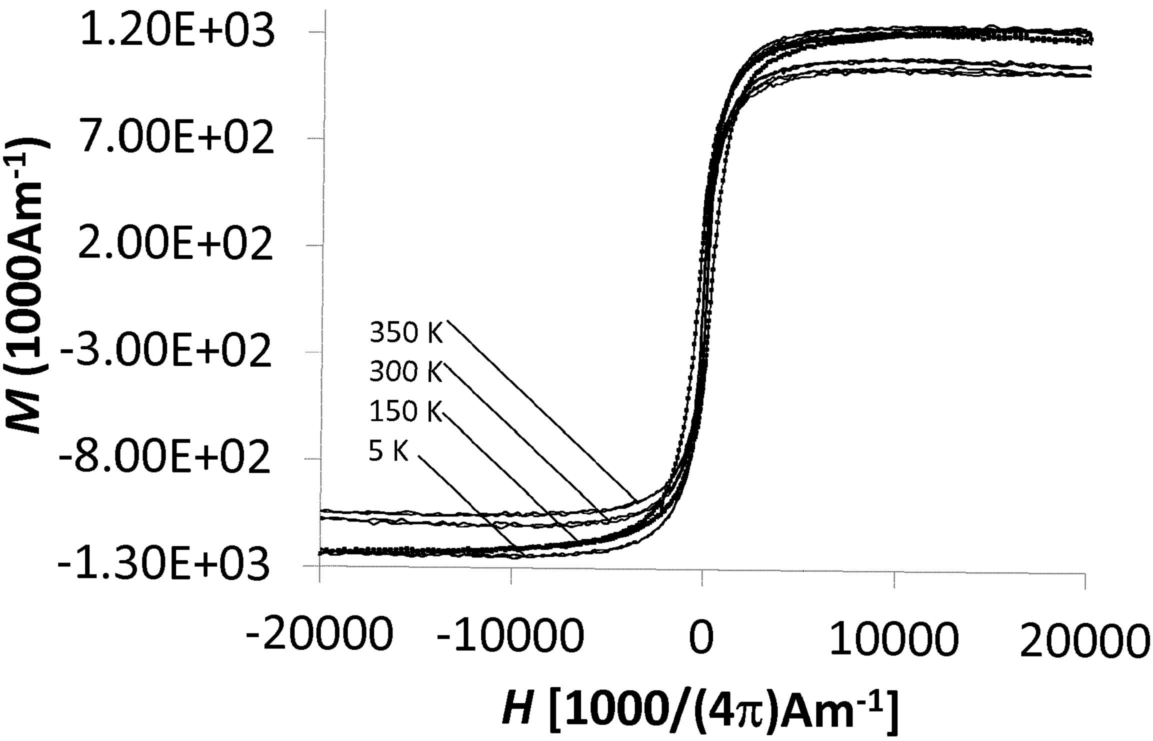
1.20E+03
7.00E+02
2.00E+02
-3.00E+02
-8.00E+02
-1.30E+03
M (1000Am-1)
350 K
300 K
150 K
5 K
-20000
-10000
0
10000
20000
H [1000/(4π)Am-1]

FIG. 13.

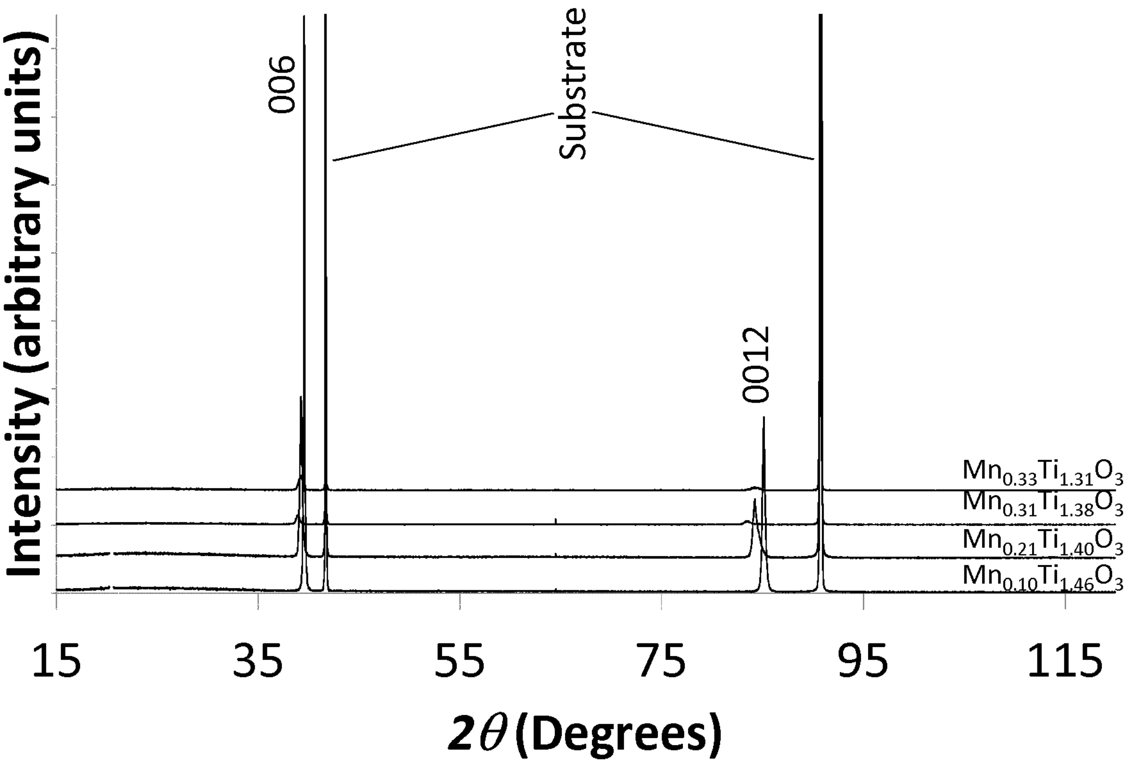
Intensity (arbitrary units)
006
Substrate
0012
Mn0.33Ti1.31O3
Mn0.31Ti1.38O3
Mn0.21Ti1.40O3
Mn0.10Ti1.46O3
15
35
55
75
95
115
2θ (Degrees)

FIG. 14.

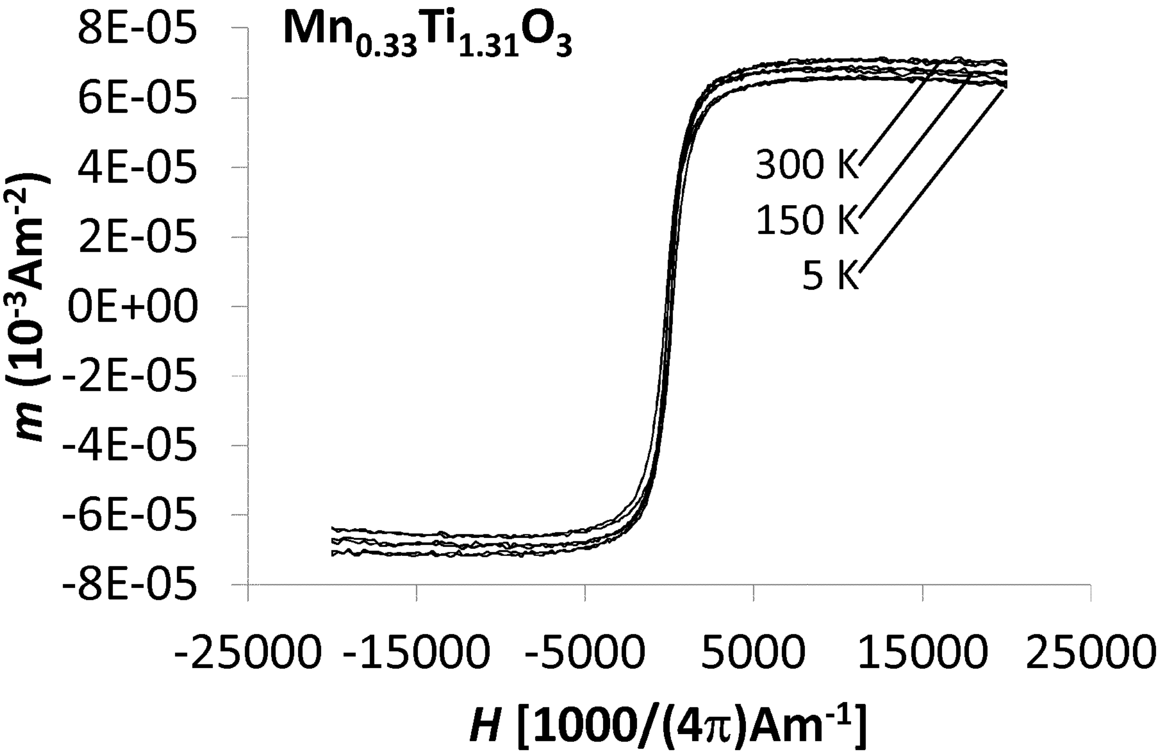

$Mn_{0.33}Ti_{1.31}O_3$
8E-05
6E-05
4E-05
2E-05
0E+00
-2E-05
-4E-05
-6E-05
-8E-05
*m* (10$^{-3}$Am$^{-2}$)
300 K
150 K
5 K
-25000 -15000 -5000 5000 15000 25000
*H* [1000/(4π)Am$^{-1}$]


FIG. 15.

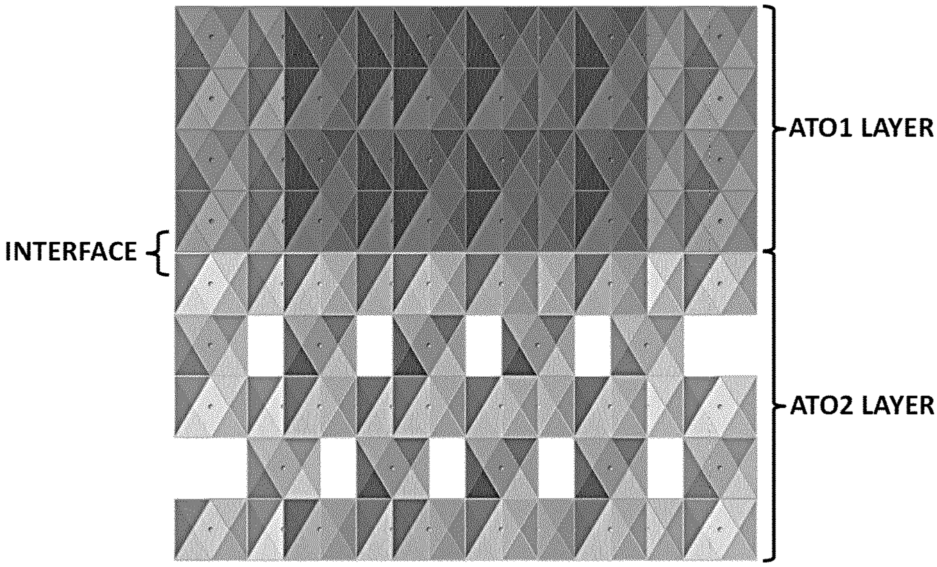


FIG. 16.

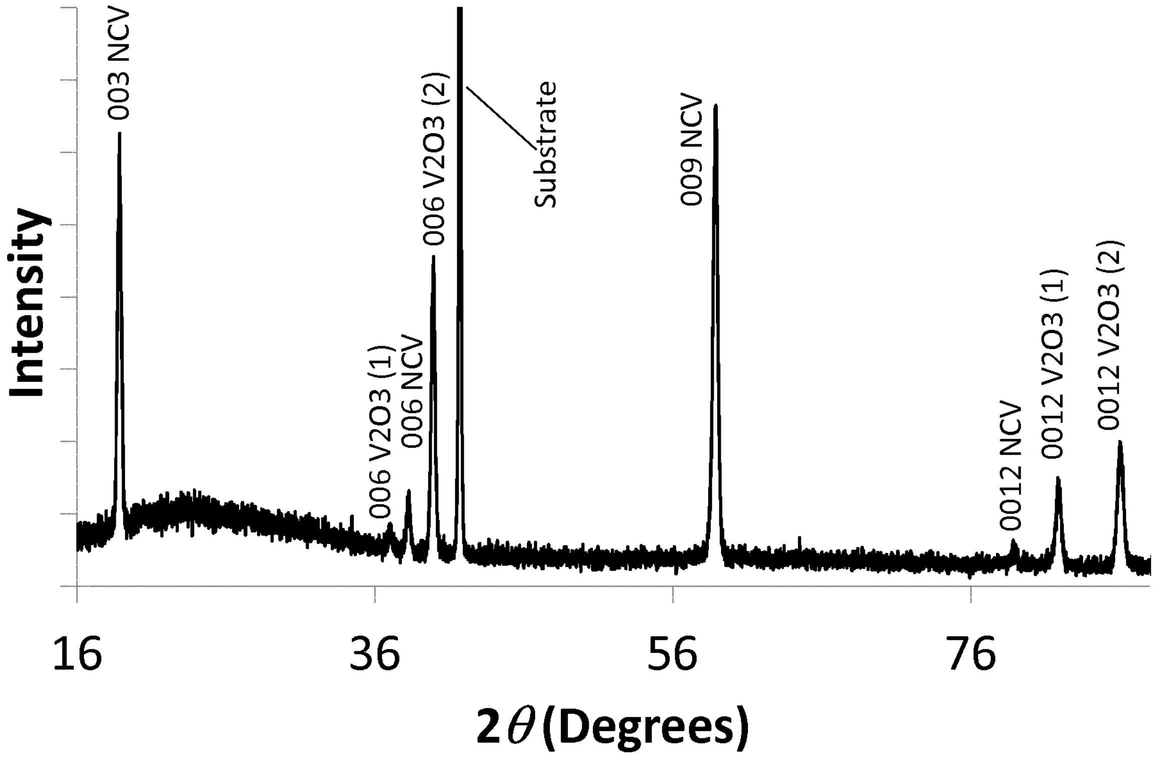
003 NCV
006 V2O3 (1)
006 NCV
006 V2O3 (2)
Substrate
009 NCV
0012 NCV
0012 V2O3 (1)
0012 V2O3 (2)
Intensity
16
36
56
76
2θ (Degrees)

FIG. 17

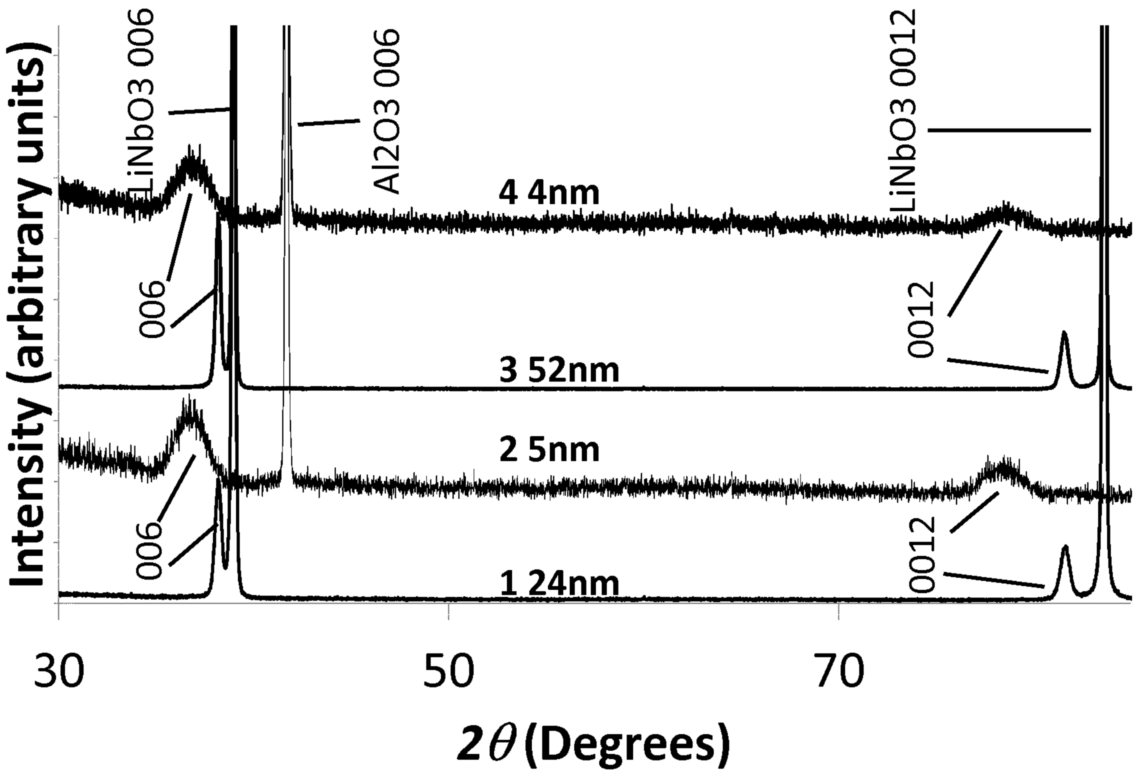
Intensity (arbitrary units)
LiNbO3 006
Al2O3 006
LiNbO3 0012
4 4nm
006
0012
3 52nm
2 5nm
006
0012
1 24nm
30
50
70
2θ (Degrees)

FIG. 18

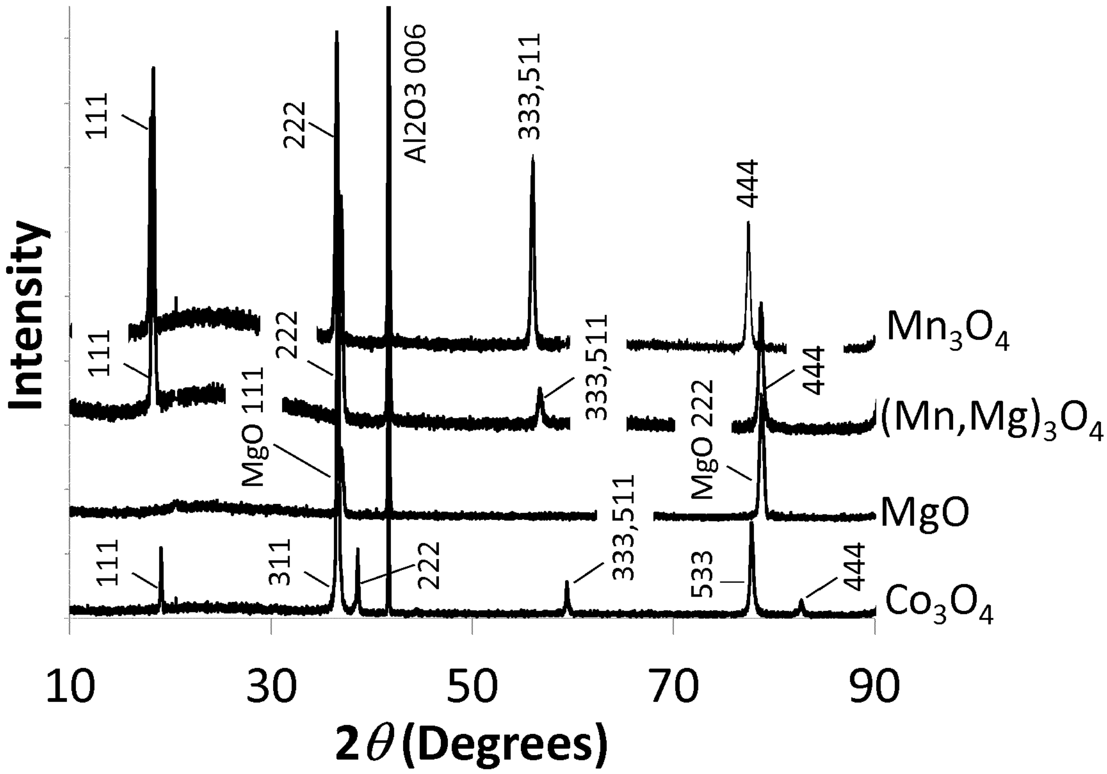
Intensity
111
222
Al2O3 006
333,511
444
Mn3O4
111
222
333,511
444
(Mn,Mg)3O4
MgO 111
MgO 222
MgO
111
311
222
333,511
533
444
Co3O4
10
30
50
70
90
2θ (Degrees)

FIG. 19

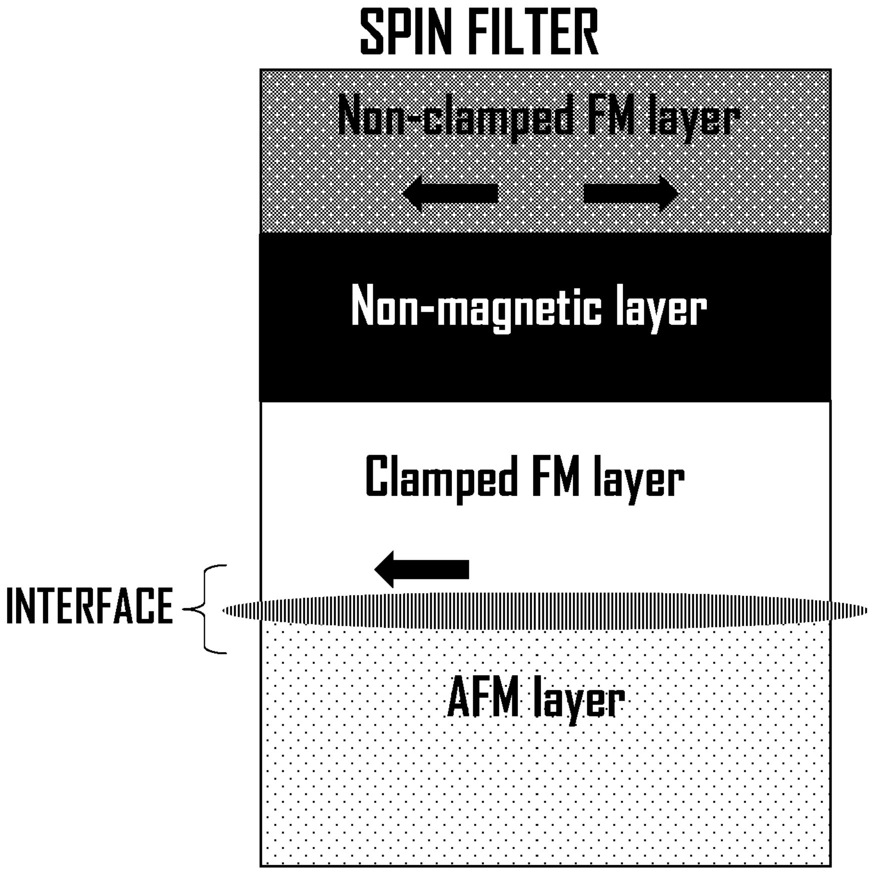
SPIN FILTER
Non-clamped FM layer
Non-magnetic layer
Clamped FM layer
INTERFACE
AFM layer

FIG. 20.

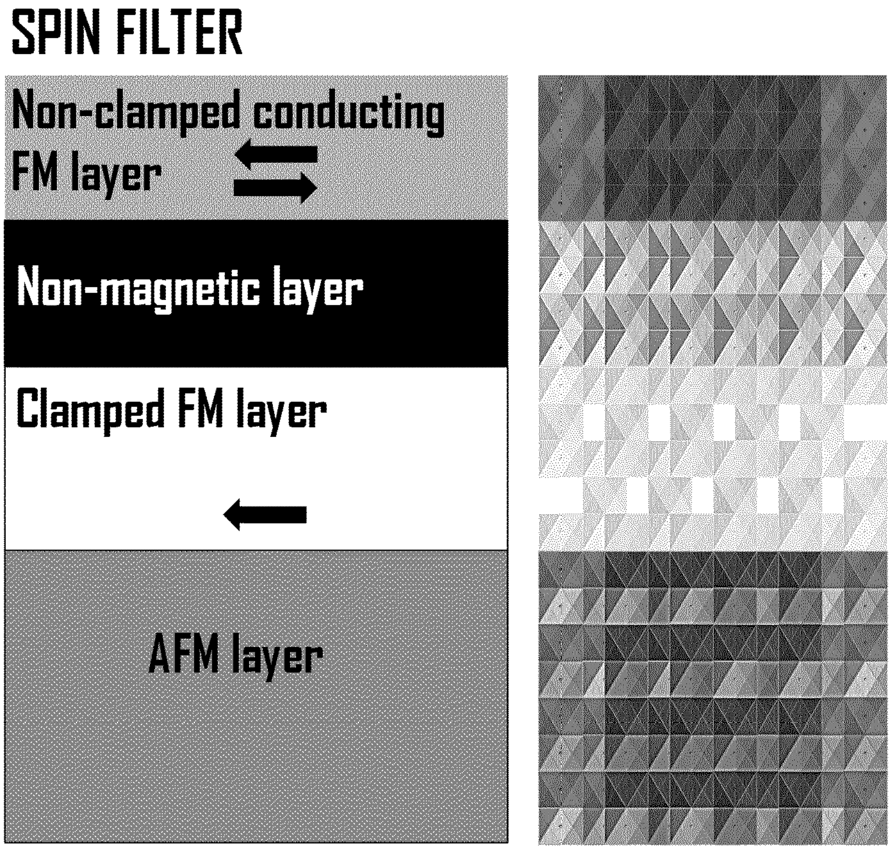
SPIN FILTER
Non-clamped conducting FM layer
Non-magnetic layer
Clamped FM layer
AFM layer

FIG. 21.

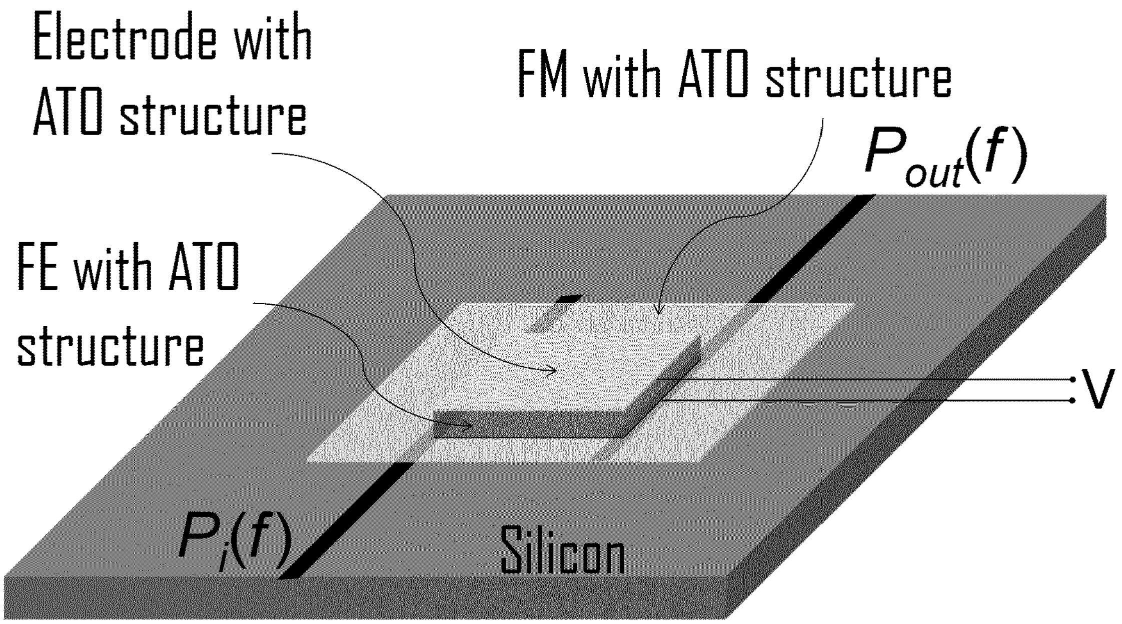
Electrode with
ATO structure
FM with ATO structure
$P_{out}(f)$
FE with ATO
structure
V
$P_i(f)$
Silicon

FIG. 22.

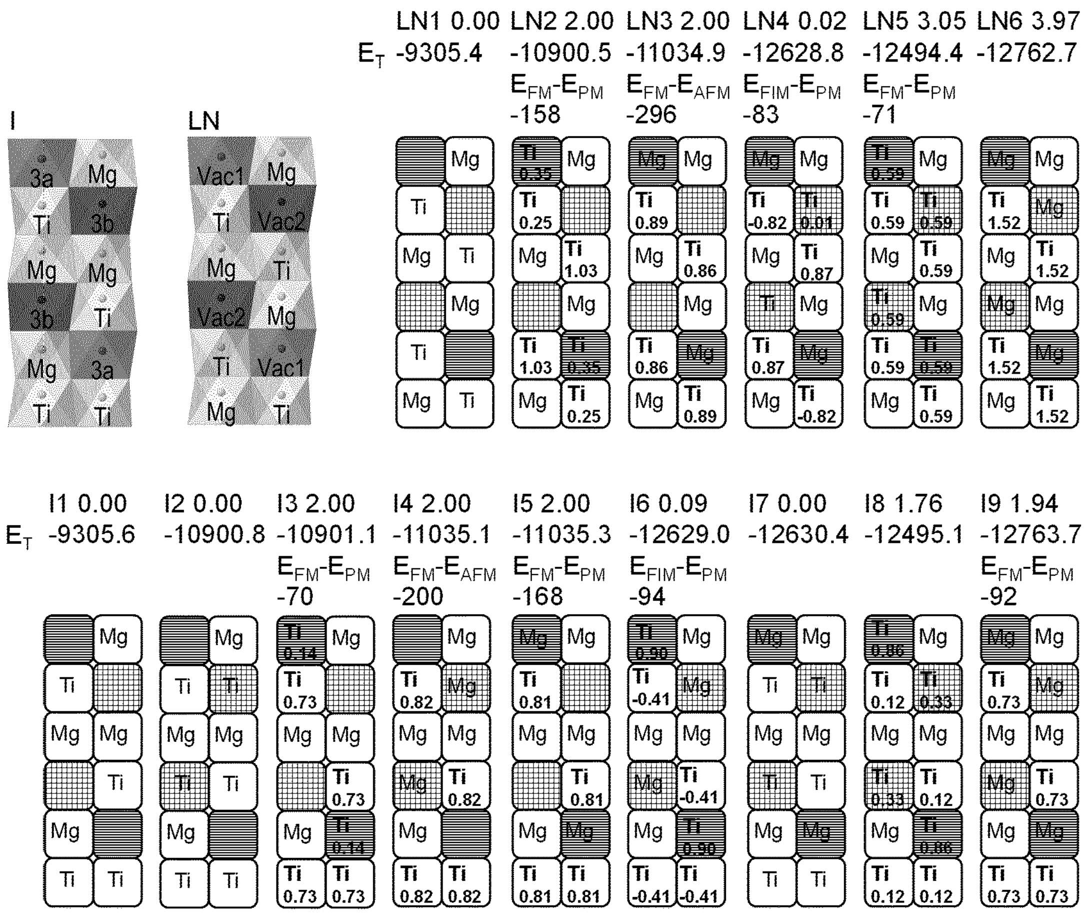

LN1 0.00 LN2 2.00 LN3 2.00 LN4 0.02 LN5 3.05 LN6 3.97
E_T -9305.4 -10900.5 -11034.9 -12628.8 -12494.4 -12762.7
E_FM-E_PM E_FM-E_AFM E_FIM-E_PM E_FM-E_PM
-158 -296 -83 -71
I
LN
3a Mg Ti 3b Mg Mg 3b Ti Mg 3a Ti Ti
Vac1 Mg Ti Vac2 Mg Ti Vac2 Mg Ti Vac1 Mg Ti
I1 0.00 I2 0.00 I3 2.00 I4 2.00 I5 2.00 I6 0.09 I7 0.00 I8 1.76 I9 1.94
E_T -9305.6 -10900.8 -10901.1 -11035.1 -11035.3 -12629.0 -12630.4 -12495.1 -12763.7
E_FM-E_PM E_FM-E_AFM E_FM-E_PM E_FIM-E_PM E_FM-E_PM
-70 -200 -168 -94 -92


FIG. 23.

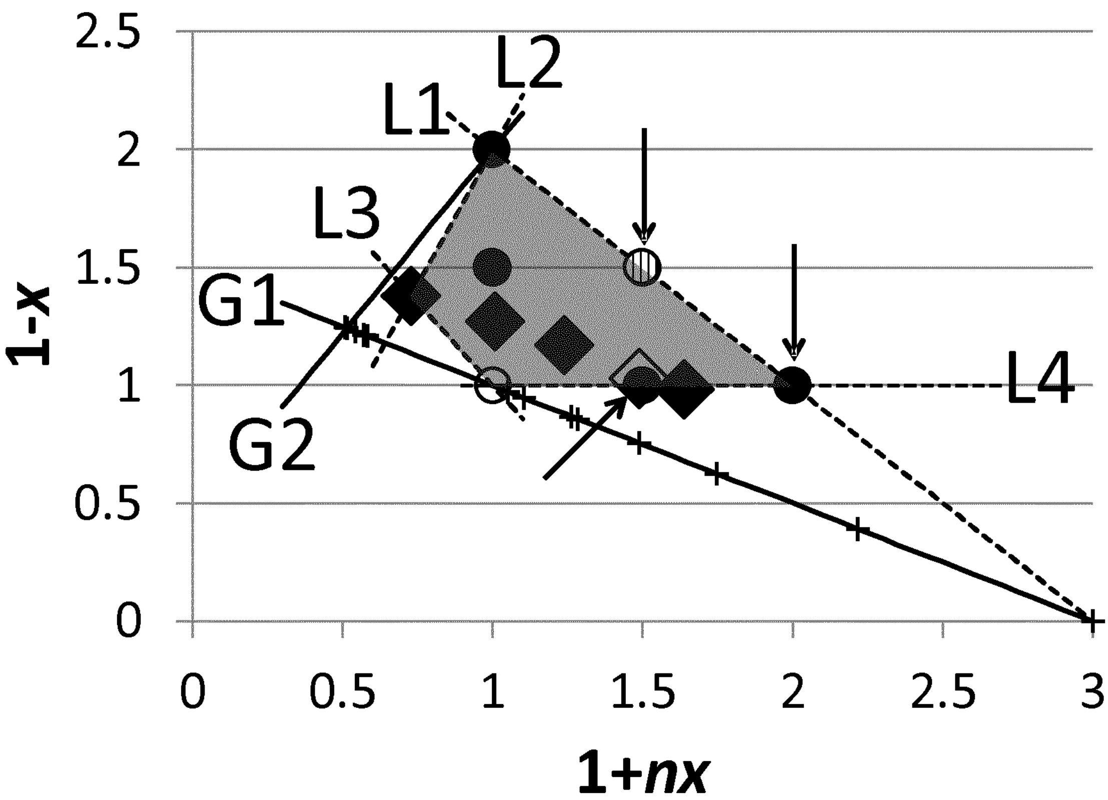


FIG. 24.

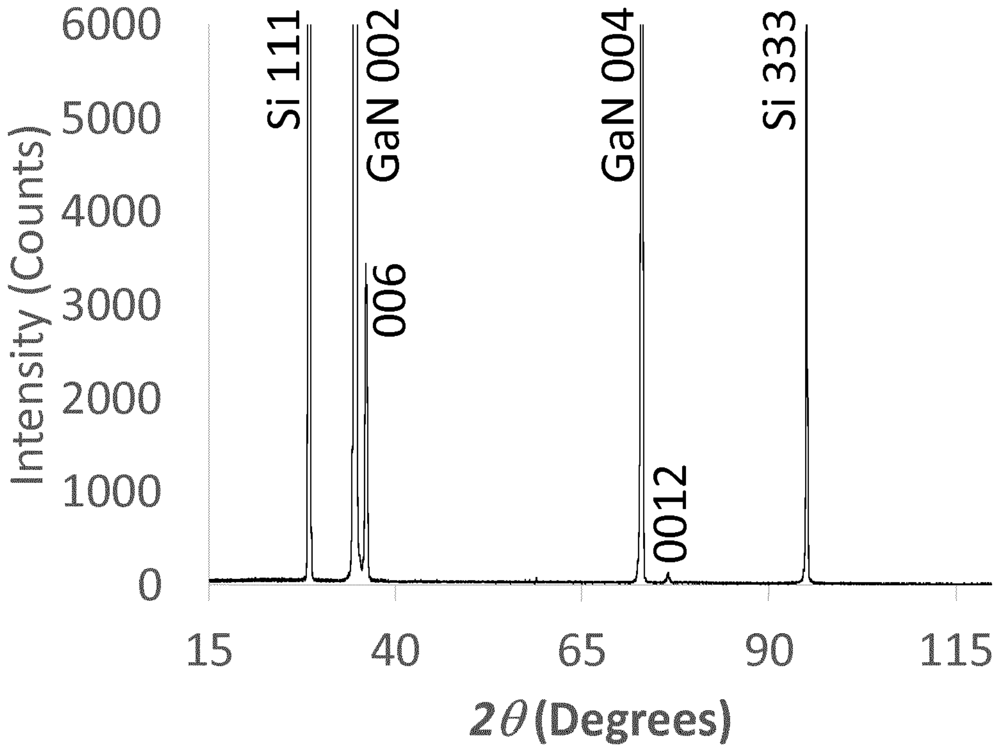

Si 111
GaN 002
006
GaN 004
0012
Si 333
Intensity (Counts)
6000
5000
4000
3000
2000
1000
0
15
40
65
90
115
2θ (Degrees)


FIG. 25.

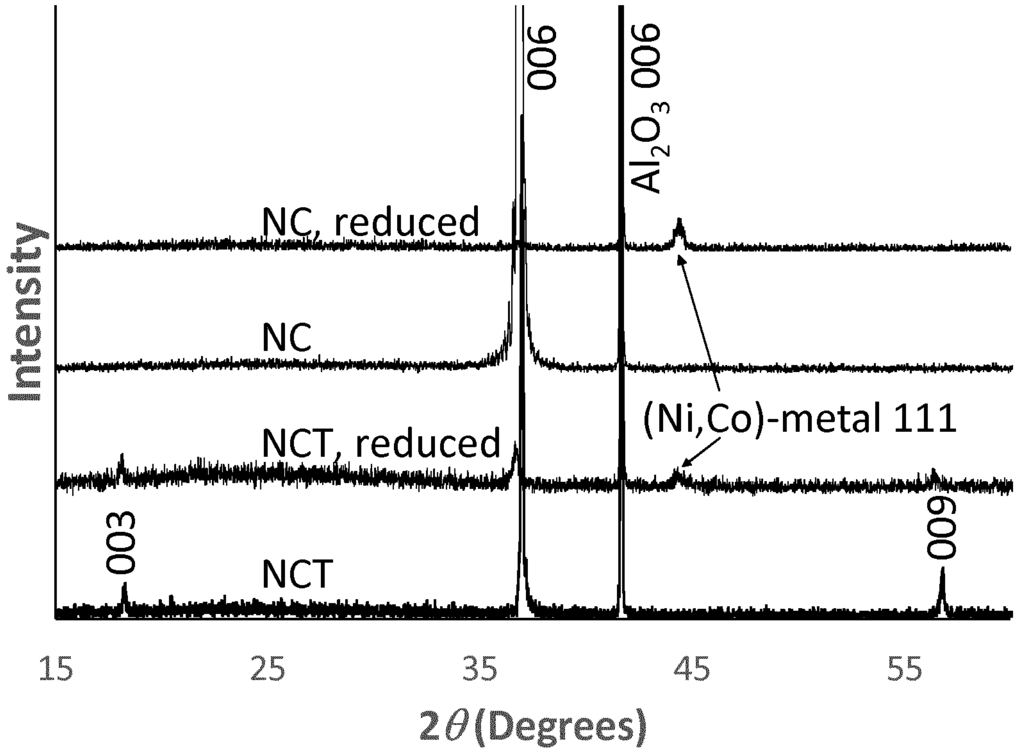
Intensity
NC, reduced
NC
NCT, reduced
NCT
003
006
$Al_2O_3$ 006
(Ni,Co)-metal 111
009
15
25
35
45
55
2θ (Degrees)

FIG. 26.

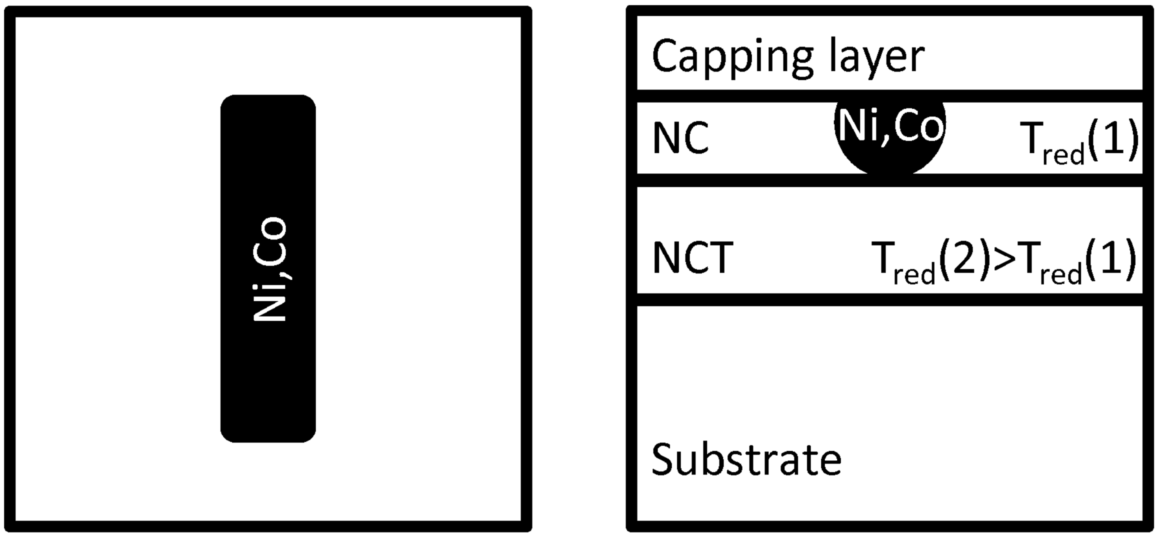


FIG. 27.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 2464962 A, J. Frantti and Y. Fujioka


### Non-patent literature cited in the description


- The International Technology Roadmap for Semiconductors. 2015
- **S. MANIPATRUNI ; D. E. NIKONOV ; I. A. YOUNG.** Material targets for scaling all-spin logic. *Phys. Rev. Appl.,* 2016, vol. 5, 014002
- **F. LAERMER ; A. URBAN.** Milestones in deep reactive ion etching. Tansducers ' 05. *Digest of Technical Papers,* 2005, vol. 1,2, 1118
- **N. DREBOV ; A. MARTINEZ-LIMIA ; L. KUNZ ; A. GOLA ; T. SHIGEMATSU ; T. ECKL ; P. GUMBSCH ; C. ELSÄSSER.** Ab initio screening methodology applied to the search for new permanent magnetic materials. *New Journal of Physics,* 2013, vol. 15, 125023
- **V. HARRIS.** Modern microwave ferrites. *IEEE Transactions on magnetics,* 2012, vol. 48, 1075
- **M. M. SCHIEBER.** Experimental Magnetochemistry: Nonmetallic Magnetic Materials. North-Holland Publishing Company, 1967
- **Y. FUJIOKA ; J. FRANTTI et al.** Itinerant-Electron Ferromagnetism in a Titanium-Rich Magnesium Titanate Ilmenite Solid Solution. *J. Phys. Chem. C.,* 2011, vol. 115, 1457
- **Y. FUJIOKA ; J. FRANTTI et al.** Ferromagnetism in MgTiO3-Ti2O3 solid solutions. *Materials Science Forum,* 2012, vol. 700, 23
- **Y. FUJIOKA ; J. FRANTTI ; C.M. ROULEAU ; A. PURETZKY ; H.M. MEYER.** Vacancy filled nickel-cobalt-titanate thin films. *Phys. Status Solidi B.,* 2017, vol. 254, 1600799
- **K. W. KOLASINSKI.** Surface Science: Foundations of catalysis and nanoscience. John Wiley & Sons, Ltd, 2008
- **K. LEE ; S. H. KANG.** Control of switching current asymmetry by magnetostatic field in MgO-based magnetic tunnel junctions. *IEEE Electronic Device Lett.,* 2009, vol. 30, 1353
- **N. I. KOUROV ; V. V. MARCHENKOV ; A. V. KOROLEV ; K. A. BELOZEROVA ; H. W. WEBER.** High-field magnetization of Heusler Alloys Fe2XY (X=Ti,V,Cr,Mn,Fe,Co,Ni; Y=Al,Si). *Physics of the Solid State.,* 2016, vol. 58, 1500
- **F. DAHMANE ; B. DOUMI ; Y. MOGULKOC ; A. TADJER ; D. PRAKASH ; K. D. VERMA ; D. VARSHNEY ; M. A. GHEBOULI ; S. BIN OMRAN ; R. KHENATA.** Investigations of the structural, electronic, magnetic, and half-metallic behavior of Co2MnZ (Z=Al,Ge,Si,Ga) full-Heusler compounds. *J. Supercond. Nov. Magn.,* 2016, vol. 29, 809
- **T. MIYAJIMA et al.** Transmission electron microscopy study on the crystallization and boron distribution of CoFeB/MgO/CoFeB magnetic tunnel junctions with various capping layers. *Appl. Phys. Lett.,* 2009, vol. 94, 122501
- **E. C. MATTSON ; D. J. MICHALAK ; J. F. VEYAN ; Y. J. CHABAL.** Cobalt and iron segregation and nitrite formation plasma treatment of CoFeB surfaces. *J. Chem. Phys.,* 2017, vol. 146, 052805
- **A. VEDYAYEV ; D. BAGRETS ; A. BAGRETS ; B. DIENY.** Resonant spin-dependent tunneling in spin-valve junctions in the presence of paramagnetic impurities. *Phys. Rev. B.,* 2001, vol. 63, 064429
- **F. J. MORIN.** Magnetic Susceptibility of aFe203 and aFe203 with Added Titanium. *Phys. Rev.,* 1950, vol. 78, 819
- **Y. ISHIKAWA ; S. AKIMOTO.** Magnetic properties of the FeTiO3-Fe2O3 solid-solution series. *Journal of the Physical Society of Japan,* 1957, vol. 12, 1083
- **Z. CHEN ; V. G. HARRIS.** Ferrite film growth on semiconductor substrates towards microwave and millimeter wave integrated circuits. *Journal of Applied Physics,* 2012, vol. 112, 081101
- **R. E. NEWNHAM.** Properties of Materials: Anisotropy, Symmetry, Structure. Oxford University Press, Inc, 2005
- **W. HAYES ; R. LOUDON.** Scattering of Light by Crystals. Dover Publications, Inc, 2004
- **B. LENK ; H. ULRICHS ; F. GARBS ; M. MÜNZENBERG.** The building block of magnonics. *Arxiv:1101.0479v2*

- **B. OBRY ; P. PIRRO ; T. BRÄCHER ; A. V. CHUMAK ; J. OSTEN ; F. CIUBOTARU ; A. A. SERGA ; J. FASSBENDER ; B. HILLEBRANDS.** A micro-structured ion-implanted magnonic crystal. *App. Phys. Lett.,* 2013, vol. 102, 202403
- **C. G. SYKES ; J. D. ADAM ; J. H. COLLINS.** Magnetostatic wave propagation in a periodic structure. *App. Phys. Lett.,* 1976, vol. 29, 388
- **Y. V. GULYAEV ; S. A. NIKITOV ; L. V. ZHIVOTOVSKII ; A. A. KLIMOV ; PH. TAILHADES ; L. PRESMANES ; C. BONNINGUE ; C. S. TSAI ; S. L. VYSOTSKII ; Y. A. FILIMONOV.** Ferromagnetic films with magnon bandgap periodic structures: magnon crystals. *JETP Lett.,* 2003, vol. 77, 567
- **K-S. LEE ; D-S. SOO ; S-K. KIM.** Physical origin and generic control of magnonic band gaps of dipole-exchange spin waves in width-modulated nanostrip waveguides. *Phys. Rev. Lett.,* 2009, vol. 102, 127202
- **B. K. KUANR ; I. R. HARWARD ; R. T. DEIOTTE ; R. E. CAMLEY ; Z. CELINSKI.** Magnetically tunable micro-strip band-stop filter: Design optimization and characterization. *J. Appl. Phys.,* 2005, vol. 97, 10Q103
- **A. V. CHUMAK ; A. A. SERGA ; B. HILLEBRANDS.** Magnonic crystals for data processing. *J. Phys. D: Appl. Phys,* 2017, vol. 50, 244001
- **T. SCHNEIDER ; A. A. SERGA ; B. LEVEN ; B. HILLEBRANDS ; R. L. STAMPS ; M. P. KOSTYLEV.** Realization of spin-wave logic gates. *Appl. Phys. Lett.,* 2008, vol. 92, 022505
- **A. KHITUN.** Multi-frequency magnonic logic circuits for parallel data processing. *J. Appl. Phys.,* 2012, vol. 111, 054307
- **P. J. BROWN ; A. G. FOX ; E. N. MASLEN ; M. A. O'KEEFE ; B. T. M. WILLIS.** Intensity of diffracted intensities, in International Tables for Crystallography, Volume C. Kluwer Academic Publishers, 2004
- **J. FRANTTI ; Y. FUJIOKA ; J. ZHANG ; J. ZHU ; S. C. VOGEL ; Y. ZHAO.** Microstrain in tetragonal lead-zirconate-titanate: The effect of pressure on the ionic displacements. *Review of Scientific Instruments,* 2014, vol. 85, 083901
- **J. FRANTTI ; Y. FUJIOKA.** Computational modeling of x-ray scattering intensities during domain reversal in lead-zirconate-titanate nanosize clusters. *Materials Today: Proceedings,* 2016, vol. 3, 92-98
- **J. FRANTTI ; Y. FUJIOKA.** X-ray and neutron scattering on disordered nanosize clusters: a case study of lead-zirconate-titanate solid solutions. *Annalen der Physics,* 2015, vol. 527, 219-237